# EUROPEAN PATENT APPLICATION

(11) **EP 4 697 918 A2**
(43) Date of publication of application: **18.02.2026**
(21) Application number: 25195237.0
(22) Date of filing: 11.08.2025
(51) Int. Cl.: H10K 85/60, H10K 50/11

(54) **ORGANIC LIGHT EMITTING DEVICE, COMPOSITION FOR ORGANIC MATERIAL LAYER OF ORGANIC LIGHT EMITTING DEVICE AND METHOD FOR MANUFACTURING ORGANIC LIGHT EMITTING DEVICE**

(30) Priority: 12.08.2024 KR 20240107508; 30.05.2025 KR 20250071293
(71) Applicant: LT Materials Co., Ltd., Yongin-si Gyeonggi-do 17118 (KR)
(72) Inventor: LEE, Sol, 17118 Yongin-City (KR); HEO, Yu-Jin, 17118 Yongin-City (KR); MO, Jun-Tae, 17118 Yongin-City (KR); KIM, Dong-Jun, 17118 Yongin-City (KR); CHOI, Dae-Hyuk, 17118 Yongin-City (KR)
(74) Representative: Meissner Bolte Partnerschaft mbB

(57) **Abstract**

Disclosed are an organic light emitting device including a first heterocyclic compound to a third heterocyclic compound, a composition for an organic material layer of an organic light emitting device, and a method for manufacturing an organic light emitting device. The organic light emitting device and the composition for an organic material layer thereof according to an exemplary embodiment of the present application can not only lower the driving voltage of the device and improve the light efficiency, but also improve the thermal stability of the compound, thereby improving the service life characteristics of the device.

## Description

### CROSS-REFERENCE TO RELATED APPLICATIONS

This application claims priority to and the benefit of Korean Patent Application No. 10-2024-0107508, filed with the Korean Intellectual Property Office on August 12, 2024, and Korean Patent Application No. 10-2025-0071293, filed on May 30, 2025.

### TECHNICAL FIELD

The present specification relates to an organic light emitting device, a composition for an organic material layer of the organic light emitting device, and a method for manufacturing an organic light emitting device.

### BACKGROUND ART

A light emitting device is a kind of self-emitting type display device, and has an advantage in that the viewing angle is wide, the contrast is excellent, and the response speed is fast.

An organic light emitting device has a structure in which an organic thin film is disposed between two electrodes. When a voltage is applied to an organic light emitting device having the structure, electrons and holes injected from the two electrodes combine with each other in an organic thin film to make a pair, and then, emit light while being extinguished. The organic thin film may be composed of a single layer or multiple layers, if necessary.

A material for the organic thin film may have a light emitting function, if necessary. For example, as the material for the organic thin film, it is also possible to use a compound, which may itself constitute a light emitting layer alone, or it is also possible to use a compound, which may serve as a host or a dopant of a host-dopant-based light emitting layer. In addition, as a material for the organic thin film, it is also possible to use a compound, which may play a role such as a hole injection, hole transport, electron blocking, hole blocking, electron transport or electron injection.

In order to improve the performance, service life, or efficiency of the organic light emitting device, there is a continuous need for developing a material for an organic thin film.

### [Related Art Documents]

### [Patent Documents]

(Patent Document 1) US Patent No. 4,356,429

### SUMMARY OF THE INVENTION

The present specification has been made in an effort to provide an organic light emitting device, a composition for an organic material layer of the organic light emitting device, and a method for manufacturing an organic light emitting device.

An exemplary embodiment of the present specification provides an organic light emitting device including: a first electrode; a second electrode provided to face the first electrode; and an organic material layer having one or more layers provided between the first electrode and the second electrode, in which one or more layers of the organic material layer includes a first heterocyclic compound, a second heterocyclic compound, and a third heterocyclic compound, the first heterocyclic compound is represented by the following Chemical Formula A, and the second heterocyclic compound and the third heterocyclic compound are different from each other and are each represented by the following Chemical Formula C.

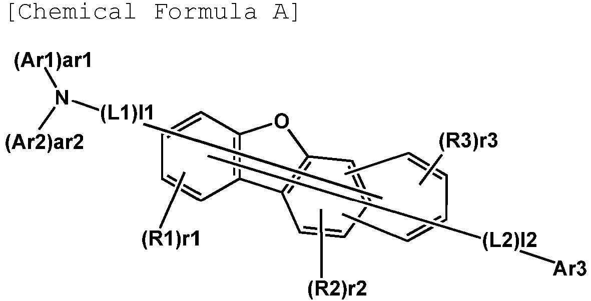

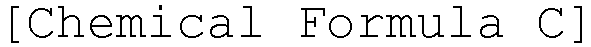

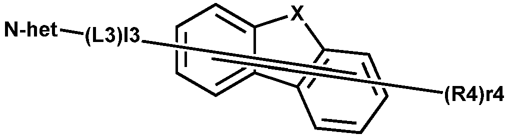

In Chemical Formulae A and C,
L1 to L3 are the same as or different from each other, and are each independently a direct bond; a substituted or unsubstituted C6 to C60 arylene group; or a substituted or unsubstituted C2 to C60 heteroarylene group,
Ar1 to Ar3 are the same as or different from each other, and are each independently a substituted or unsubstituted C6 to C60 aryl group; or a substituted or unsubstituted C2 to C60 heteroaryl group,
R1 to R3 are the same as or different from each other, and are each independently hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group,
R4 is hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; or -(L4)l4-Ar4,
Ar4 is a substituted or unsubstituted C6 to C60 aryl group; or a substituted or unsubstituted C2 to C60 heteroaryl group,
L4 is a direct bond; a substituted or unsubstituted C6 to C60 arylene group; or a substituted or unsubstituted C2 to C60 heteroarylene group,
11 to 14 are the same as or different from each other, and are each independently an integer from 1 to 3, and when each of 11 to 14 is 2 or higher, groups in the parenthesis are the same as or different from each other,
each of r1 and r3 is an integer from 0 to 4,
r2 is an integer from 0 to 2,
the sum of r1, r2 and r3 is 8,
when each of r1, r2 and r3 is 2 or an integer higher than 2, groups in the parenthesis are the same as or different from each other,
r4 is an integer from 0 to 7, and when r4 is an integer of 2 or higher, groups in the parenthesis are the same as or different from each other,
each of ar1 and ar2 is an integer from 1 to 4, and
when each of ar1 and ar2 is an integer of 2 or higher, groups in the parenthesis are the same as or different from each other,
X is O; or S, and
N-het is a substituted or unsubstituted C2 to C60 heteroaryl group, and includes one or more N's.

Another exemplary embodiment of the present specification provides a composition for an organic material layer of an organic light emitting device, including: a first heterocyclic compound, a second heterocyclic compound, and a third heterocyclic compound, in which the first heterocyclic compound is represented by Chemical Formula A, and the second heterocyclic compound and the third heterocyclic compound are different from each other and are each represented by Chemical Formula C.

The final exemplary embodiment of the present specification provides a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the above-described composition for an organic material layer of an organic light emitting device.

According to an exemplary embodiment of the present application, an organic light emitting device and a composition for an organic material layer thereof are characterized by a combination of a naphthobenzofuran compound represented by Chemical Formula A above and a dibenzofuran or dibenzothiophene compound represented by Chemical Formula C above.

The heterocyclic compound represented by Chemical Formula A is at least a 2-substituted naphthobenzofuran core, and can exhibit rapid hole transport properties as a P-type host because a first substituent is a (hetero)arylamine group 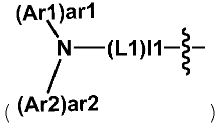 and serves as the highest occupied molecular orbital (HOMO) and a second substituent is a (hetero)aryl group 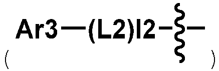 and serves as the lowest unoccupied molecular orbital (LUMO).

Further, the heterocyclic compound represented by Chemical Formula C is a 1-substituted or 2-substituted dibenzofuran core, and can exhibit rapid electron transport properties as an N-type host because a third substituent is a heteroaryl group 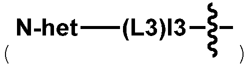 including one or more N's and serves as the LUMO, and an optional four substituent is a (hetero) aryl group represented by -(L4)l4-Ar4 and serves as the HOMO.

As a result, when the composition is used for an organic light emitting device, the driving voltage of the device can be lowered, the light efficiency of the device can be improved, and the thermal stability of the compound can be improved to improve the service life characteristics of the device.

### BRIEF DESCRIPTION OF THE DRAWINGS

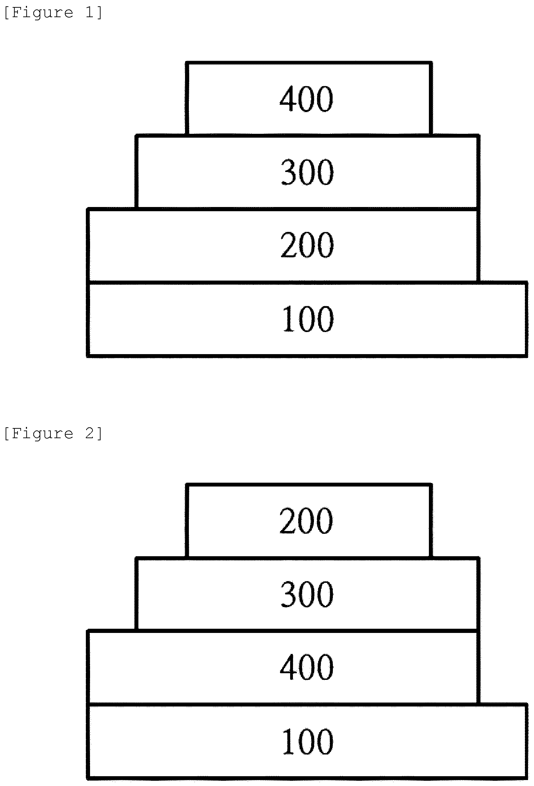

FIGS. 1 to 3 are views each exemplarily illustrating a stacking structure of an organic light emitting device according to an exemplary embodiment of the present specification.

### DETAILED DESCRIPTION

Hereinafter, the present specification will be described in more detail.

### <Definitions>

When one part "includes" one constituent element in the present specification, unless otherwise specifically described, this does not mean that another constituent element is excluded, but means that another constituent element may be further included.

In the present specification, 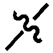 of a chemical formula means a position to be bonded.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, "when a substituent is not indicated in the structure of a chemical formula or compound" means that a hydrogen atom is bonded to a carbon atom. However, since deuterium (²H) or tritium corresponds to an isotope of hydrogen, it may be interpreted as a concept included in hydrogen, as long as it is not explicitly excluded.

That is, in the present application, deuterium exhibits an effect equivalent to that of hydrogen in terms of driving voltage, light emitting efficiency, and service life, or exhibits improved effects in some evaluation criteria, according to Chem. Commun., 2014, 50, 14870, and since the effect falls within the scope that a person with ordinary skill in the art may be predicted to have the equivalent effect without conducting specific experiments, deuterium, an isotope of hydrogen, is interpreted as a concept included in hydrogen, as long as it is not explicitly excluded.

According to an exemplary embodiment of the present specification, "when a substituent is not indicated in the structure of a chemical formula or compound" may mean that all the positions that may be reached by the substituent are hydrogen; or deuterium. That is, deuterium is an isotope of hydrogen, and some hydrogen atoms may be deuterium which is an isotope, and in this case, the content of deuterium may be 0% to 100%.

According to an exemplary embodiment of the present specification, in "the case where a substituent is not indicated in the structure of a chemical formula or compound", when the content of deuterium is 0%, the content of hydrogen is 100%, and all the substituents do not explicitly exclude deuterium such as hydrogen, hydrogen and deuterium may be mixed and used in the compound.

According to an exemplary embodiment of the present specification, deuterium is one of the isotopes of hydrogen, is an element that has a deuteron composed of one proton and one neutron as a nucleus, and may be represented by hydrogen-2, and the element symbol may also be expressed as D or ²H.

According to an exemplary embodiment of the present specification, the isotope means an atom with the same atomic number (Z), but different mass numbers (A), and may also be interpreted as an element which has the same number of protons, but different number of neutrons.

According to an exemplary embodiment of the present specification, when the total number of substituents of a basic compound is defined as T1 and the number of specific substituents among the substituents is defined as T2, the content T% of the specific substituent may be defined as T2/T1×100 = T%.

That is, when taking a phenyl group represented by 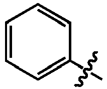 as an example, herein, a deuterium content of 20% may be represented by 20% when the total number of substituents that the phenyl group can have is 5 (T1 in the formula) and the number of deuterium atoms among the substituents is 1 (T2 in the formula). That is, a deuterium content of 20% in the phenyl group may be represented by the following structural formula.

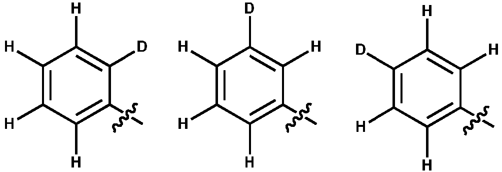

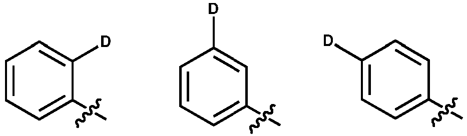

Further, according to an exemplary embodiment of the present specification, "a phenyl group having a deuterium content of 0%" may mean a phenyl group that does not include a deuterium atom, that is, has five hydrogen atoms.

In the present specification, the halogen may be fluorine, chlorine, bromine or iodine.

In the present specification, the alkyl group includes a straight-chain or branched-chain having 1 to 60 carbon atoms, and may be additionally substituted with another substituent. The number of carbon atoms of the alkyl group may be 1 to 60, specifically 1 to 40, and more specifically 1 to 20. Specific examples thereof include a methyl group, an ethyl group, a propyl group, an n-propyl group, an isopropyl group, a butyl group, an n-butyl group, an isobutyl group, a tert-butyl group, a sec-butyl group, a 1-methylbutyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group, and the like, but are not limited thereto.

In the present specification, the alkenyl group includes a straight-chain or branched-chain having 2 to 60 carbon atoms, and may be additionally substituted with another substituent. The number of carbon atoms of the alkenyl group may be 2 to 60, specifically 2 to 40, and more specifically 2 to 20. Specific examples thereof include a vinyl group, a 1-propenyl group, an isopropenyl group, a 1-butenyl group; a 2-butenyl group; a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group and the like, but are not limited thereto.

In the present specification, the alkynyl group includes a straight-chain or branched-chain having 2 to 60 carbon atoms, and may be additionally substituted with another substituent. The number of carbon atoms of the alkynyl group may be 2 to 60, specifically 2 to 40, and more specifically 2 to 20.

In the present specification, an alkoxy group may be straight-chained, branched, or cyclic. The number of carbon atoms of the alkoxy group is not particularly limited, but is preferably 1 to 20. Specific examples thereof include methoxy, ethoxy, n-propoxy, isopropoxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy, and the like, but are not limited thereto.

In the present specification, the cycloalkyl group includes a monocycle or polycycle having 3 to 60 carbon atoms, and may be additionally substituted with another substituent. Here, the polycycle means a group in which a cycloalkyl group is directly linked to or fused with another cyclic group. Here, another cyclic group may also be a cycloalkyl group, but may also be another kind of cyclic group, for example, a heterocycloalkyl group, an aryl group, a heteroaryl group, and the like. The number of carbon atoms of the cycloalkyl group may be 3 to 60, specifically 3 to 40, and more specifically 5 to 20. Specific examples thereof include a cyclopropyl group, a cyclobutyl group, a cyclopentyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, a cyclooctyl group, and the like, but are not limited thereto.

In the present specification, the heterocycloalkyl group includes O, S, Se, N, or Si as a heteroatom, includes a monocycle or polycycle having 2 to 60 carbon atoms, and may be additionally substituted with another substituent. Here, the polycycle means a group in which a heterocycloalkyl group is directly linked to or fused with another cyclic group. Here, another cyclic group may also be a heterocycloalkyl group, but may also be another kind of cyclic group, for example, a cycloalkyl group, an aryl group, a heteroaryl group, and the like. The number of carbon atoms of the heterocycloalkyl group may be 2 to 60, specifically 2 to 40, and more specifically 3 to 20.

In the present specification, the aryl group includes a monocycle or polycycle having 6 to 60 carbon atoms, and may be additionally substituted with another substituent. Here, the polycycle means a group in which an aryl group is directly linked to or fused with another cyclic group. Here, another cyclic group may also be an aryl group, but may also be another kind of cyclic group, for example, a cycloalkyl group, a heterocycloalkyl group, a heteroaryl group, and the like. The aryl group includes a spiro group. The number of carbon atoms of the aryl group may be 6 to 60, specifically 6 to 40, and more specifically 6 to 25. Specific examples of the aryl group include a phenyl group, a biphenyl group, a terphenyl group, a naphthyl group, an anthryl group, a chrysenyl group, a phenanthrenyl group, a perylenyl group, a fluoranthenyl group, a triphenylenyl group, a phenalenyl group, a pyrenyl group, a tetracenyl group, a pentacenyl group, a fluorenyl group, an indenyl group, an acenaphthylenyl group, a benzofluorenyl group, a spirobifluorenyl group, a 2,3-dihydro-1H-indenyl group, a fused cyclic group thereof, and the like, but are not limited thereto.

In the present specification, the terphenyl group may be selected from the following structures.

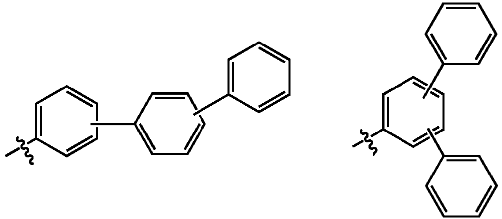

In the present specification, the fluorenyl group may be substituted, and adjacent substituents may be bonded to each other to form a ring.

When the fluorenyl group is substituted, the substituent may be selected from the following structures, but is not limited thereto. Of any one of the following fluorenyl groups in the substituted state, one of the carbon atoms may be bonded to another structure.

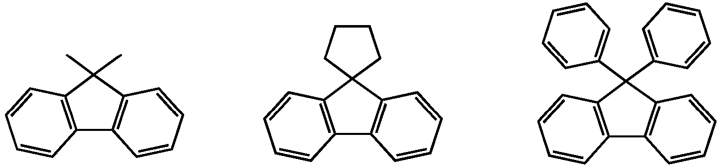

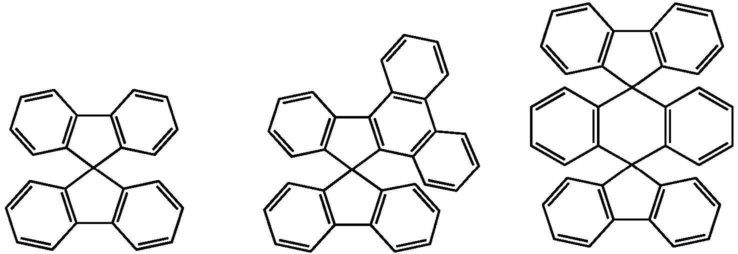

In the present specification, the heteroaryl group includes S, O, Se, N, or Si as a heteroatom, includes a monocycle or a polycycle having 2 to 60 carbon atoms, and may be additionally substituted with another substituent. Here, the polycycle means a group in which a heteroaryl group is directly linked to or fused with another cyclic group. Here, another cyclic group may also be a heteroaryl group, but may also be another kind of cyclic group, for example, a cycloalkyl group, a heterocycloalkyl group, an aryl group, and the like. The number of carbon atoms of the heteroaryl group may be 2 to 60, specifically 2 to 40, and more specifically 3 to 25. Specific examples of the heteroaryl group include a pyridyl group, a pyrrolyl group, a pyrimidyl group, a pyridazinyl group, a furanyl group, a thiophene group, an imidazolyl group, a pyrazolyl group, an oxazolyl group, an isoxazolyl group, a thiazolyl group, an isothiazolyl group, a triazolyl group, a furazanyl group, an oxadiazolyl group, a thiadiazolyl group, a dithiazolyl group, a tetrazolyl group, a pyranyl group, a thiopyranyl group, a diazinyl group, an oxazinyl group, a thiazinyl group, a dioxynyl group, a triazinyl group, a tetrazinyl group, a quinolyl group, an isoquinolyl group, a quinazolinyl group, an isoquinazolinyl group, a quinozolilyl group, a naphthyridyl group, an acridinyl group, a phenanthridinyl group, an imidazopyridinyl group, a diaza naphthalenyl group, a triazaindene group, an indolyl group, an indolizinyl group, a benzothiazolyl group, a benzoxazolyl group, a benzimidazolyl group, a benzothiophene group, a benzofuran group, a dibenzothiophene group, a dibenzofuran group, a carbazolyl group, a benzocarbazolyl group, a dibenzocarbazolyl group, a phenazinyl group, a dibenzosilole group, spirobi (dibenzosilole), a dihydrophenazinyl group, a phenoxazinyl group, a phenanthridyl group, an imidazopyridinyl group, a thienyl group, an indolo[2,3-a]carbazolyl group, an indolo[2,3-b]carbazolyl group, an indolinyl group, a 10,11-dihydro-dibenzo[b,f]azepin group, a 9,10-dihydroacridinyl group, a phenanthrazinyl group, a phenothiathiazinyl group, a phthalazinyl group, a naphthylidinyl group, a phenanthrolinyl group, a benzo [c] [1,2,5]thiadiazolyl group, a 2,3-dihydrobenzo[b]thiophene group, a 2,3-dihydrobenzofuran group, a 5,10-dihydrodibenzo[b,e][1,4]azasilinyl group, a pyrazolo[1,5-c]quinazolinyl group, a pyrido[1,2-b]indazolyl group, a pyrido[1,2-a]imidazo[1,2-e]indolinyl group, a 5,11-dihydroindeno[1,2-b]carbazolyl group, and the like, but are not limited thereto.

In the present specification, when the substituent is a carbazole group, it means being bonded to nitrogen or carbon of carbazole.

In the present specification, when a carbazole group is substituted, an additional substituent may be substituted with the nitrogen or carbon of the carbazole.

In the present specification, a benzocarbazole group may be any one of the following structures. Of the following benzocarbazole groups, any one carbon or nitrogen may be bonded to another structure.

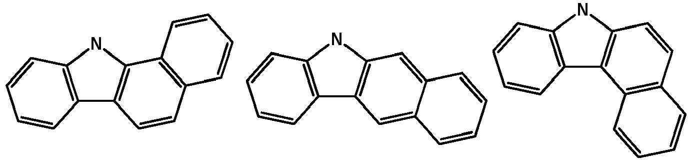

In the present specification, a dibenzocarbazole group may be any one of the following structures. Of the following dibenzocarbazole groups, any one carbon or nitrogen may be bonded to another structure.

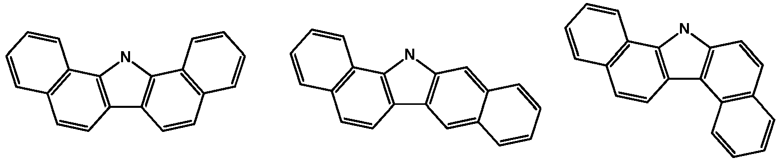

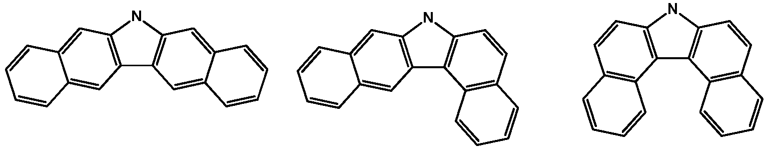

In the present specification, a naphthobenzofuran group may be any one of the following structures. Of the following naphthobenzofuran groups, any one carbon may be bonded to another structure.

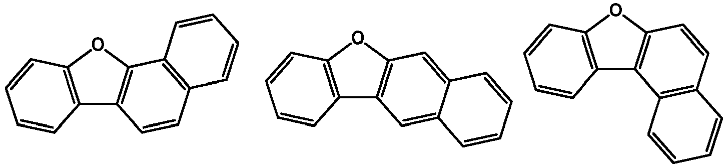

In the present specification, a naphthobenzothiophene group may be any one of the following structures. Of the following naphthobenzothiophene groups, any one carbon may be bonded to another structure.

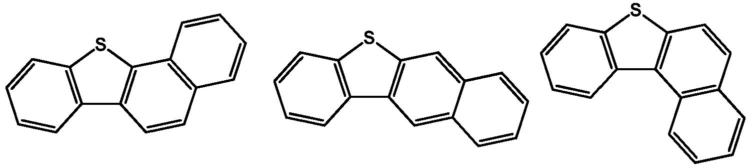

In the present specification, a silyl group includes Si and is a substituent to which the Si atom is directly linked as a radical, and is represented by - Si (R101) (R102) (R103), and R101 to R103 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group.

Specific examples of the silyl group include 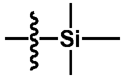 (a trimethylsilyl group), 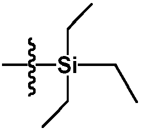 (a triethylsilyl group), 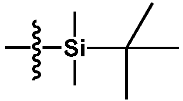 (a t-butyldimethylsilyl group), 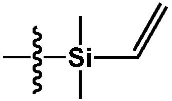 (a vinyldimethylsilyl group), 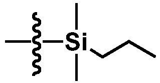 (a propyldimethylsilyl group), 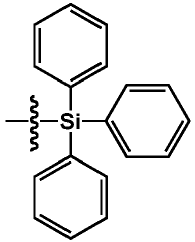 (a triphenylsilyl group), 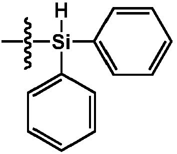 (a diphenylsilyl group), 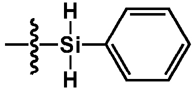 (a phenylsilyl group) and the like, but are not limited thereto.

In the present specification, the phosphine oxide group is represented by -P(=O) (R104) (R105), and R104 and R105 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. Specifically, the phosphine oxide group may be substituted with an alkyl group or an aryl group, and the above-described example may be applied to the alkyl group and the aryl group. Examples of the phosphine oxide group include a dimethylphosphine oxide group, a diphenylphosphine oxide group, a dinaphthylphosphine oxide group, and the like, but are not limited thereto.

In the present specification, the amine group is represented by -N(R106) (R107), and R106 and R107 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. The amine group may be selected from the group consisting of -NH₂; a monoalkylamine group; a monoarylamine group; a monoheteroarylamine group; a dialkylamine group; a diarylamine group; a diheteroarylamine group; an alkylarylamine group; an alkylheteroarylamine group; and an arylheteroarylamine group, and the number of carbon atoms thereof is not particularly limited, but is preferably 1 to 30. Specific examples of the amine group include a methylamine group, a dimethylamine group, an ethylamine group, a diethylamine group, a phenylamine group, a naphthylamine group, a biphenylamine group, a dibiphenylamine group, an anthracenylamine group, a 9-methyl-anthracenylamine group, a diphenylamine group, a phenylnaphthylamine group, a ditolylamine group, a phenyltolylamine group, a triphenylamine group, a biphenylnaphthylamine group, a phenylbiphenylamine group, a biphenylfluorenylamine group, a phenyltriphenylenylamine group, a biphenyltriphenylenylamine group, and the like, but are not limited thereto.

In the present specification, the above-described examples of the aryl group may be applied to an arylene group except for a divalent arylene group.

In the present specification, the above-described examples of the heteroaryl group may be applied to a heteroarylene group except for a divalent heteroarylene group.

In the present specification, an "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituted at the ortho position in a benzene ring and two substituents substituting the same carbon in an aliphatic ring may be interpreted as groups which are "adjacent" to each other.

Hydrocarbon rings and hetero rings that adjacent groups may form include an aliphatic hydrocarbon ring, an aromatic hydrocarbon ring, an aliphatic hetero ring and an aromatic hetero ring, and structures exemplified by the above-described cycloalkyl group, aryl group, heterocycloalkyl group and heteroaryl group may be each applied to the rings, except for those that are not monovalent groups.

In an exemplary embodiment of the present specification, a group not represented by a substituent; or a group represented by hydrogen may all mean a group substitutable with deuterium. That is, it may indicate that hydrogen (H); or deuterium (D) can be substituted with each other.

In general, compounds bonded with hydrogen and compounds substituted with deuterium exhibit a difference in thermodynamic behavior. The reason for this is that the mass of a deuterium atom is 2-fold higher than that of hydrogen, but due to the difference in the mass of atoms, deuterium is characterized by having lower vibration energy.

Further, the single bond dissociation energy of carbon and deuterium is higher than the single bond dissociation energy of carbon and hydrogen. Accordingly, the deuterium-substituted structure has an effect of increasing the thermal stability of the molecule and improving the service life of the device using the increased thermal stability.

When a compound is deposited on a silicon wafer, a material including deuterium tends to be packed so that the intermolecular distance is reduced. Further, when the surface of a thin film is observed using an atomic force microscope (AFM), it can be confirmed that the thin film made of a compound including deuterium is deposited with a more uniform surface without any aggregated portion.

### <Organic light emitting device>

Hereinafter, the compound according to the present specification will be described.

The organic light emitting device according to an exemplary embodiment of the present specification is characterized in that one or more layers of the organic material layer include a first heterocyclic compound, a second heterocyclic compound, and a third heterocyclic compound, the first heterocyclic compound is represented by the following Chemical Formula A, and the second heterocyclic compound and the third heterocyclic compound are different from each other, and are each represented by the following Chemical Formula C.

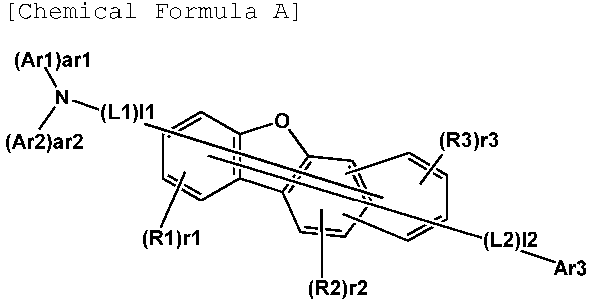

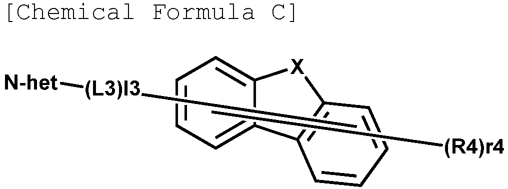

In Chemical Formulae A and C, the description on each of the substituents (L1 to L3, Ar1 to Ar3, R1 to R4, N-het, X, ar1, ar2, 11 to 13, and r1 to r4) is as described above.

According to an exemplary embodiment of the present specification, Chemical Formula A is represented by any one of the following Chemical Formulae A-1 to A-3.

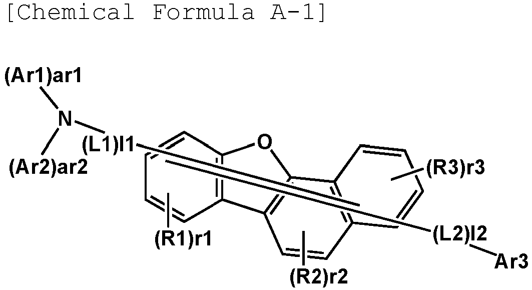

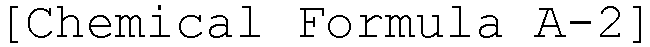

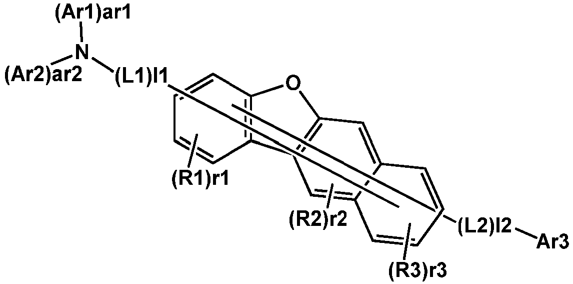

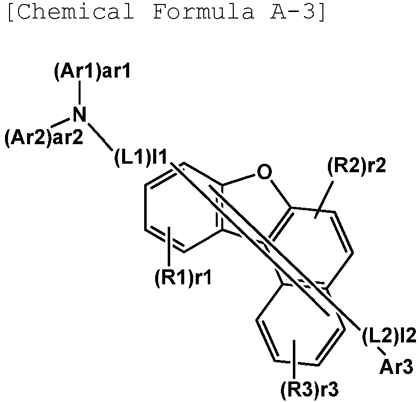

In Chemical Formulae A-1 to A-3,
each of the substituents (L1, L2, Ar1 to Ar3, R1 to R3, ar1, ar2, 11, 12, and r1 to r3) is the same as that defined in Chemical Formula A.

According to an exemplary embodiment of the present specification, Chemical Formula A is represented by any one of the following Chemical Formulae A-4 to A-10.

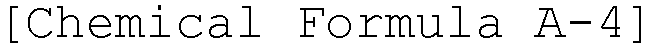

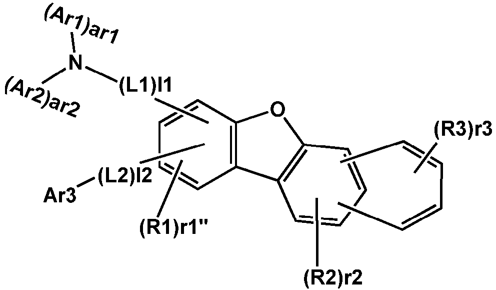

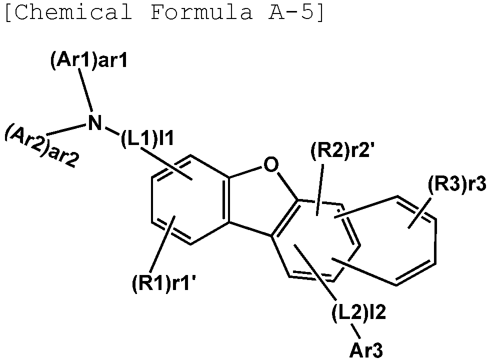

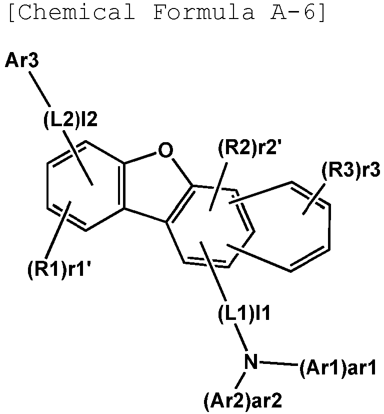

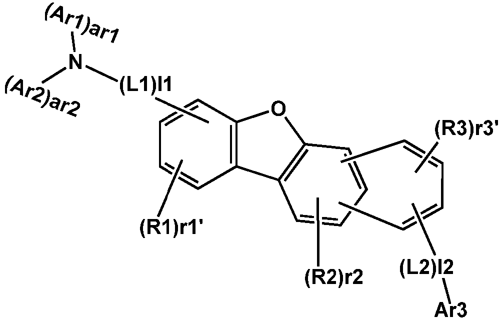

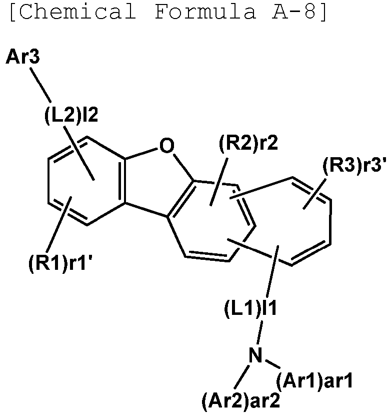

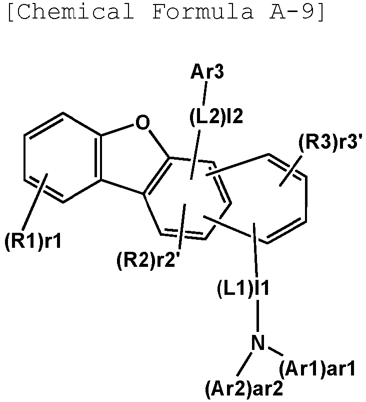

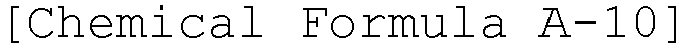

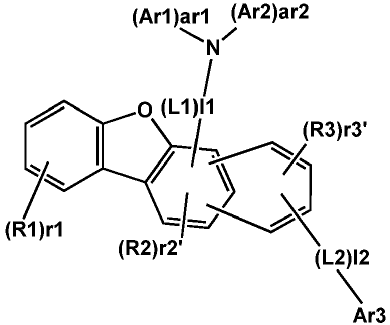

In Chemical Formulae A-4 to A-10,
each of the substituents (L1, L2, Ar1 to Ar3, R1 to R3, ar1, ar2, 11, 12, and r1 to r3) is the same as that defined in Chemical Formula A,
r1' is an integer from 0 to 3,
r1" is an integer from 0 to 2,
r2' is 0 or 1,
r3' is an integer from 0 to 3, and
when each of r1', r1" and r3' is 2 or an integer higher than 2, groups in the parenthesis are the same as or different from each other.

In the present specification, when ar1 is 2, for example, the following structure may be shown, and Ar11 and Ar12 are the same as or different from each other, but are the same as the definition of Ar1. However, Ar11 corresponds to a divalent group. Such considerations may be applied to a substituent equivalent to Ar1 (for example, Ar2).

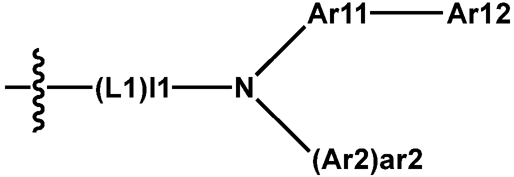

According to an exemplary embodiment of the present specification, Chemical Formula C is represented by any one of the following Chemical Formulae C-1 to C-3.

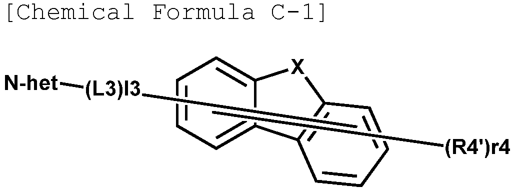

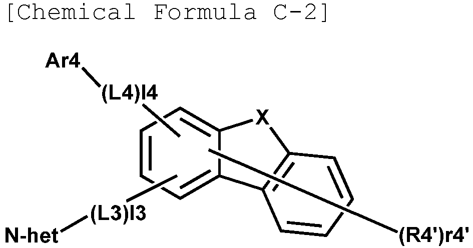

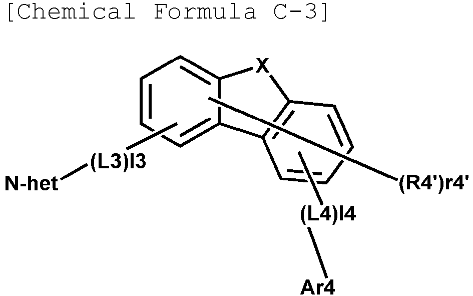

In Chemical Formulae C-1 to C-3,
each of the substituents (L3, L4, Ar4, N-het, X, r4, 13, and 14) is the same as that defined in Chemical Formula C,
R4''s are the same as or different from each other, and are each independently hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group, and
r4' is an integer from 0 to 6, and when r4' is an integer of 2 or higher, groups in the parenthesis are the same as or different from each other.

According to an exemplary embodiment of the present specification, L1 to L3 are the same as or different from each other, and may be each independently a direct bond; a substituted or unsubstituted C6 to C40 arylene group; or a substituted or unsubstituted C2 to C40 heteroarylene group.

According to an exemplary embodiment of the present specification, L1 to L3 are the same as or different from each other, and may be each independently a direct bond; or a substituted or unsubstituted C6 to C30 arylene group.

According to an exemplary embodiment of the present specification, L1 to L3 are the same as or different from each other, and may be each independently a direct bond; or a C6 to C20 arylene group unsubstituted or substituted with deuterium.

According to an exemplary embodiment of the present specification, L1 to L3 are the same as or different from each other, and may be each independently a direct bond; a substituted or unsubstituted phenylene group; a substituted or unsubstituted biphenylene group; or a substituted or unsubstituted naphthylene group.

According to an exemplary embodiment of the present specification, L1 to L3 are the same as or different from each other, and may be each independently a direct bond; a phenylene group unsubstituted or substituted with deuterium; a biphenylene group unsubstituted or substituted with deuterium; or a naphthylene group unsubstituted or substituted with deuterium.

According to an exemplary embodiment of the present specification, Ar1 to Ar3 are the same as or different from each other, and may be each independently a substituted or unsubstituted C6 to C40 aryl group; or a substituted or unsubstituted C2 to C40 heteroaryl group.

According to an exemplary embodiment of the present specification, Ar1 to Ar3 are the same as or different from each other, and may be each independently a C6 to C30 aryl group unsubstituted or substituted with deuterium; or a C2 to C30 heteroaryl group unsubstituted or substituted with deuterium.

According to an exemplary embodiment of the present specification, Ar1 to Ar3 are the same as or different from each other, and may be each independently a substituted or unsubstituted phenyl group; a substituted or unsubstituted biphenyl group; a substituted or unsubstituted terphenyl group; a substituted or unsubstituted naphthyl group; a substituted or unsubstituted phenanthrenyl group; a substituted or unsubstituted benzophenanthrenyl group; a substituted or unsubstituted chrysenyl group; a substituted or unsubstituted fluorenyl group; a substituted or unsubstituted benzofluorenyl group; a substituted or unsubstituted spirobifluorenyl group; a substituted or unsubstituted dibenzofuranyl group; a substituted or unsubstituted naphthobenzofuranyl group; a substituted or unsubstituted phenanthrobenzofuranyl group; a substituted or unsubstituted dibenzothiophenyl group; a substituted or unsubstituted naphthobenzothiophenyl group; a substituted or unsubstituted phenanthrobenzothiophenyl group; or a substituted or unsubstituted carbazole group.

According to an exemplary embodiment of the present specification, Ar1 to Ar3 are the same as or different from each other, and may be each independently a phenyl group unsubstituted or substituted with deuterium; a biphenyl group unsubstituted or substituted with deuterium; a terphenyl group unsubstituted or substituted with deuterium; a naphthyl group unsubstituted or substituted with a substituent selected from the group consisting of deuterium and a phenyl group; a phenanthrenyl group unsubstituted or substituted with deuterium; a benzophenanthrenyl group unsubstituted or substituted with deuterium; a chrysenyl group unsubstituted or substituted with deuterium; a fluorenyl group unsubstituted or substituted with a substituent selected from the group consisting of deuterium, a methyl group and a phenyl group; a benzofluorenyl group unsubstituted or substituted with deuterium; a spirobifluorenyl group unsubstituted or substituted with deuterium; a dibenzofuranyl group unsubstituted or substituted with a substituent selected from the group consisting of deuterium and a phenyl group; a naphthobenzofuranyl group unsubstituted or substituted with a substituent selected from the group consisting of deuterium and a phenyl group; a phenanthrobenzofuranyl group unsubstituted or substituted with deuterium; a dibenzothiophenyl group unsubstituted or substituted with a substituent selected from the group consisting of deuterium and a phenyl group; a naphthobenzothiophenyl group unsubstituted or substituted with a substituent selected from the group consisting of deuterium and a phenyl group; a phenanthrobenzofuranyl group unsubstituted or substituted with deuterium; or a carbazole group unsubstituted or substituted with a substituent selected from the group consisting of deuterium, a phenyl group, a biphenyl group and a naphthyl group.

According to an exemplary embodiment of the present specification, R1 to R3 are the same as or different from each other, and may be each independently hydrogen; deuterium; a halogen group; a cyano group; a substituted or unsubstituted C1 to C40 alkyl group; a substituted or unsubstituted C3 to C40 cycloalkyl group; a substituted or unsubstituted C2 to C40 heterocycloalkyl group; a substituted or unsubstituted C6 to C40 aryl group; or a substituted or unsubstituted C2 to C40 heteroaryl group.

According to an exemplary embodiment of the present specification, R1 to R3 are the same as or different from each other, and may be each independently hydrogen; deuterium; or a substituted or unsubstituted C6 to C30 aryl group.

According to an exemplary embodiment of the present specification, R1 to R3 are the same as or different from each other, and may be each independently hydrogen; deuterium; or a C6 to C30 aryl group unsubstituted or substituted with deuterium.

According to an exemplary embodiment of the present specification, R1 to R3 are the same as or different from each other, and may be each independently hydrogen; deuterium; or a phenyl group.

According to an exemplary embodiment of the present specification, R4 may be hydrogen; deuterium; a halogen group; a cyano group; a substituted or unsubstituted C1 to C40 alkyl group; a substituted or unsubstituted C3 to C40 cycloalkyl group; a substituted or unsubstituted C2 to C40 heterocycloalkyl group; a substituted or unsubstituted C6 to C40 aryl group; a substituted or unsubstituted C2 to C40 heteroaryl group; or -(L4)l4-Ar4.

According to an exemplary embodiment of the present specification, R4 may be hydrogen; deuterium; a substituted or unsubstituted C6 to C30 aryl group; or -(L4)l4-Ar4. According to an exemplary embodiment of the present specification, R4 may be hydrogen; deuterium; or -(L4)l4-Ar4.

According to an exemplary embodiment of the present specification, Ar4 may be a substituted or unsubstituted C6 to C40 aryl group; or a substituted or unsubstituted C2 to C40 heteroaryl group.

According to an exemplary embodiment of the present specification, Ar4 may be a substituted or unsubstituted C6 to C30 aryl group; or a substituted or unsubstituted C2 to C30 heteroaryl group.

According to an exemplary embodiment of the present specification, Ar4 may be a substituted or unsubstituted phenyl group; a substituted or unsubstituted biphenyl group; a substituted or unsubstituted terphenyl group; a substituted or unsubstituted naphthyl group; a substituted or unsubstituted phenanthrenyl group; a substituted or unsubstituted benzophenanthrenyl group; a substituted or unsubstituted chrysenyl group; a substituted or unsubstituted triphenylenyl group; a substituted or unsubstituted pyrenyl group; a substituted or unsubstituted dibenzofuranyl group; or a substituted or unsubstituted dibenzothiophenyl group.

According to an exemplary embodiment of the present specification, Ar4 may be a phenyl group unsubstituted or substituted with deuterium; a biphenyl group unsubstituted or substituted with deuterium; a terphenyl group unsubstituted or substituted with deuterium; a naphthyl group unsubstituted or substituted with deuterium; a phenanthrenyl group unsubstituted or substituted with deuterium; a benzophenanthrenyl group unsubstituted or substituted with deuterium; a chrysenyl group unsubstituted or substituted with deuterium; a triphenylenyl group unsubstituted or substituted with deuterium; a pyrenyl group unsubstituted or substituted with deuterium; a dibenzofuranyl group unsubstituted or substituted with deuterium; or a dibenzothiophenyl group unsubstituted or substituted with deuterium.

According to an exemplary embodiment of the present specification, L4 may be a direct bond; a substituted or unsubstituted C6 to C40 arylene group; or a substituted or unsubstituted C2 to C40 heteroarylene group.

According to an exemplary embodiment of the present specification, L4 may be a direct bond; or a substituted or unsubstituted C6 to C30 arylene group.

According to an exemplary embodiment of the present specification, L4 may be a direct bond; or a C6 to C30 arylene group unsubstituted or substituted with deuterium.

According to an exemplary embodiment of the present specification, L4 may be a direct bond; a substituted or unsubstituted phenylene group; a substituted or unsubstituted biphenylene group; or a substituted or unsubstituted naphthylene group.

According to an exemplary embodiment of the present specification, L4 may be a direct bond; a phenylene group unsubstituted or substituted with deuterium; a biphenylene group unsubstituted or substituted with deuterium; or a naphthylene group unsubstituted or substituted with deuterium.

According to an exemplary embodiment of the present specification, X may be O.

According to an exemplary embodiment of the present specification, X may be S.

According to an exemplary embodiment of the present specification, N-het is a substituted or unsubstituted C2 to C40 heteroaryl group, and includes one or more N's.

According to an exemplary embodiment of the present specification, N-het is a substituted or unsubstituted C2 to C20 heteroaryl group, and includes two or more N's.

According to an exemplary embodiment of the present specification, N-het is a substituted or unsubstituted monocyclic C2 to C20 heteroaryl group, and includes two or more N's.

According to an exemplary embodiment of the present specification, the N-het is represented by the following Structural Formula N.

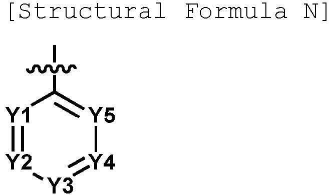

In Structural Formula N, 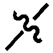 means a linking position in Chemical Formula C,
Y1 to Y5 are the same as or different from each other, and are each independently CRa or N, and at least one is N, and
Ra is a substituted or unsubstituted C6 to C60 aryl group; a substituted or unsubstituted C2 to C60 heteroaryl group; or a combination thereof, or two or more adjacent Ra groups are bonded to form a ring.

According to an exemplary embodiment of the present specification, Y1 to Y5 are the same as or different from each other, and are each independently CRa or N, and at least two groups may be N.

According to an exemplary embodiment of the present specification, Y1 to Y5 are the same as or different from each other, and each independently CRa or N, and at least three groups may be N.

According to an exemplary embodiment of the present specification, Ra is a substituted or unsubstituted C6 to C40 aryl group; a substituted or unsubstituted C2 to C40 heteroaryl group; or a combination thereof, or two or more adjacent Ra groups may be bonded to form a ring.

According to an exemplary embodiment of the present specification, Ra is a substituted or unsubstituted C6 to C30 aryl group; or a substituted or unsubstituted C2 to C30 heteroaryl group, or two or more adjacent Ra groups may be bonded to each other to form a substituted or unsubstituted C6 to C30 aromatic hydrocarbon ring or a substituted or unsubstituted C2 to C30 aromatic hetero ring.

According to an exemplary embodiment of the present specification, Ra is a substituted or unsubstituted phenyl group; a substituted or unsubstituted biphenyl group; a substituted or unsubstituted terphenyl group; a substituted or unsubstituted naphthyl group; a substituted or unsubstituted phenanthrenyl group; a substituted or unsubstituted benzophenanthrenyl group; a substituted or unsubstituted triphenylene group; a substituted or unsubstituted chrysenyl group; a substituted or unsubstituted pyrenyl group; a substituted or unsubstituted dibenzofuranyl group; a substituted or unsubstituted naphthobenzofuranyl group; a substituted or unsubstituted dibenzothiophenyl group; a substituted or unsubstituted naphthobenzothiophenyl group; a substituted or unsubstituted carbazolyl group; or a combination thereof, or two or more adjacent Ra groups may be bonded to each other to form a substituted or unsubstituted benzene ring; a substituted or unsubstituted benzothiophene group; or a substituted or unsubstituted benzofuran ring. Here, the carbazolyl group may be 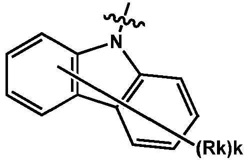 (an N-carbazolyl group) or 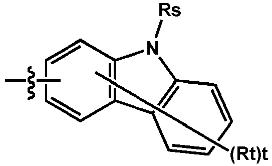 (a C-carbazolyl group), and here, 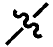 is a position linked to another substituent, Rk, Rs, and Rt are the same as or different from each other, and are each independently hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group, k is an integer from 0 to 8, t is an integer from 0 to 7, and when each of k and t is an integer of 2 or higher, substituents in the parenthesis are the same as or different from each other.

According to an exemplary embodiment of the present specification, Ra is a phenyl group unsubstituted or substituted with a substituent selected from deuterium, a cyano group, a halogen group, a phenyl group, a biphenyl group and a naphthyl group; a biphenyl group unsubstituted or substituted with deuterium; a terphenyl group unsubstituted or substituted with deuterium; a naphthyl group unsubstituted or substituted with deuterium and a phenyl group; a phenanthrenyl group unsubstituted or substituted with deuterium; a benzophenanthrenyl group unsubstituted or substituted with deuterium; a triphenylene group unsubstituted or substituted with deuterium; a chrysenyl group unsubstituted or substituted with deuterium; a pyrenyl group unsubstituted or substituted with deuterium; a dibenzofuranyl group unsubstituted or substituted with a substituent selected from the group consisting of deuterium, a phenyl group and a naphthyl group; a naphthobenzofuranyl group unsubstituted or substituted with deuterium; a dibenzothiophenyl group unsubstituted or substituted with a substituent selected from the group consisting of deuterium, a phenyl group and a naphthyl group; a naphthobenzothiophenyl group unsubstituted or substituted with deuterium; a carbazolyl group unsubstituted or substituted with a substituent selected from the group consisting of deuterium and a phenyl group; or a combination thereof, or two or more adjacent Ra groups may be bonded to each other to form a benzene ring unsubstituted or substituted with a heteroaryl group including a heteroatom selected from deuterium, an aryl group, S and O; a benzothiophene ring unsubstituted or substituted with a heteroaryl group including a heteroatom selected from deuterium, an aryl group, S and O; or a benzofuran ring unsubstituted or substituted with a heteroaryl group including a heteroatom selected from deuterium, an aryl group, S and O. Here, the above-described description may be applied to the carbazolyl group.

According to an exemplary embodiment of the present specification, the "substituted or unsubstituted" may mean being unsubstituted or substituted with one or more substituents selected from the group consisting of deuterium; a halogen group; a cyano group; a C1 to C60 alkyl group; and a C6 to C60 aryl group.

According to an exemplary embodiment of the present specification, the "substituted or unsubstituted" may mean being unsubstituted or substituted with one or more substituents selected from the group consisting of deuterium; a halogen group; a cyano group; a C1 to C30 alkyl group; and a C6 to C30 aryl group.

According to an exemplary embodiment of the present specification, the "substituted or unsubstituted" may mean being unsubstituted or substituted with one or more substituents selected from the group consisting of deuterium; a halogen group; a cyano group; a methyl group; a phenyl group; and a naphthyl group.

According to an exemplary embodiment of the present specification, the deuterium content of the first heterocyclic compound may be 0%, or 1% to 100%.

According to an exemplary embodiment of the present specification, the deuterium content of the first heterocyclic compound may be 0%, or 10% to 100%.

According to an exemplary embodiment of the present specification, the deuterium content of the first heterocyclic compound may be 0%, or 20% to 100%.

According to an exemplary embodiment of the present specification, the deuterium content of the first heterocyclic compound may be 0%, or 30% to 100%.

According to an exemplary embodiment of the present specification, the deuterium content of the first heterocyclic compound may be 0%, or 60% to 100%.

According to an exemplary embodiment of the present specification, the deuterium content of the first heterocyclic compound may be 0%, or 80% to 100%.

According to an exemplary embodiment of the present specification, the deuterium content of the first heterocyclic compound may be 0%, or 90% to 100%.

According to an exemplary embodiment of the present specification, the deuterium content of the second heterocyclic compound may be 0%, or 1% to 100%.

According to an exemplary embodiment of the present specification, the deuterium content of the second heterocyclic compound may be 0%, or 10% to 100%.

According to an exemplary embodiment of the present specification, the deuterium content of the second heterocyclic compound may be 0%, or 20% to 100%.

According to an exemplary embodiment of the present specification, the deuterium content of the second heterocyclic compound may be 0%, or 30% to 100%.

According to an exemplary embodiment of the present specification, the deuterium content of the second heterocyclic compound may be 0%, or 60% to 100%.

According to an exemplary embodiment of the present specification, the deuterium content of the second heterocyclic compound may be 0%, or 80% to 100%.

According to an exemplary embodiment of the present specification, the deuterium content of the second heterocyclic compound may be 0%, or 90% to 100%.

According to an exemplary embodiment of the present specification, the deuterium content of the third heterocyclic compound may be 0%, or 1% to 100%.

According to an exemplary embodiment of the present specification, the deuterium content of the third heterocyclic compound may be 0%, or 10% to 100%.

According to an exemplary embodiment of the present specification, the deuterium content of the third heterocyclic compound may be 0%, or 20% to 100%.

According to an exemplary embodiment of the present specification, the deuterium content of the third heterocyclic compound may be 0%, or 30% to 100%.

According to an exemplary embodiment of the present specification, the deuterium content of the third heterocyclic compound may be 0%, or 60% to 100%.

According to an exemplary embodiment of the present specification, the deuterium content of the third heterocyclic compound may be 0%, or 80% to 100%.

According to an exemplary embodiment of the present specification, the deuterium content of the third heterocyclic compound may be 0%, or 90% to 100%.

According to an exemplary embodiment of the present specification, the first heterocyclic compound may be selected from the following.

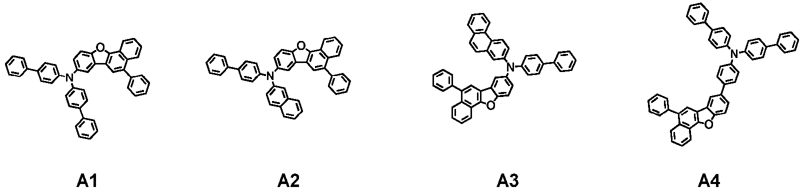

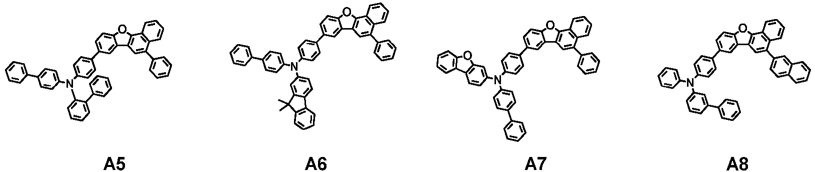

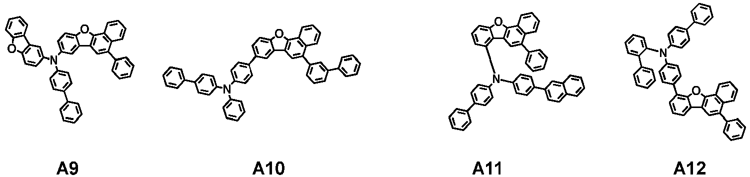

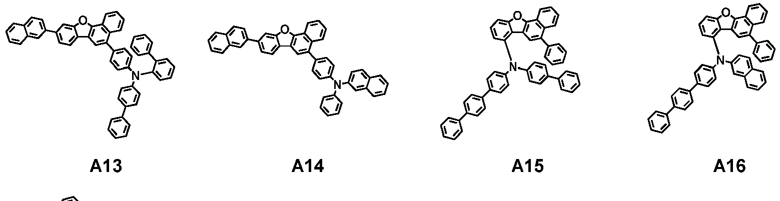

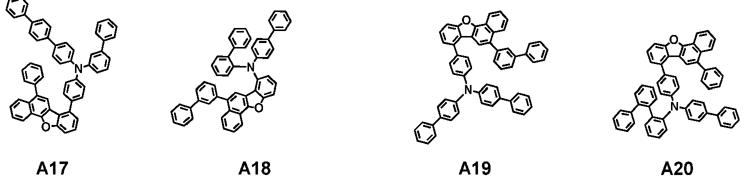

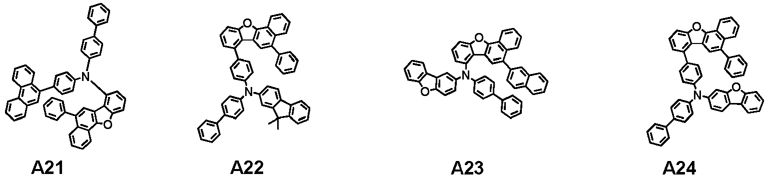

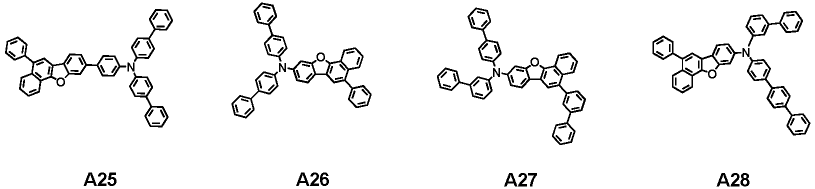

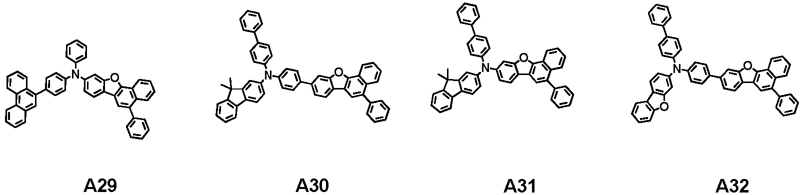

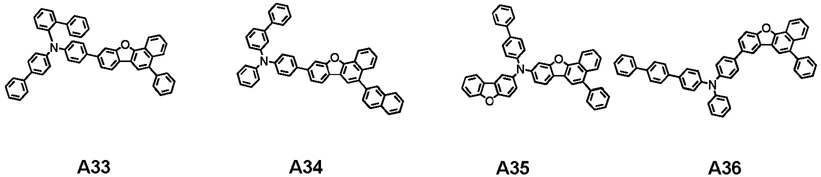

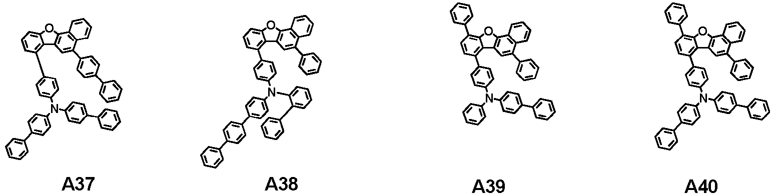

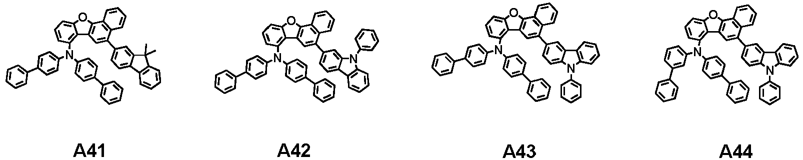

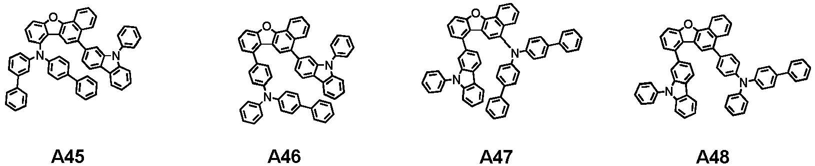

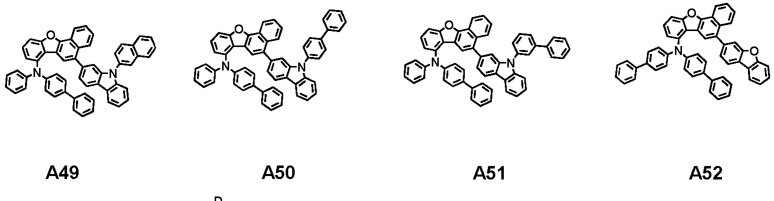

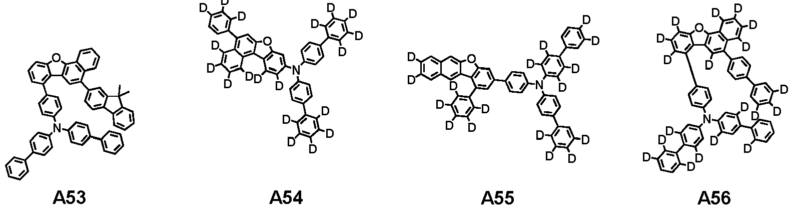

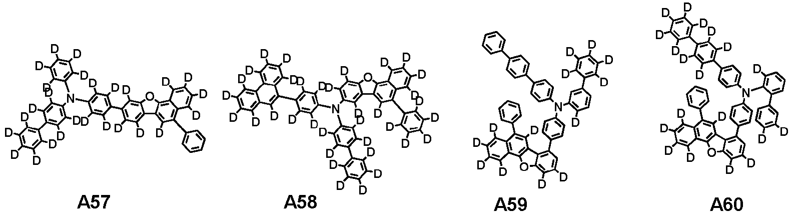

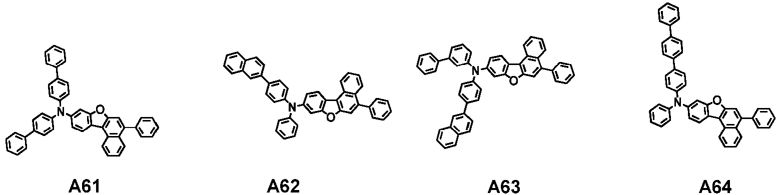

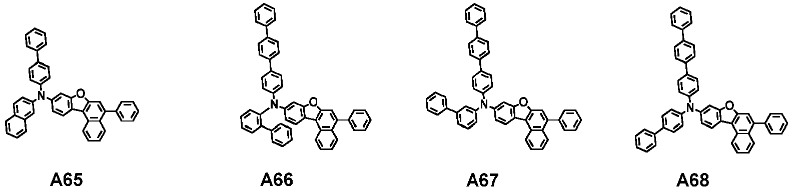

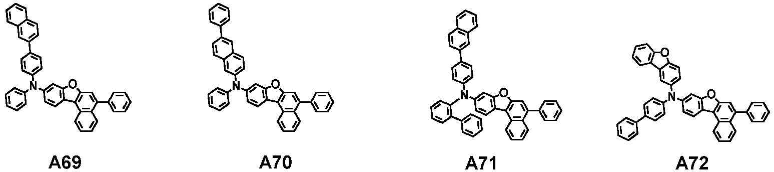

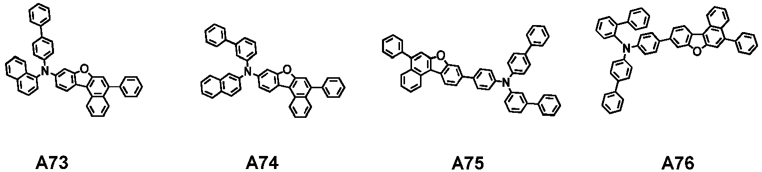

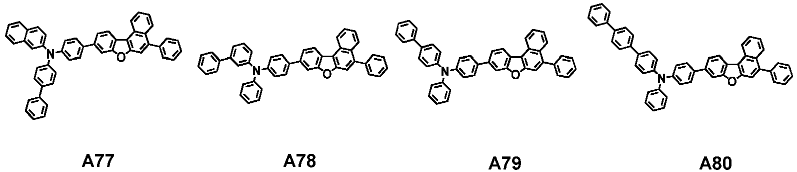

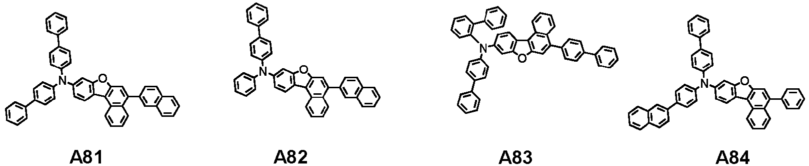

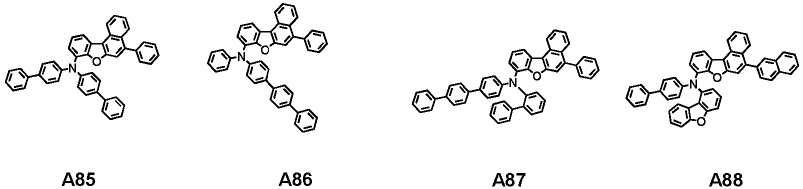

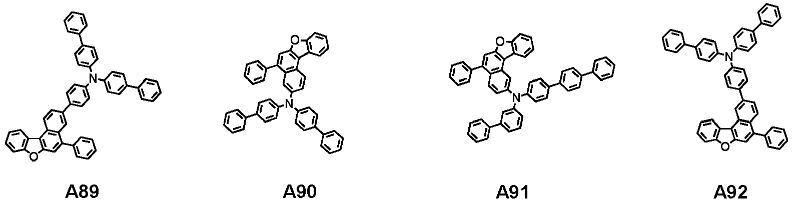

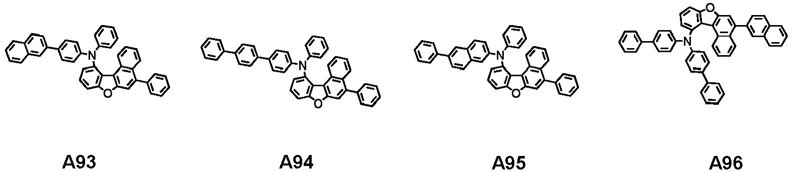

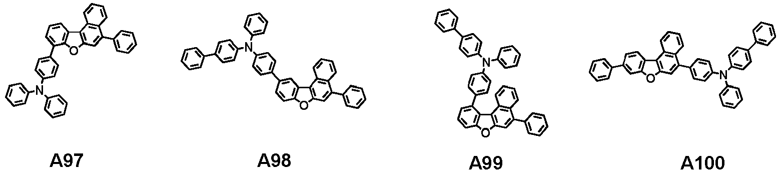

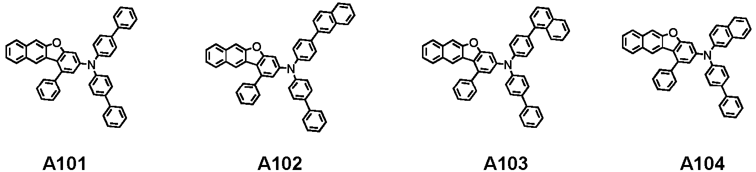

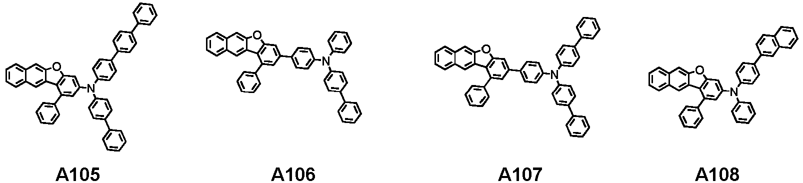

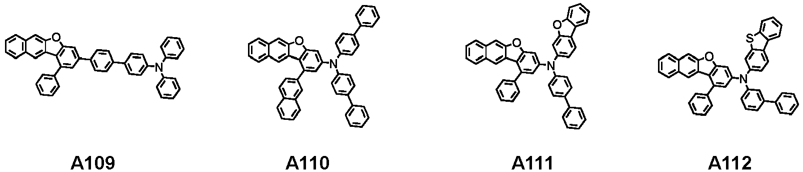

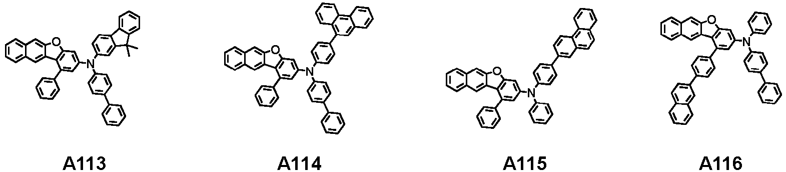

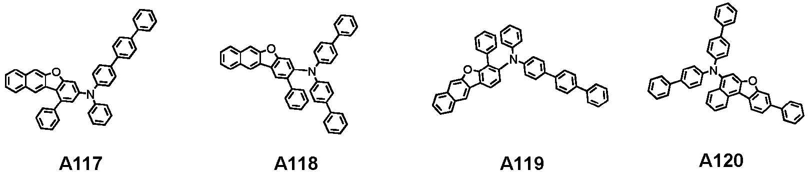

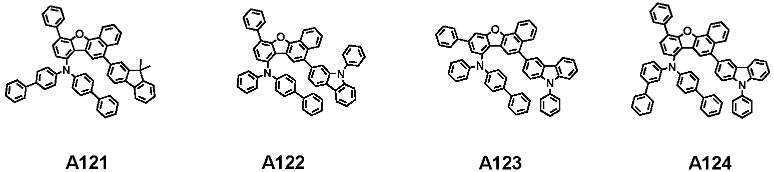

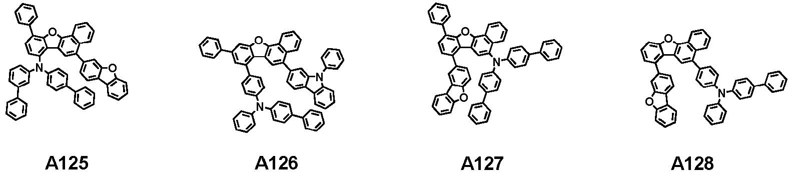

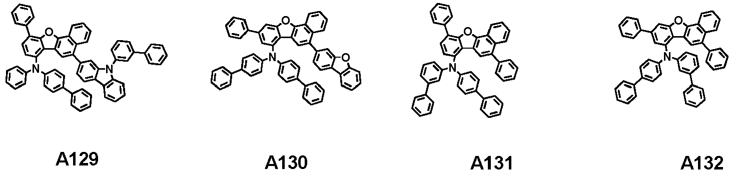

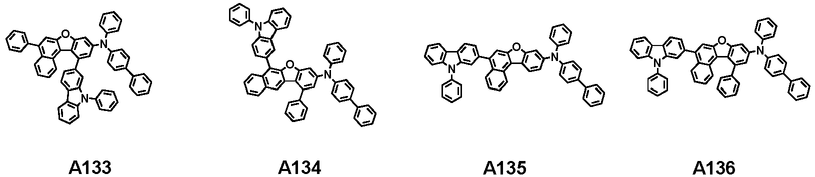

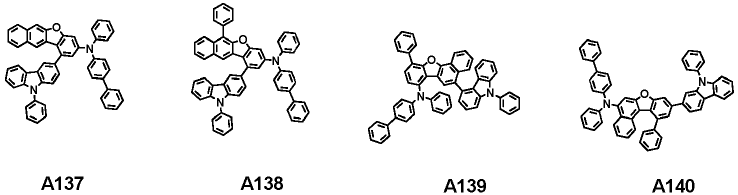

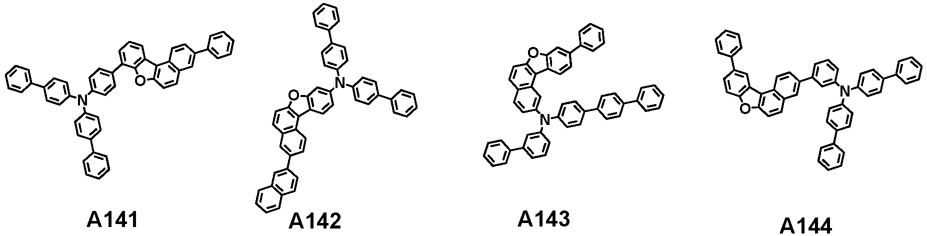

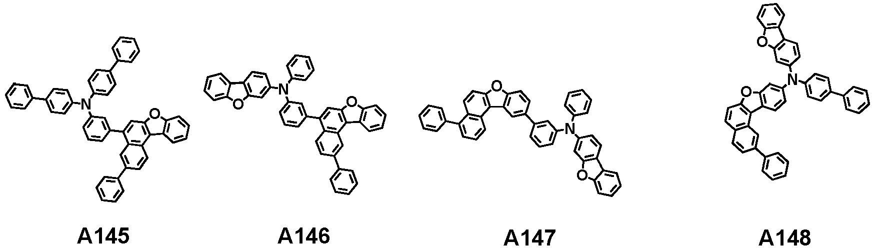

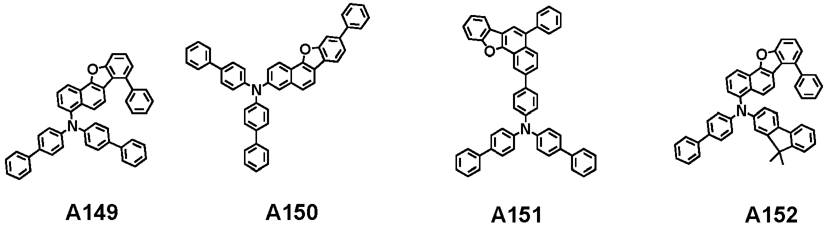

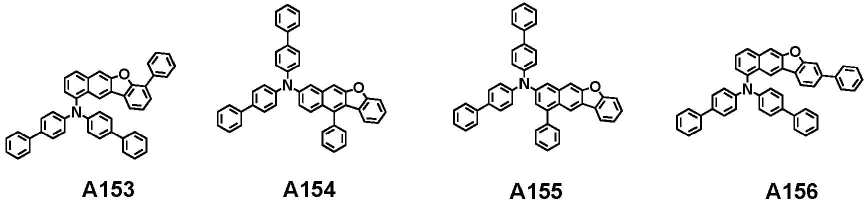

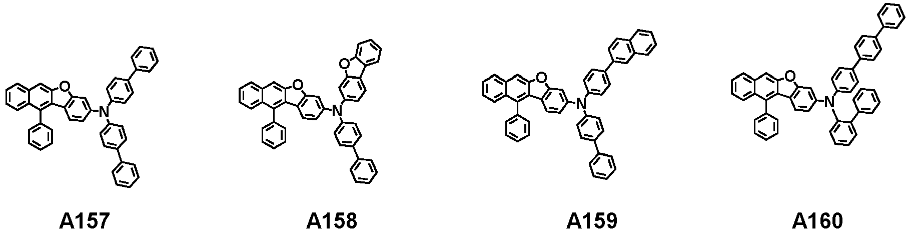

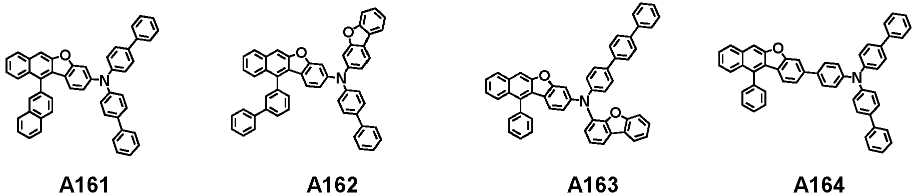

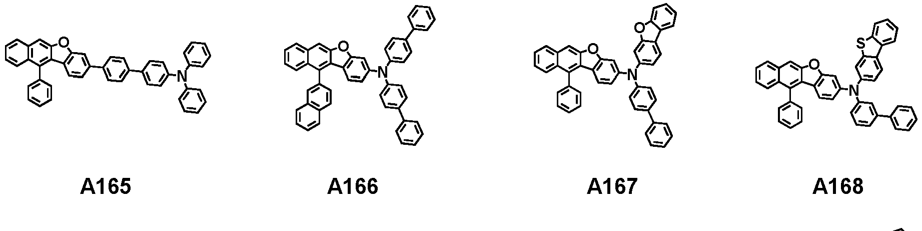

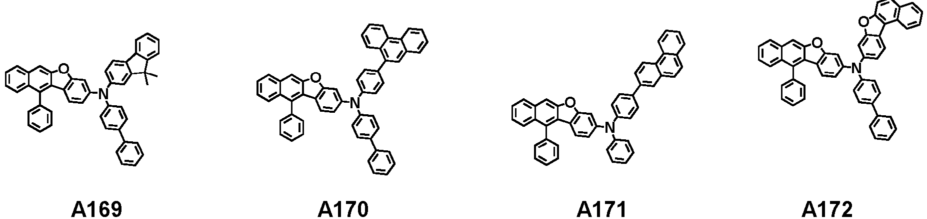

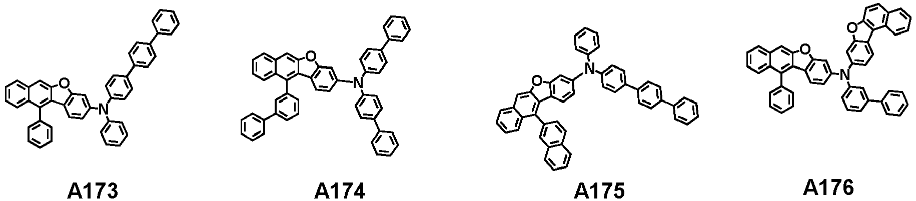

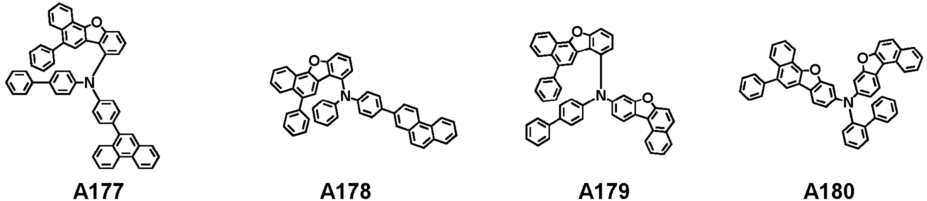

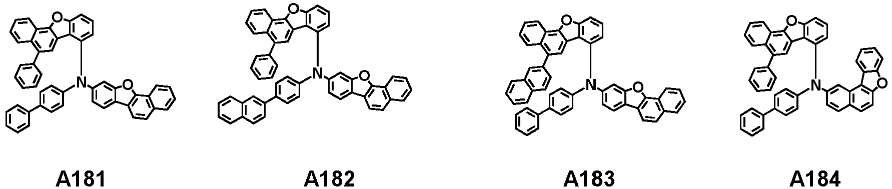

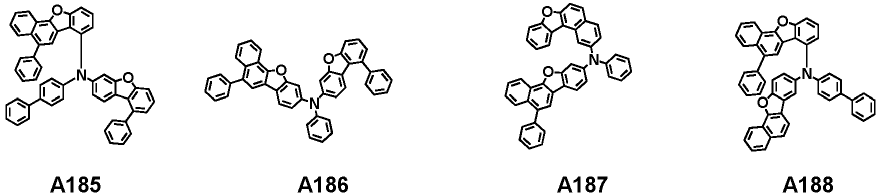

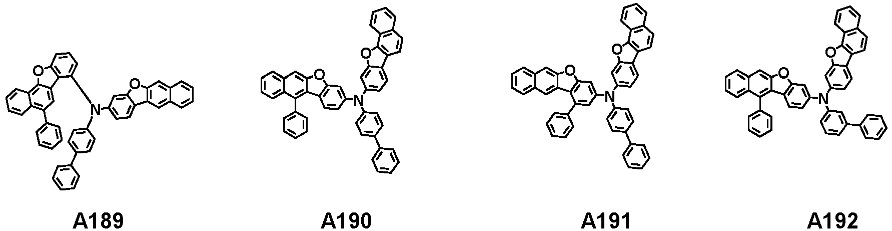

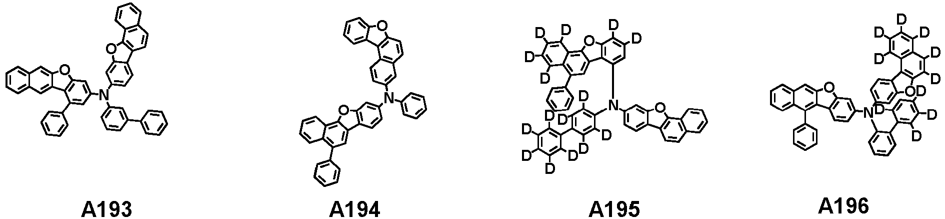

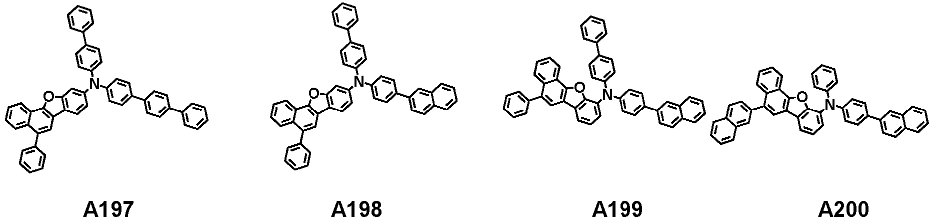

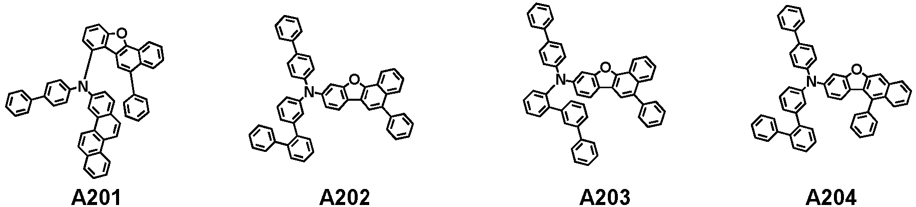

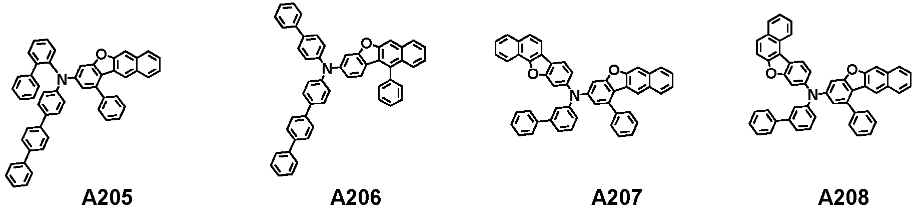

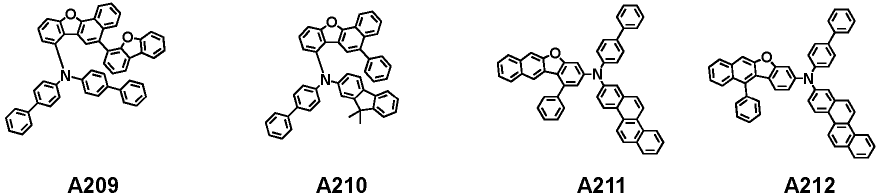

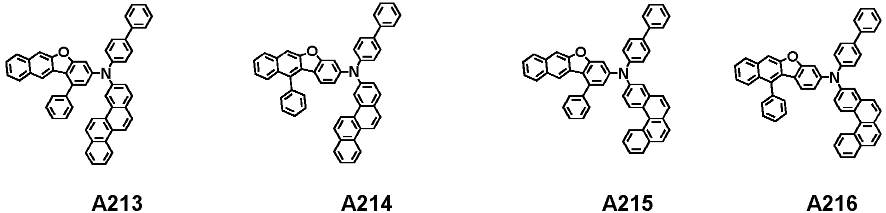

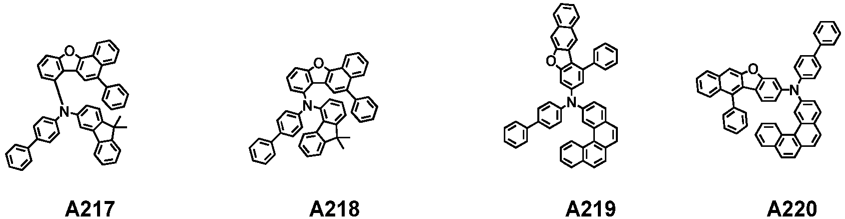

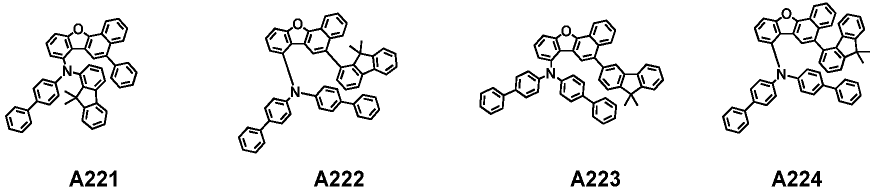

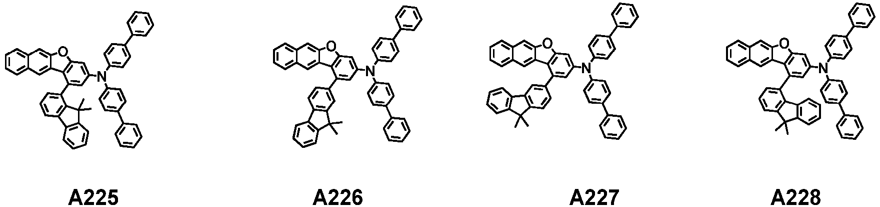

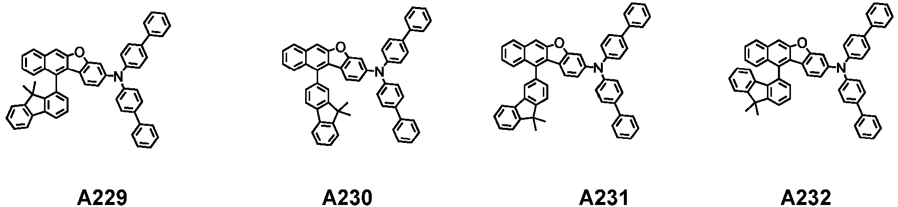

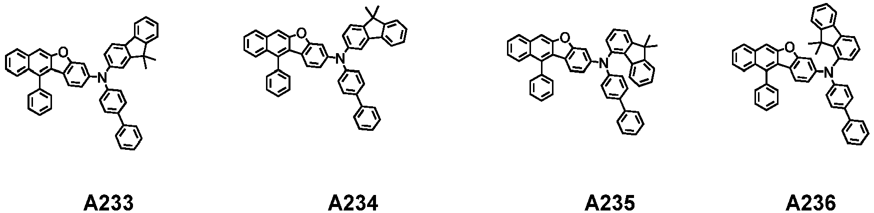

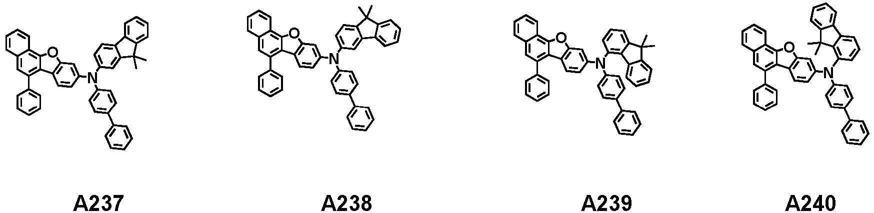

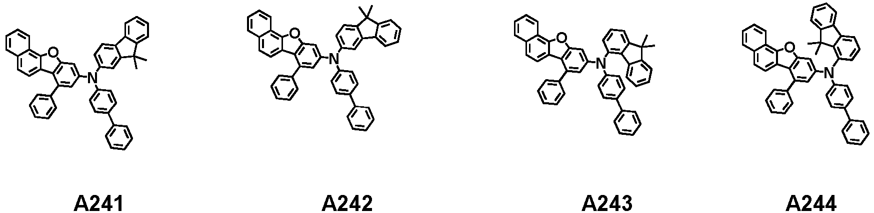

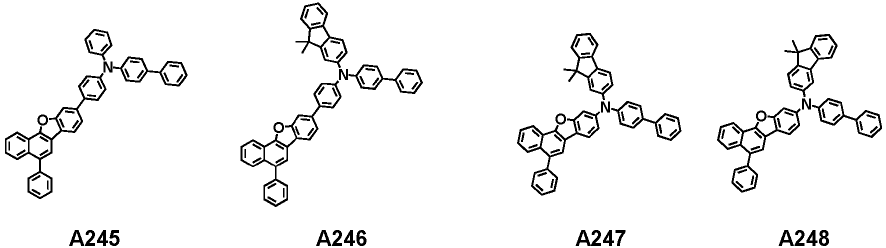

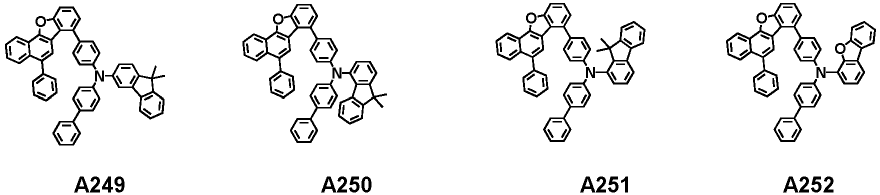

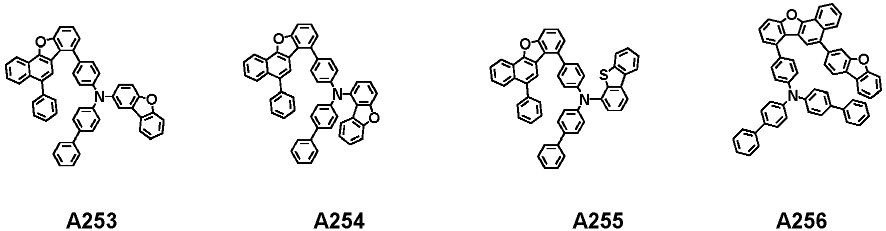

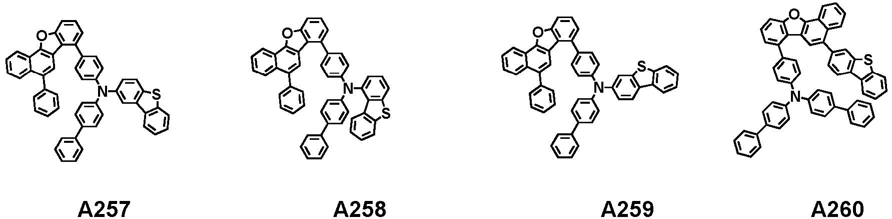

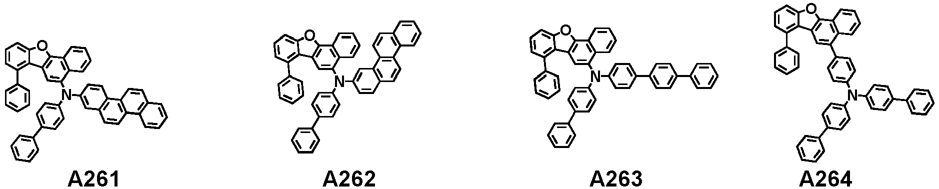

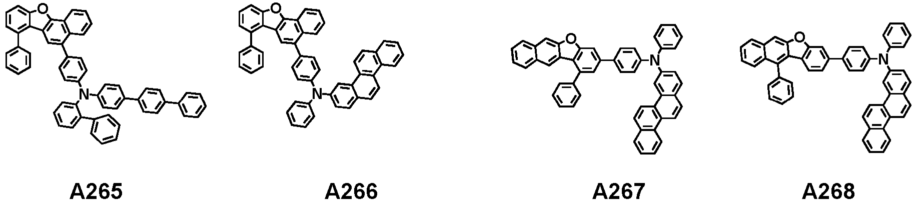

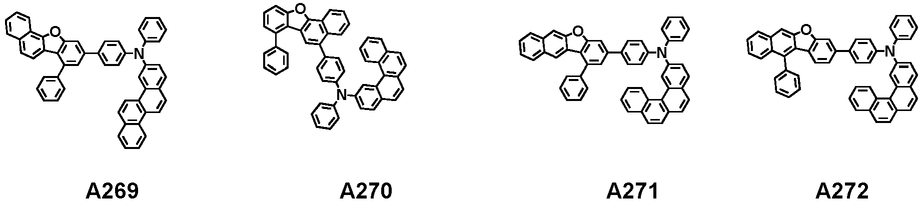

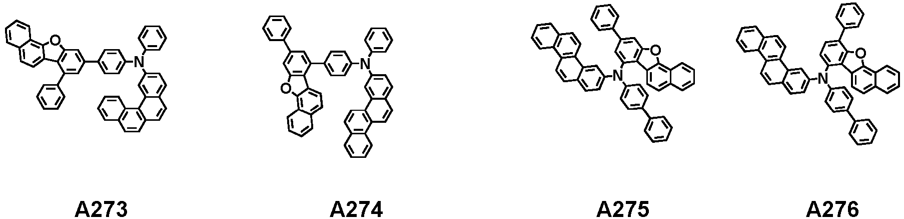

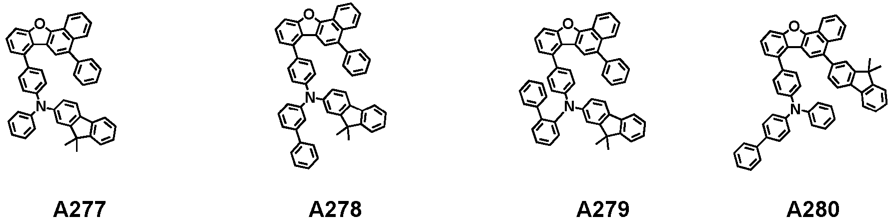

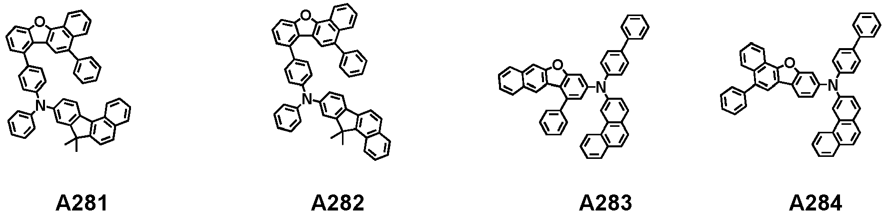

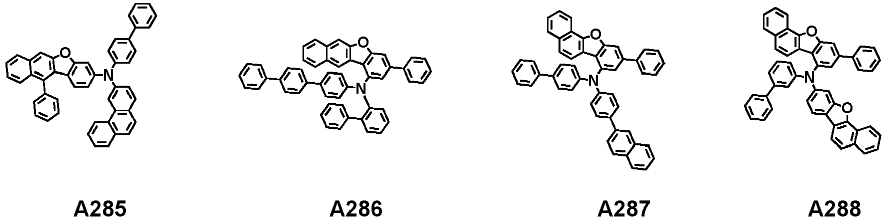

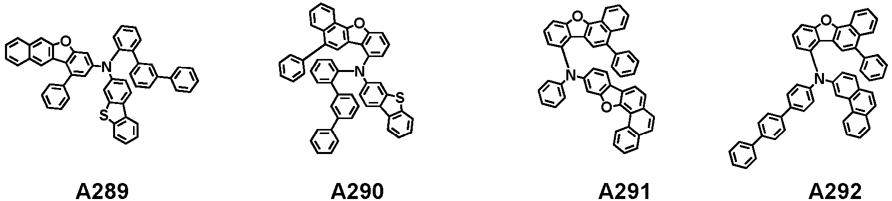

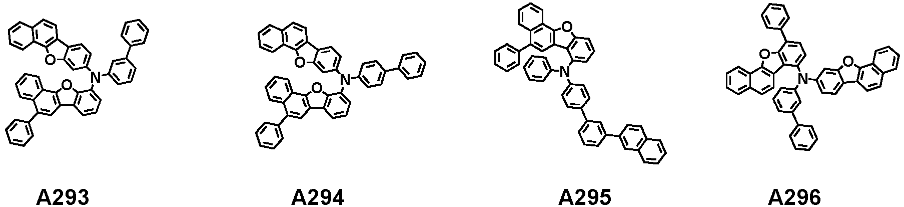

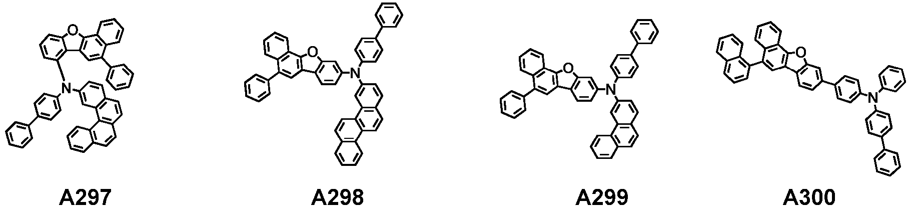

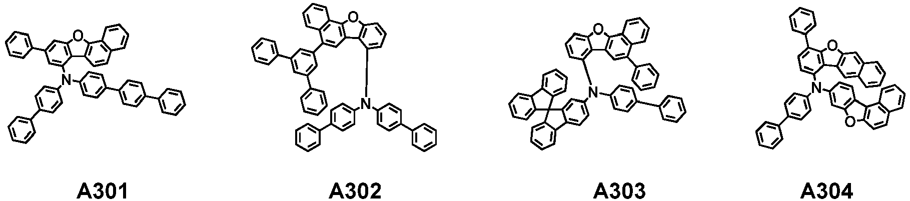

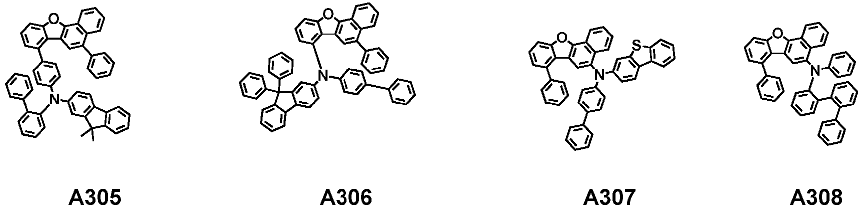

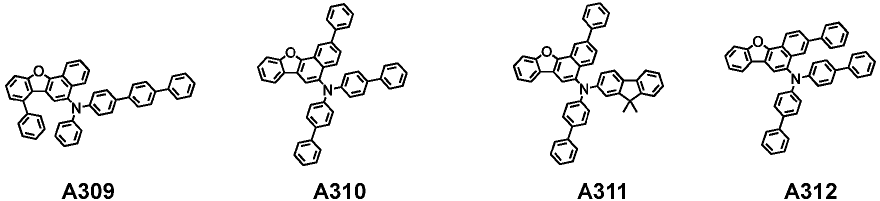

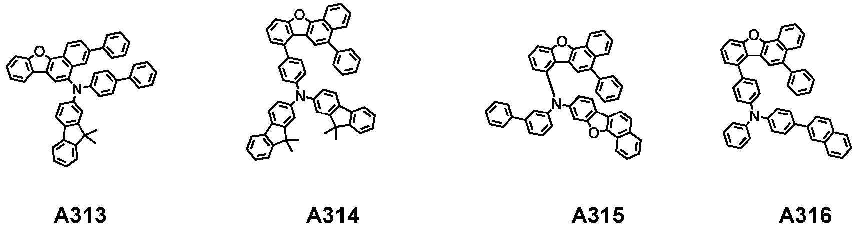

According to an exemplary embodiment of the present specification, the second heterocyclic compound and the third heterocyclic compound are different from each other and may be each selected from the following.

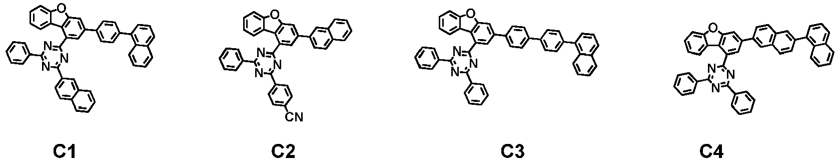

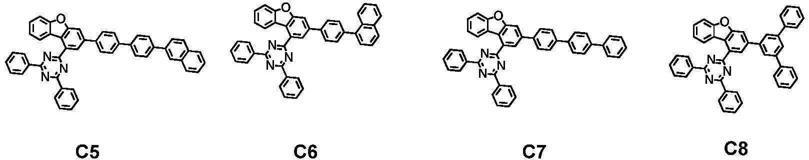

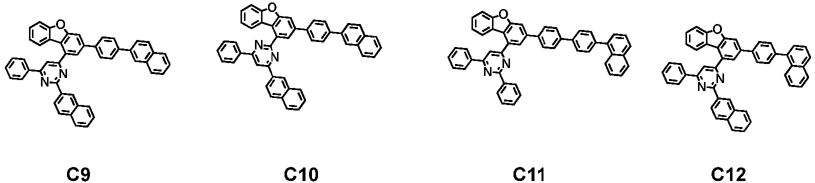

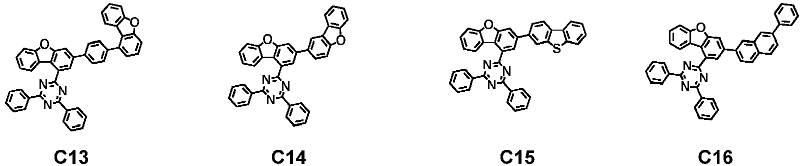

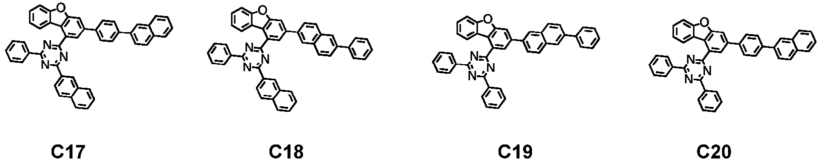

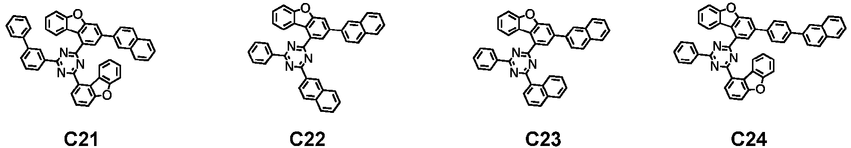

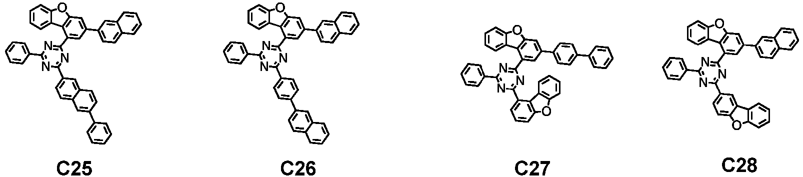

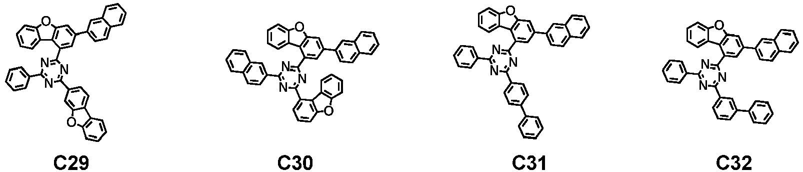

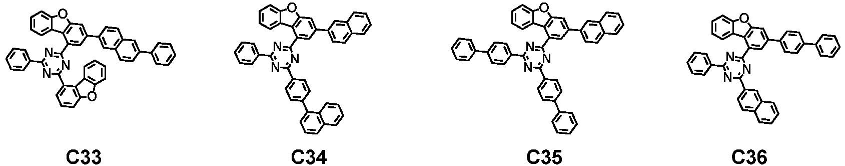

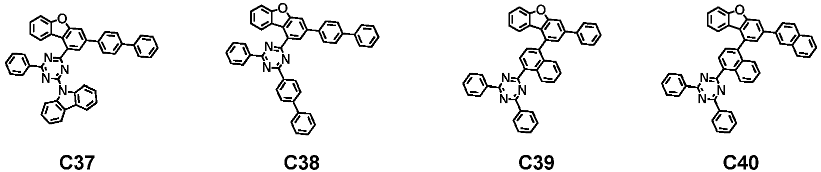

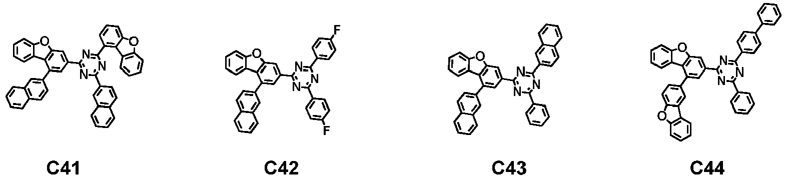

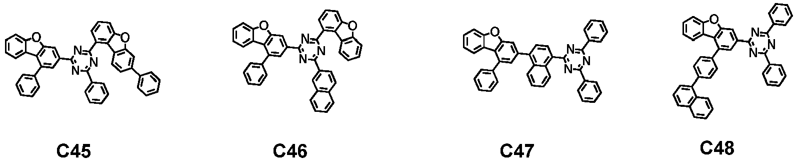

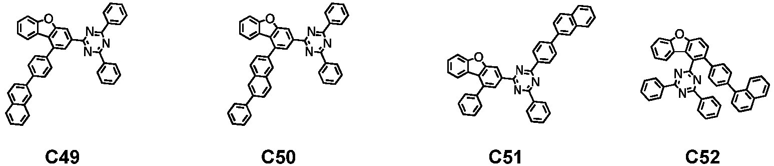

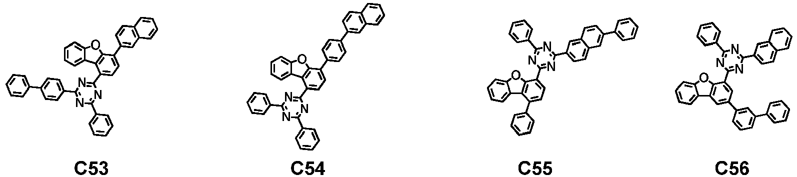

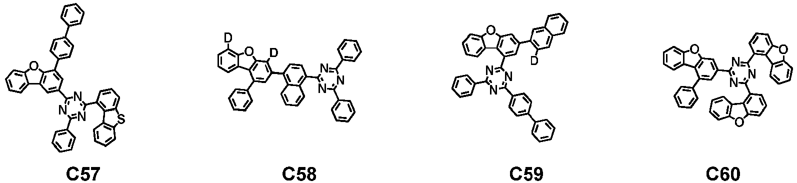

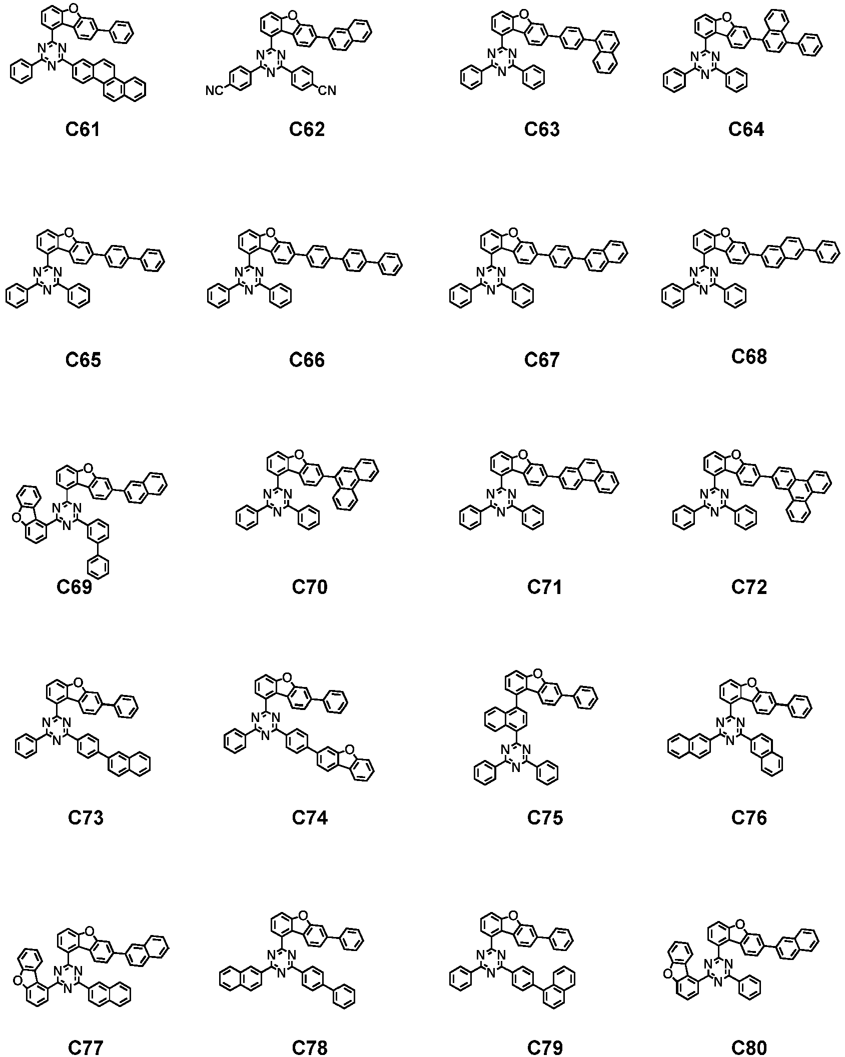

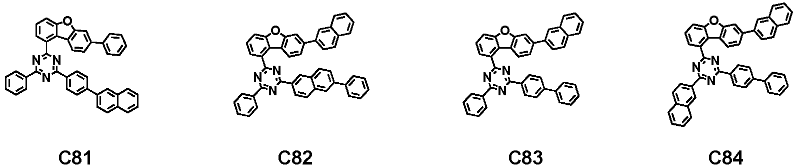

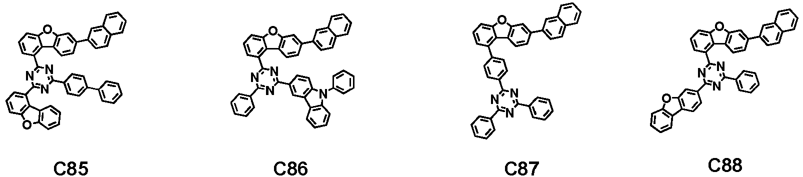

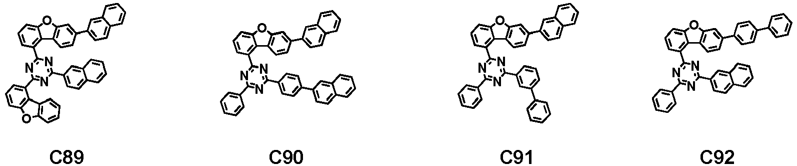

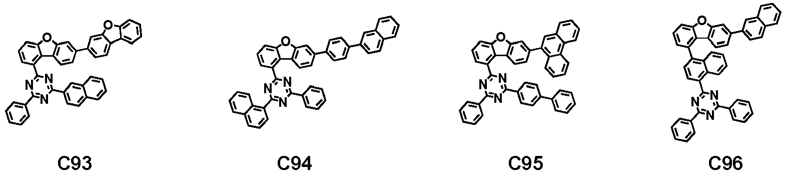

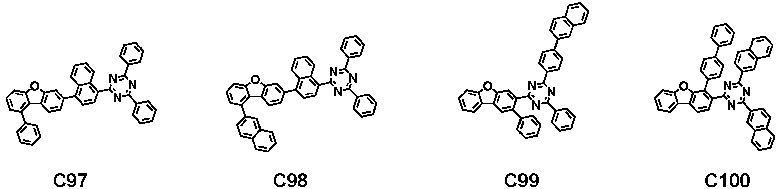

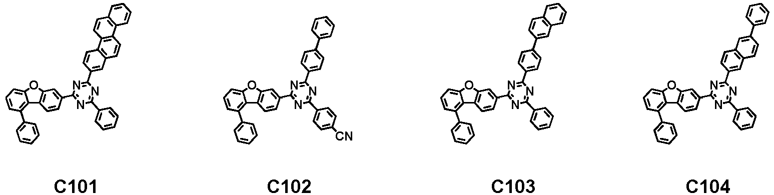

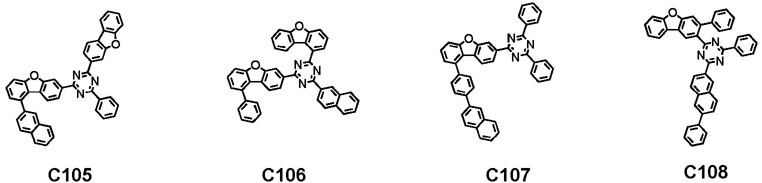

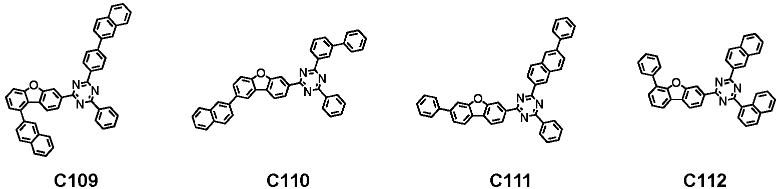

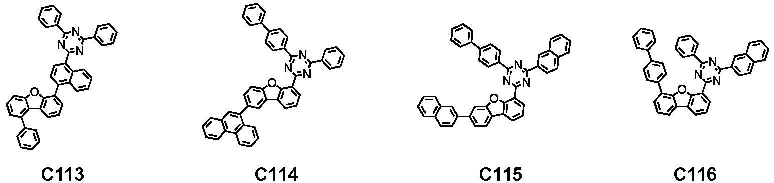

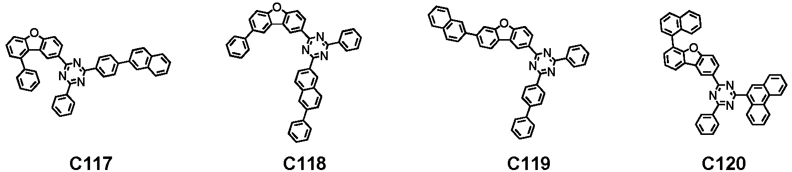

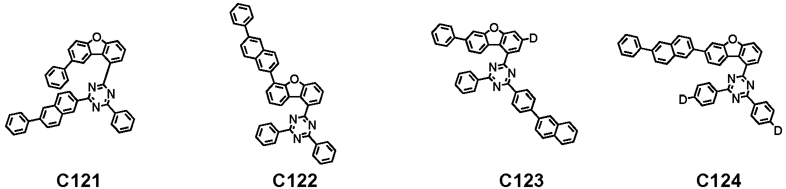

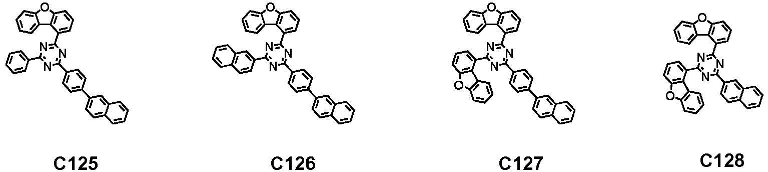

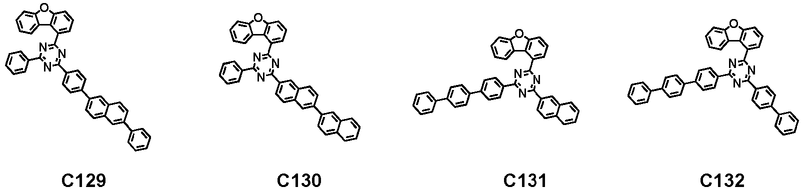

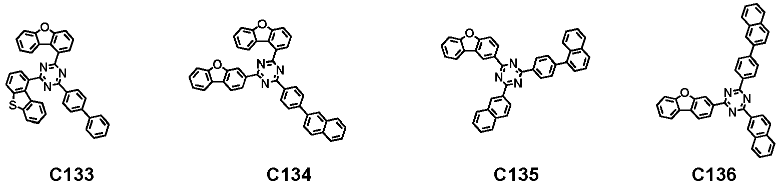

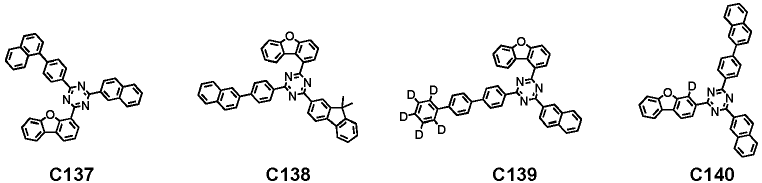

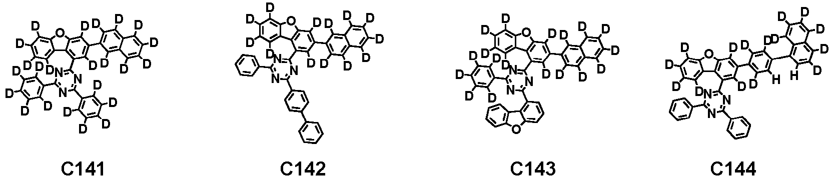

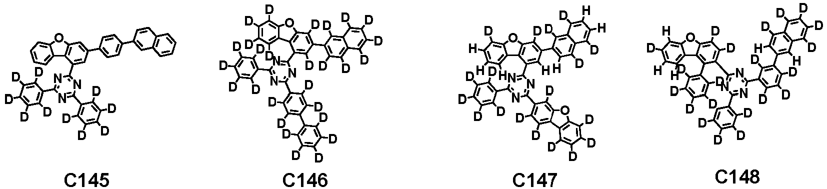

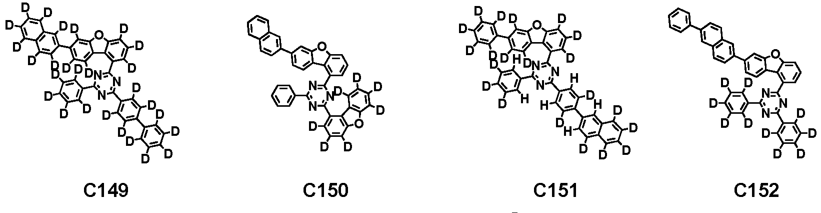

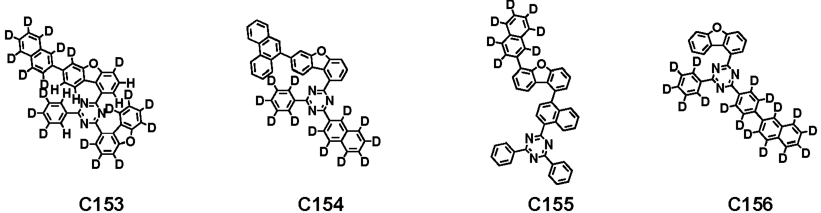

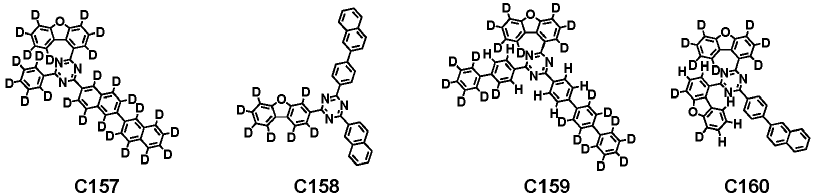

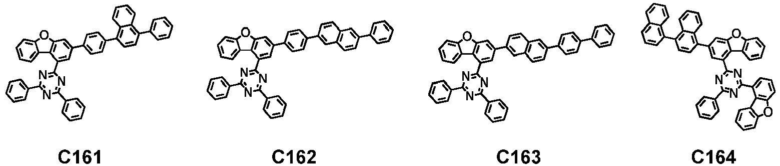

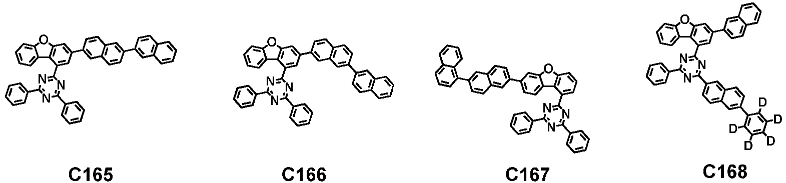

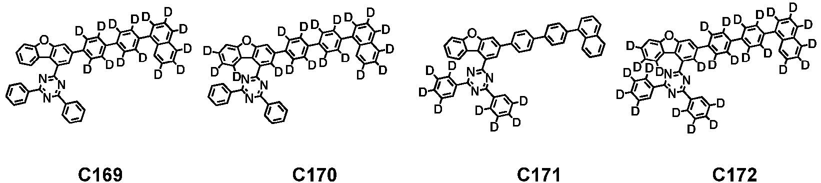

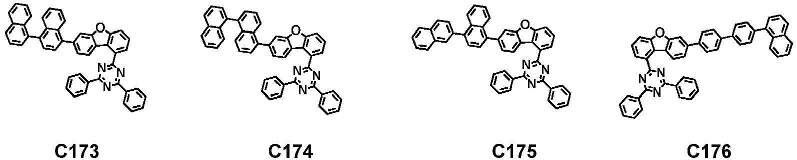

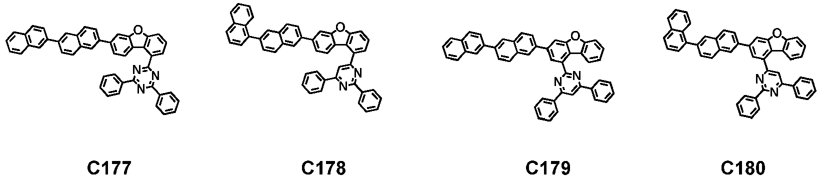

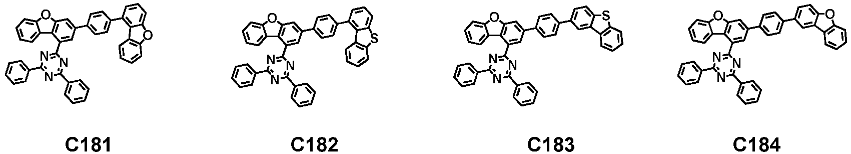

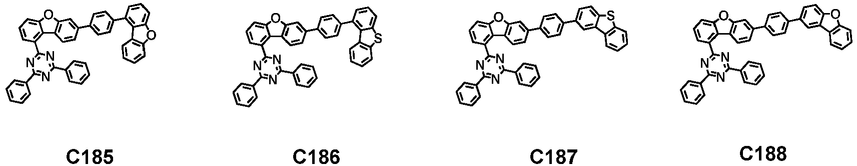

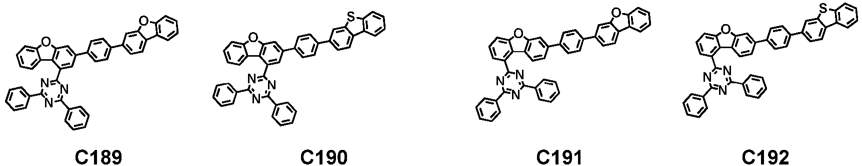

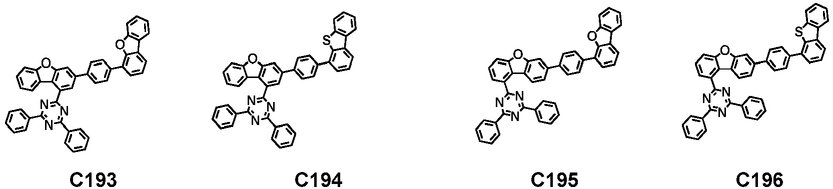

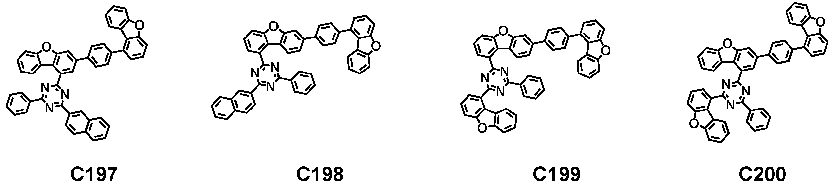

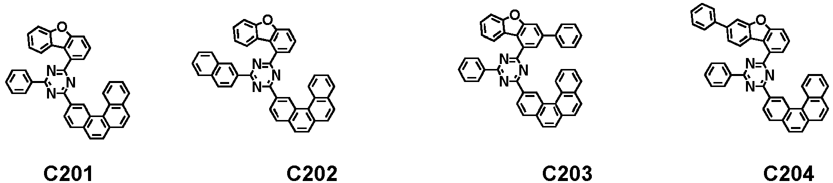

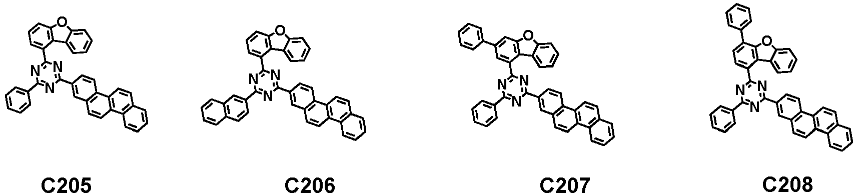

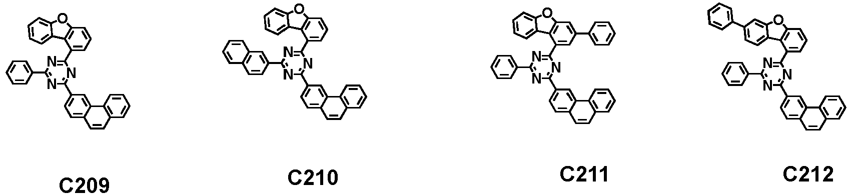

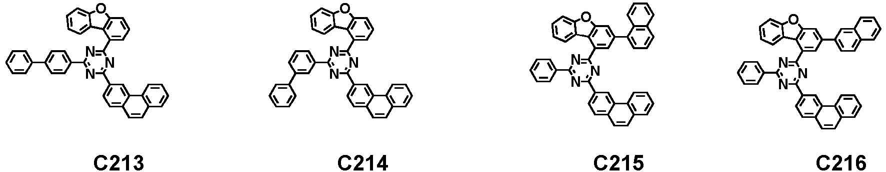

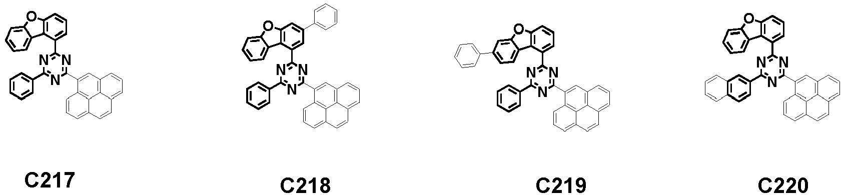

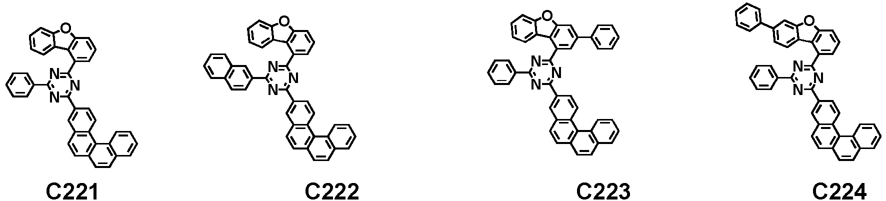

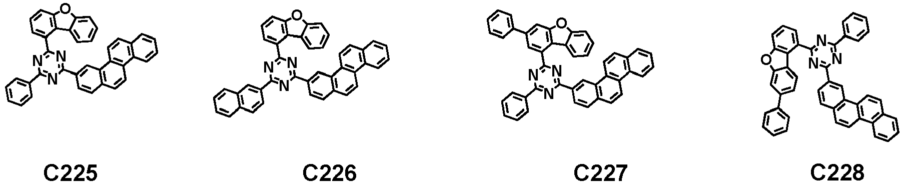

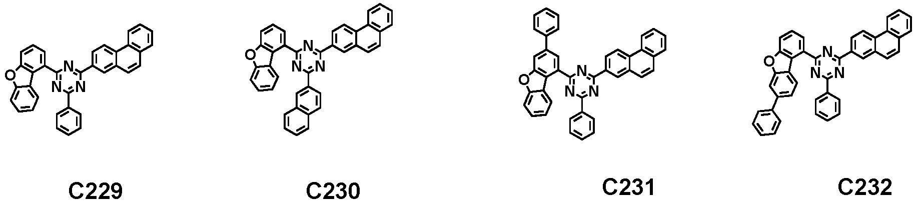

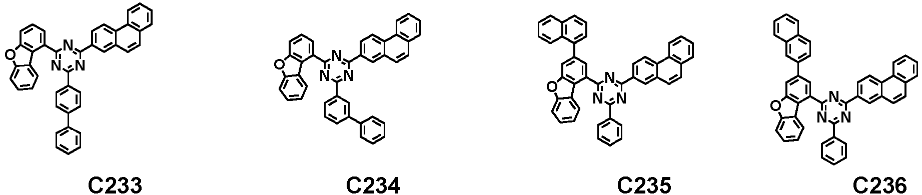

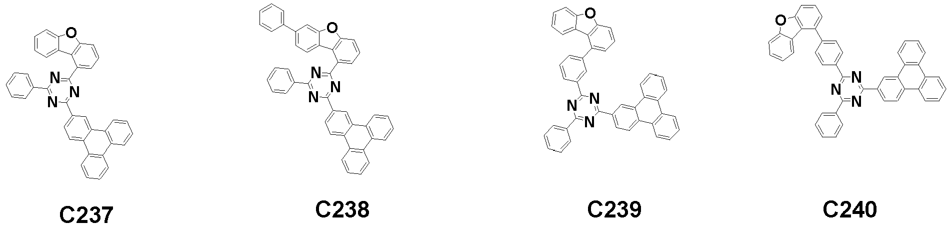

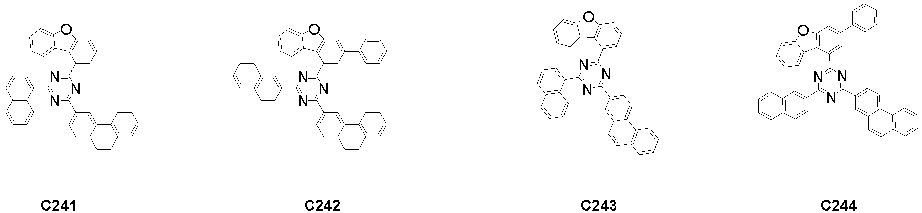

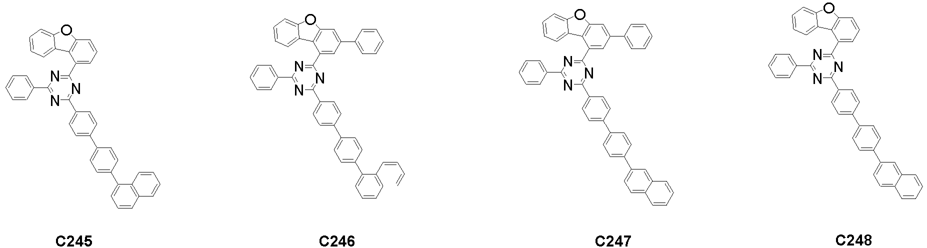

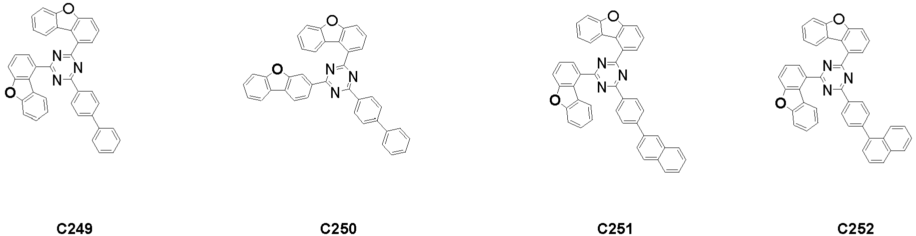

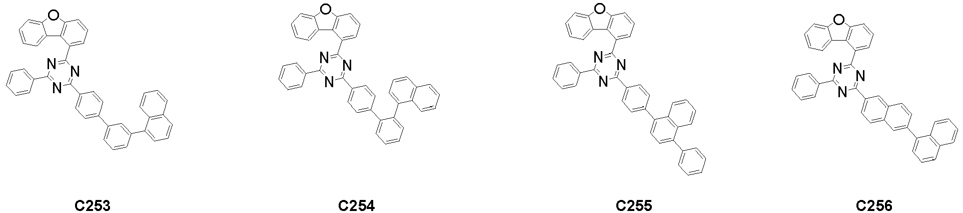

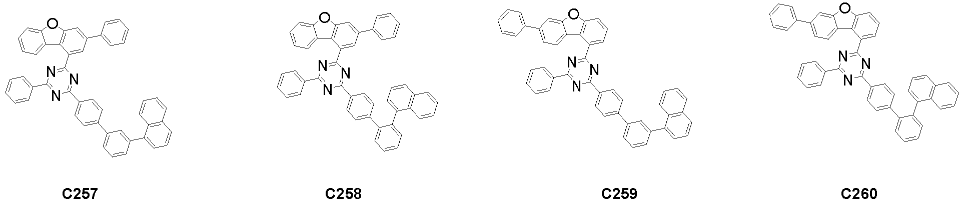

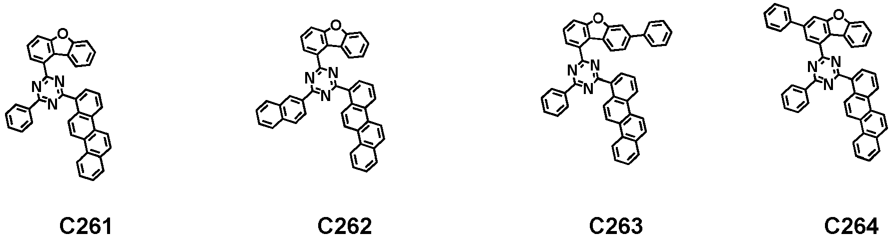

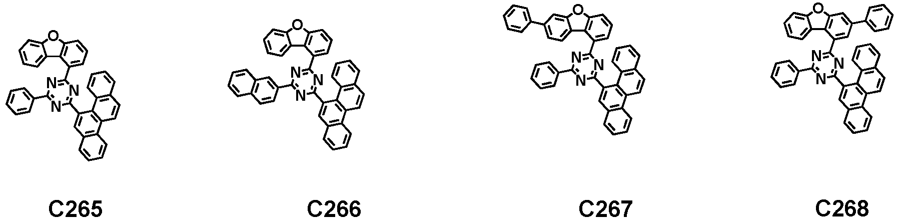

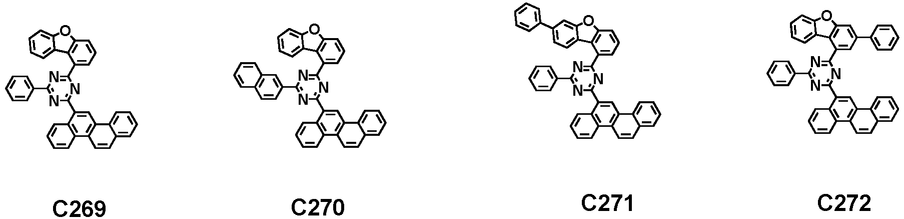

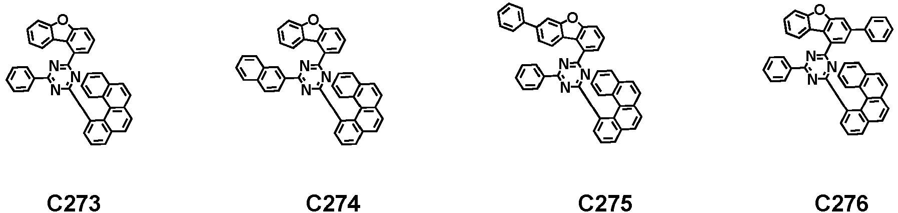

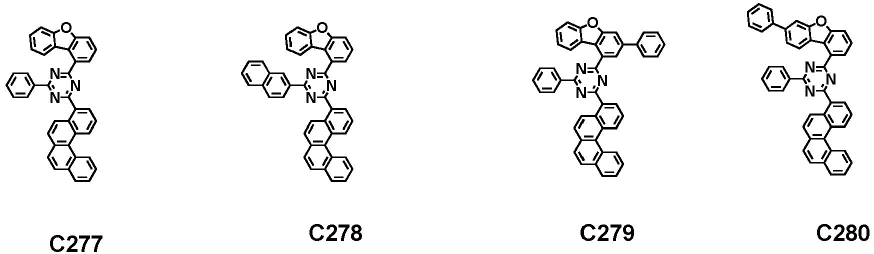

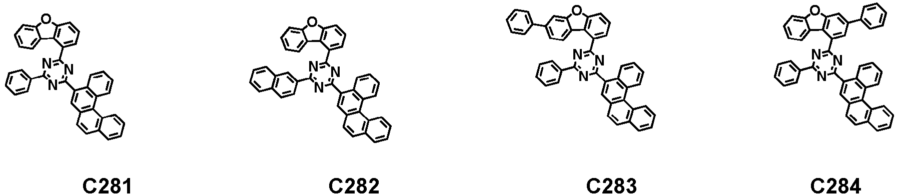

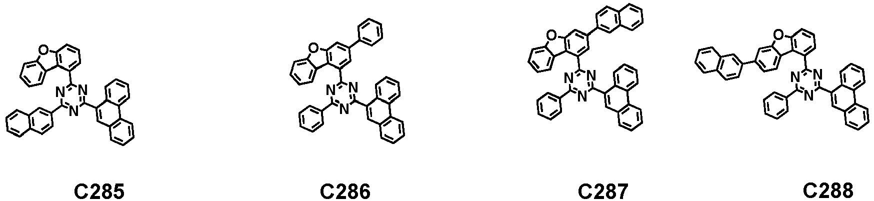

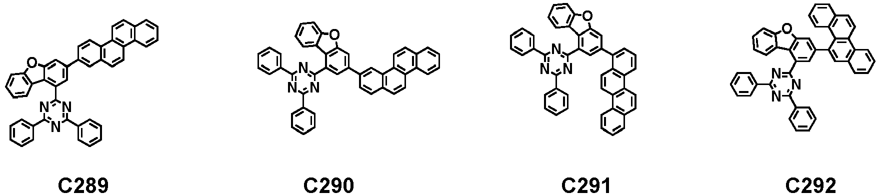

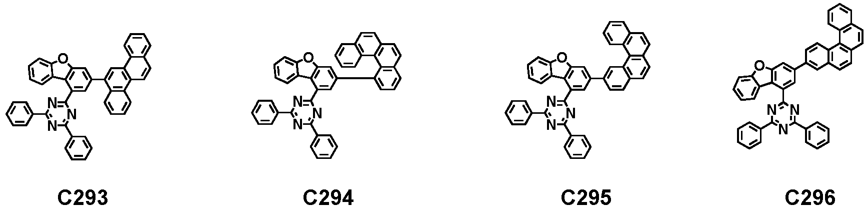

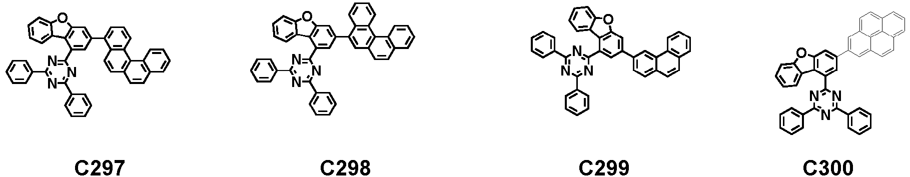

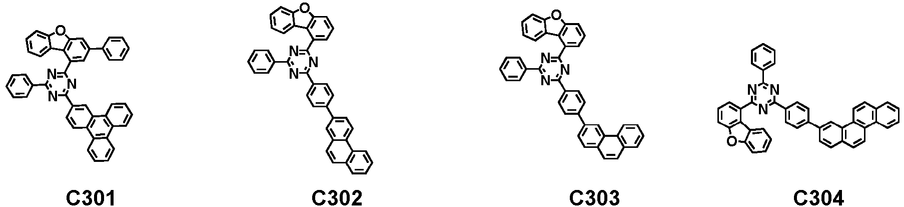

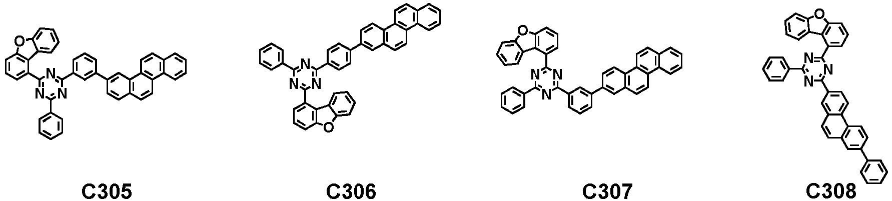

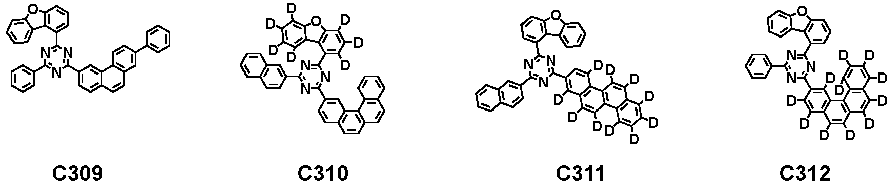

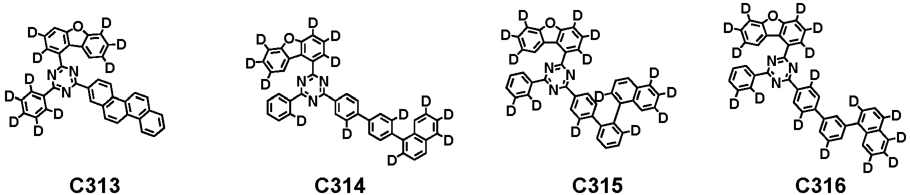

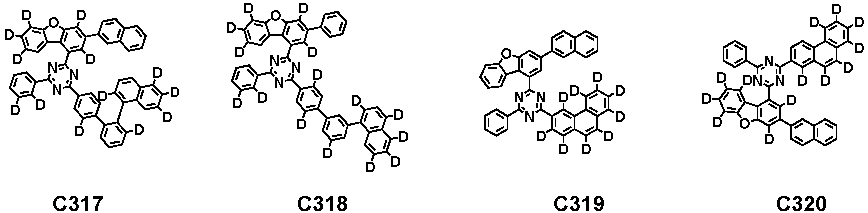

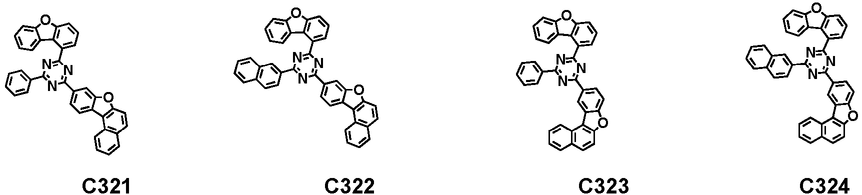

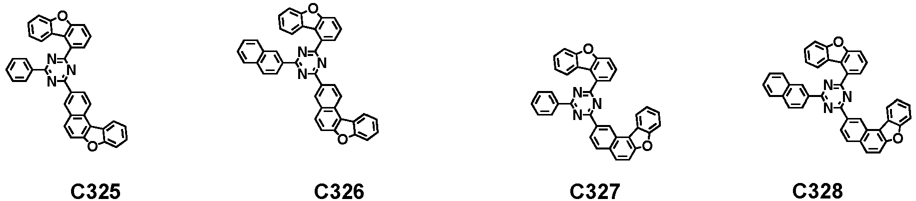

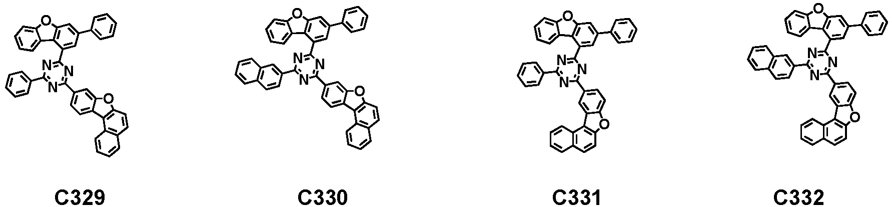

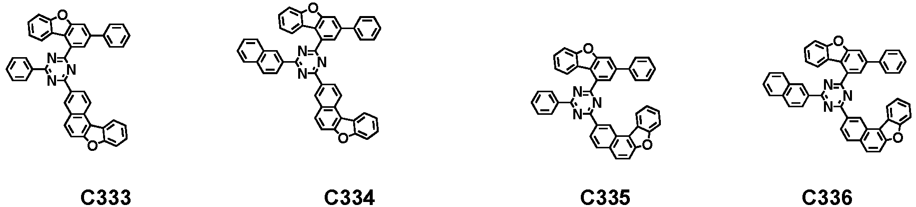

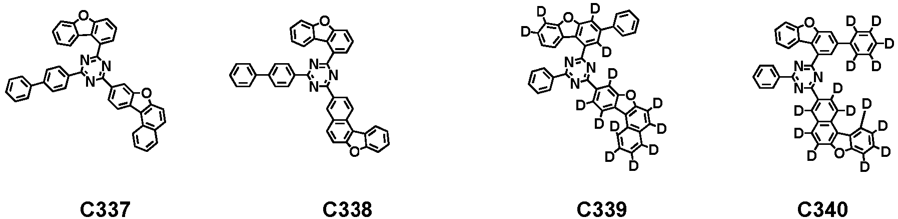

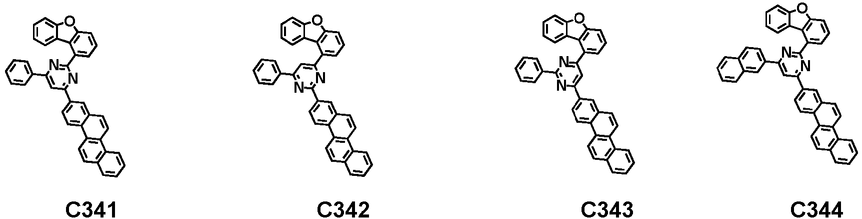

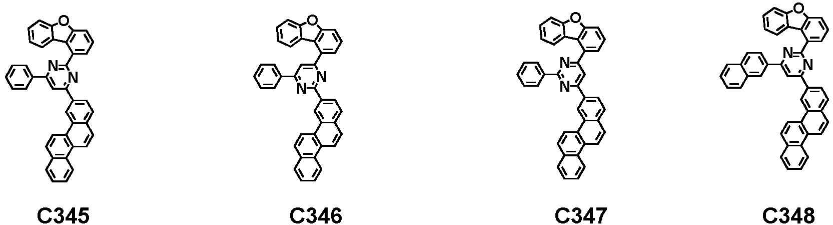

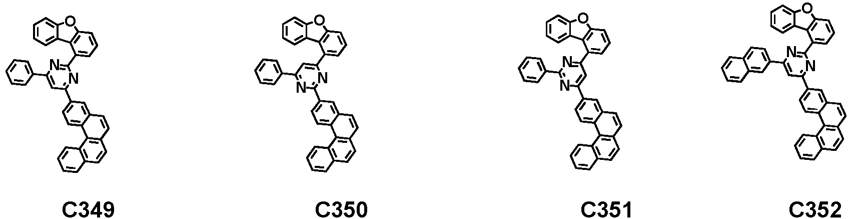

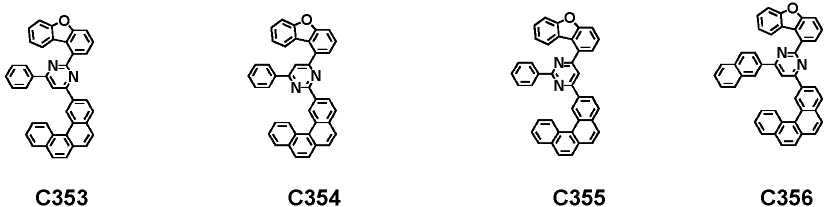

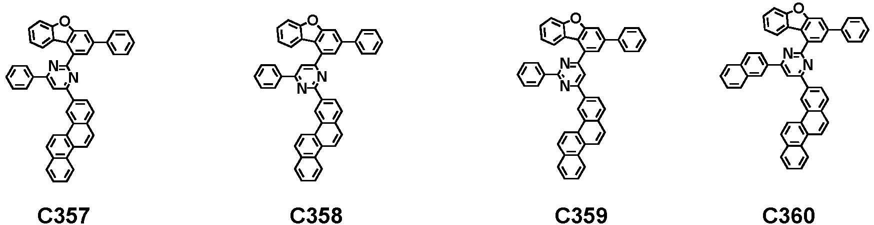

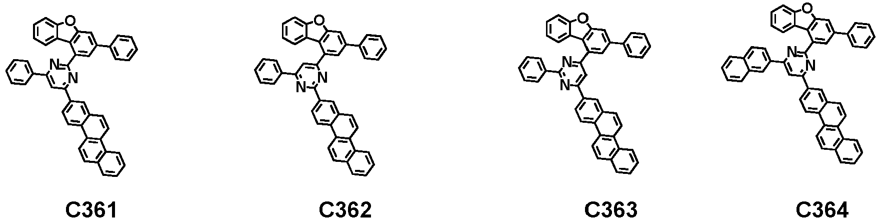

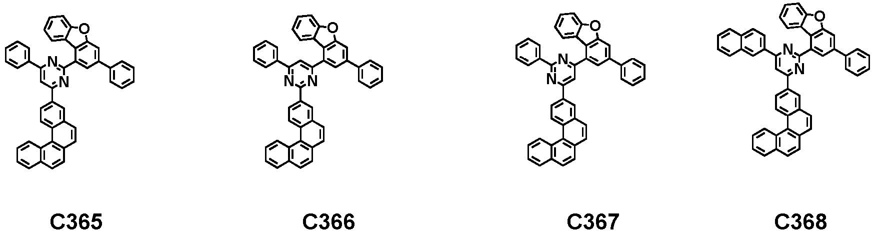

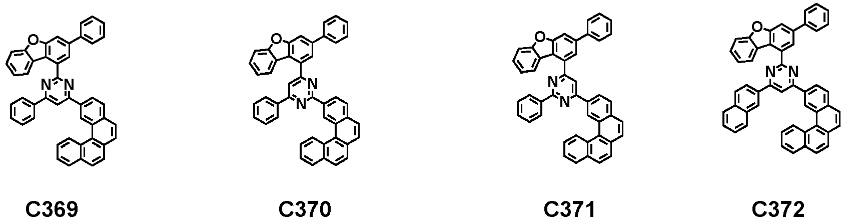

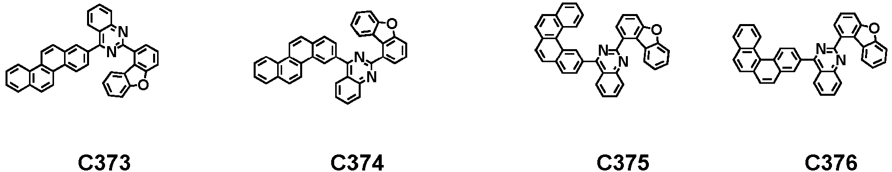

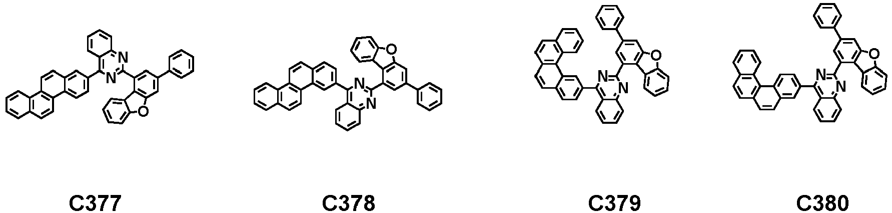

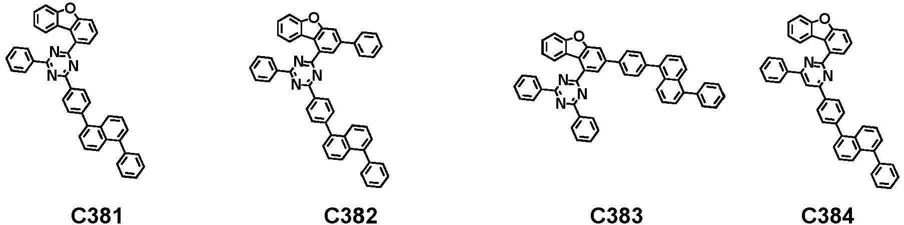

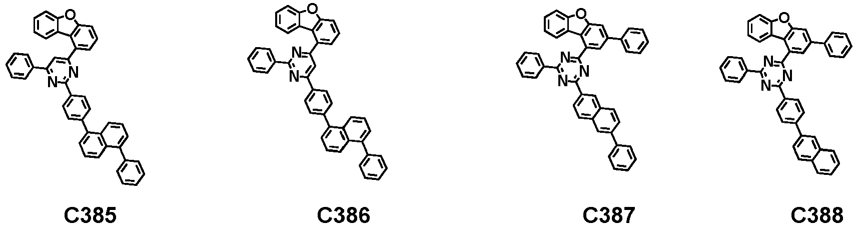

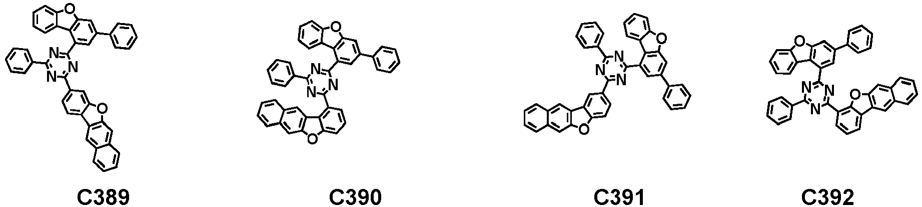

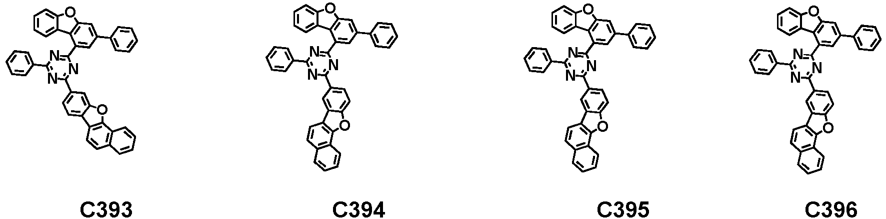

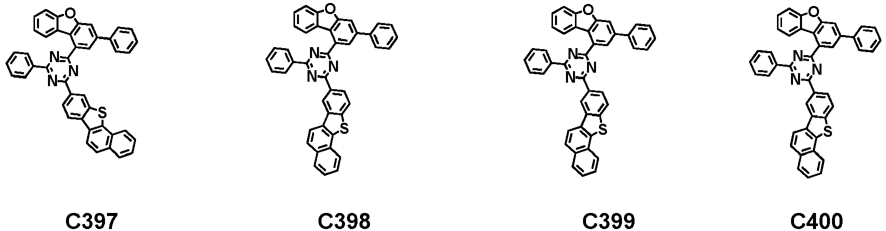

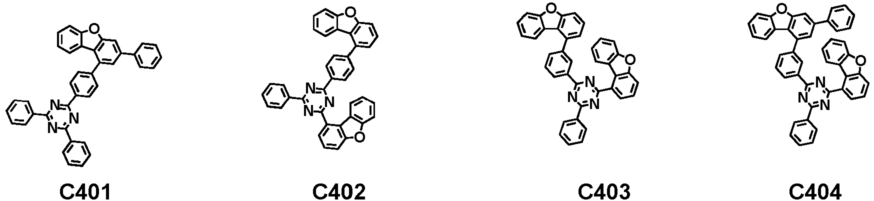

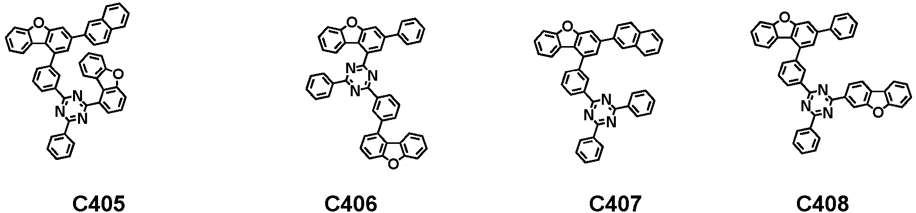

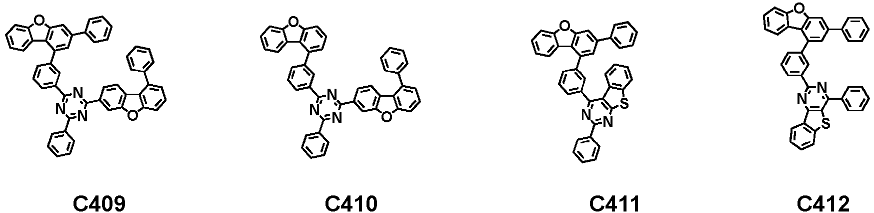

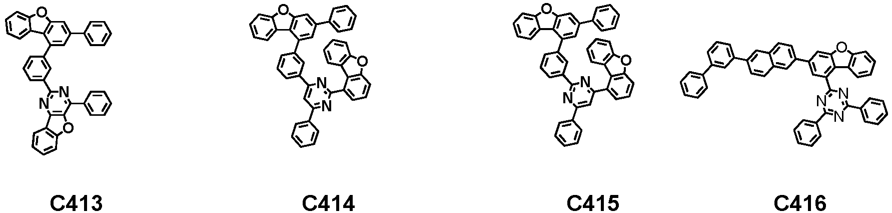

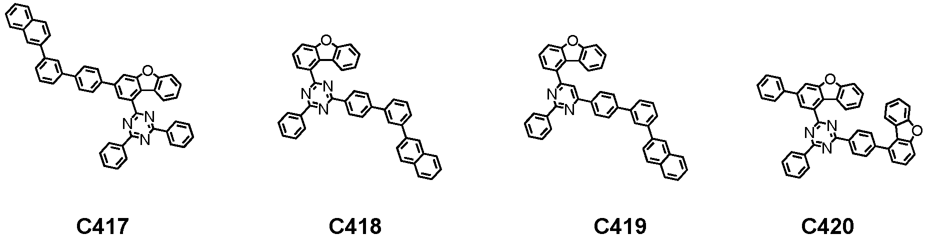

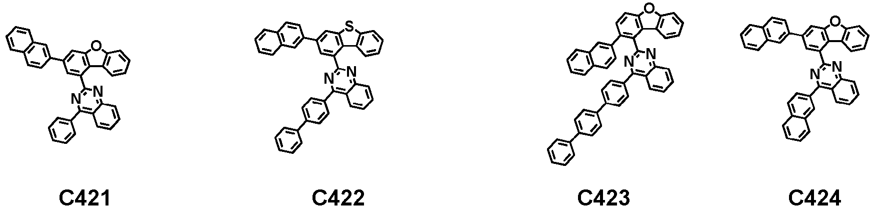

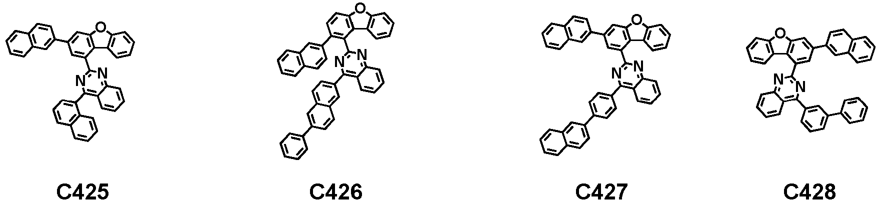

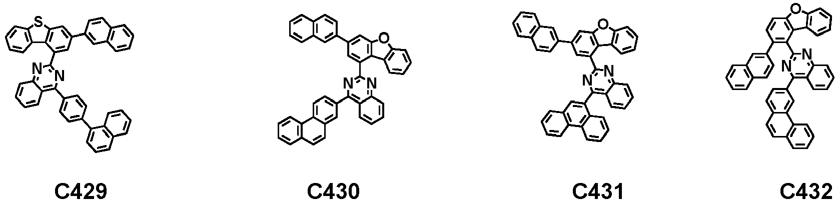

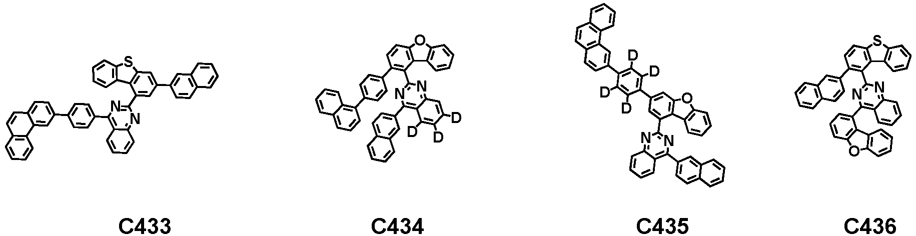

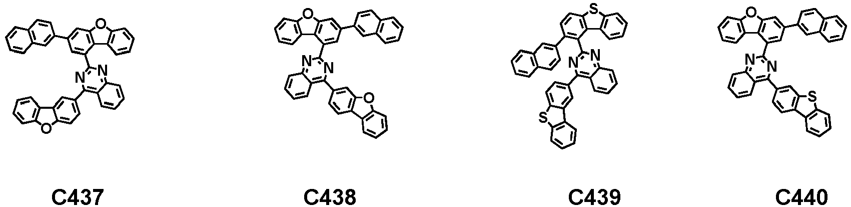

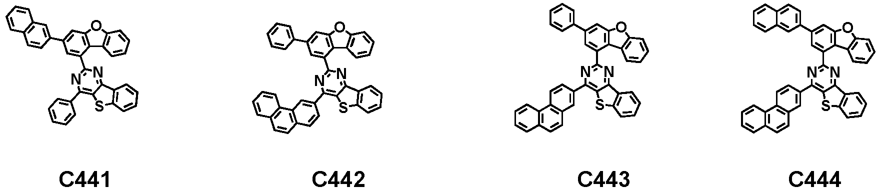

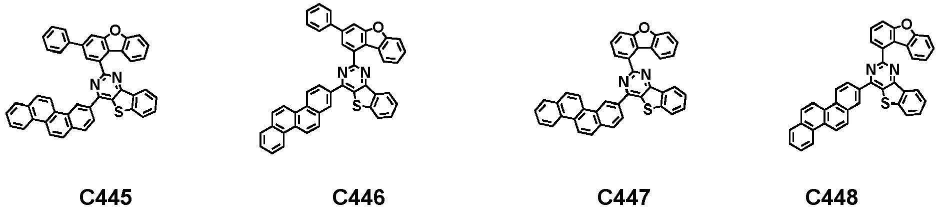

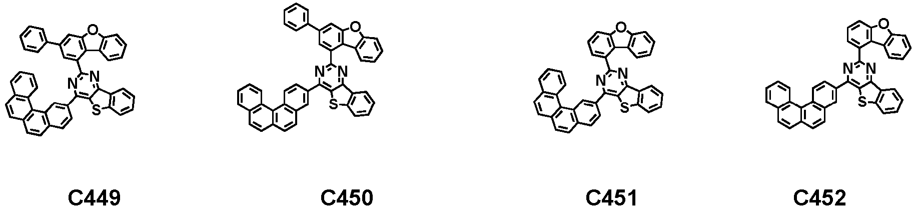

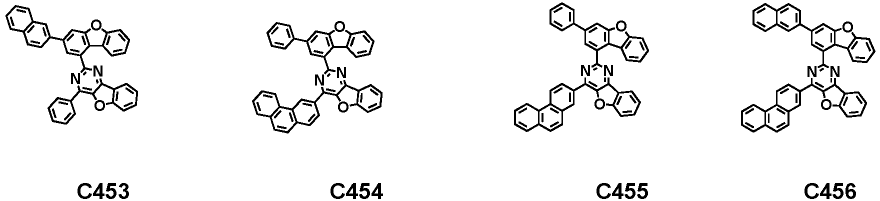

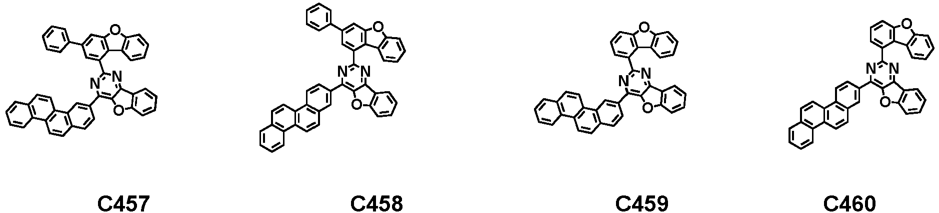

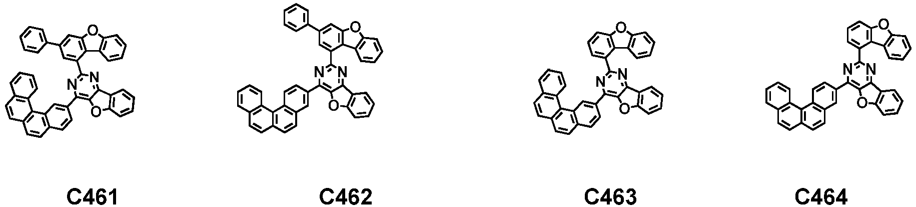

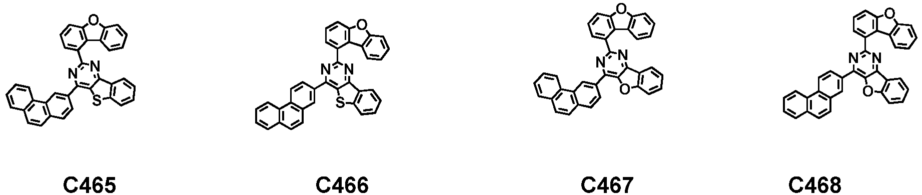

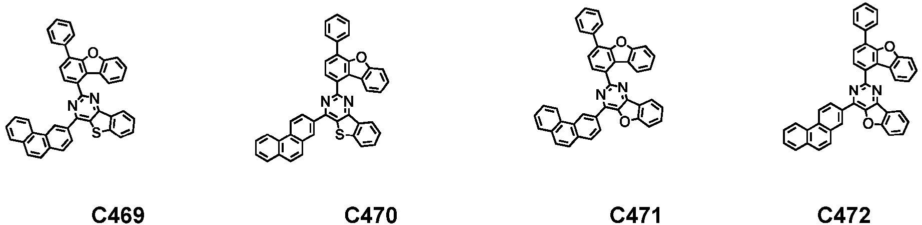

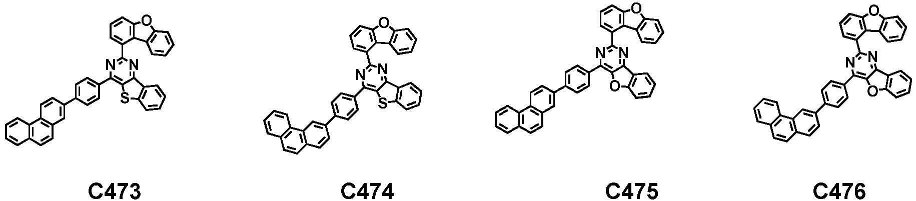

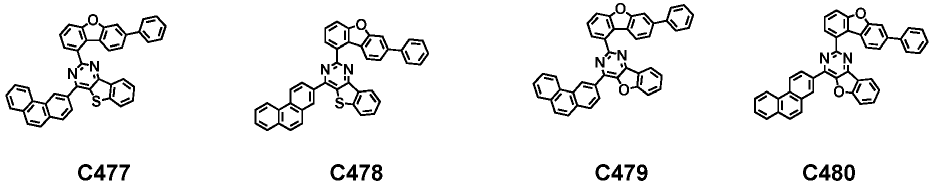

As long as the inherent characteristics of the first heterocyclic compound (represented by Chemical Formula A), the second heterocyclic compound, and the third heterocyclic compound (the second and third heterocyclic compounds are both represented by Chemical Formula C, but are compounds with different structures), are maintained, it is possible to synthesize compounds having additional inherent characteristics of the introduced substituents by introducing various substituents into structures other than the compounds exemplified above. For example, it is possible to synthesize a material which satisfies the conditions required for each organic material layer by introducing into the core structure a substituent usually used for a hole injection layer material, a hole transport layer material, a hole transport auxiliary layer material, a light emitting layer material, an electron transport layer material, an electron transport auxiliary layer material, and a charge generation layer material used during the manufacture of an organic light emitting device.

In addition, it is possible to finely adjust an energy band-gap by introducing various substituents into the heterocyclic compound structures represented by Chemical Formulae A and C, and meanwhile, it is possible to improve characteristics at the interface between organic materials and diversify the use of the material.

According to an exemplary embodiment of the present specification, the organic material layer further includes at least one of a hole transport layer and an electron blocking layer, and at least one of the hole transport layer and the electron blocking layer and the electron blocking layer may include the first heterocyclic compound, the second heterocyclic compound, and the third heterocyclic compound.

According to an exemplary embodiment of the present specification, the organic material layer further includes a hole transport layer, and the hole transport layer may include the first heterocyclic compound, the second heterocyclic compound, and the third heterocyclic compound.

According to an exemplary embodiment of the present specification, the organic material layer further includes an electron blocking layer, and the electron blocking layer may include the first heterocyclic compound, the second heterocyclic compound, and the third heterocyclic compound.

According to an exemplary embodiment of the present specification, the organic material layer further includes a light emitting layer, and the light emitting layer may include the first heterocyclic compound, the second heterocyclic compound, and the third heterocyclic compound.

In another exemplary embodiment of the present specification, the light emitting layer may include the first heterocyclic compound, the second heterocyclic compound, and the third heterocyclic compound as hosts.

According to an exemplary embodiment of the present specification, the light emitting layer may include the first heterocyclic compound, the second heterocyclic compound, and the third heterocyclic compound as red hosts.

According to an exemplary embodiment of the present specification, the light emitting layer may include the first heterocyclic compound, the second heterocyclic compound, and the third heterocyclic compound as green hosts.

According to an exemplary embodiment of the present specification, the light emitting layer may include the first heterocyclic compound, the second heterocyclic compound, and the third heterocyclic compound as blue hosts.

According to an exemplary embodiment of the present specification, the first electrode may be a positive electrode, and the second electrode may be a negative electrode.

According to an exemplary embodiment of the present specification, the first electrode may be a negative electrode, and the second electrode may be a positive electrode.

According to an exemplary embodiment of the present specification, the organic light emitting device may be a blue organic light emitting device, and the first heterocyclic compound, the second heterocyclic compound, and the third heterocyclic compound may be used as materials for the blue organic light emitting device.

According to an exemplary embodiment of the present specification, the organic light emitting device may be a green organic light emitting device, and the first heterocyclic compound, the second heterocyclic compound and the third heterocyclic compound may be used as materials for the green organic light emitting device.

According to an exemplary embodiment of the present specification, the organic light emitting device may be a red organic light emitting device, and the first heterocyclic compound, the second heterocyclic compound and the third heterocyclic compound may be used as materials for the red organic light emitting device.

The organic material layer of the organic light emitting device of the present specification may also have a single-layered structure, but may have a multi-layered structure in which two or more organic material layers are stacked. For example, the organic light emitting device of the present specification may have a structure including a hole injection layer, a hole transport layer, a light emitting layer, an electron transport layer, an electron injection layer, and the like as organic material layers. However, the structure of the organic light emitting device is not limited thereto, and may include less or more numbers of organic material layers.

According to an exemplary embodiment of the present specification, the organic material layer may include an iridium-based dopant.

According to an exemplary embodiment of the present specification, as the iridium-based dopant, Ir(ppy)₃, which is a green phosphorescent dopant, may be used, but the iridium-based dopant is not limited thereto.

According to an exemplary embodiment of the present specification, as the iridium-based dopant, (piq)₂(Ir)(acac), which is a red phosphorescent dopant, may be used, but the iridium-based dopant is not limited thereto.

In the organic light emitting device of the present specification, as a positive electrode material, materials having a relatively high work function may be used, and a transparent conductive oxide, a metal or a conductive polymer, and the like may be used. Specific examples of the positive electrode material include: a metal such as vanadium, chromium, copper, zinc, and gold, or an alloy thereof; a metal oxide such as zinc oxide, indium oxide, indium tin oxide (ITO), and indium zinc oxide (IZO) ; a combination of a metal and an oxide, such as ZnO:Al or SnO₂:Sb; a conductive polymer such as poly(3-methylthiophene), poly[3,4-(ethylene-1,2-dioxy)thiophene] (PEDOT), polypyrrole, and polyaniline; and the like, but are not limited thereto.

In the organic light emitting device of the present specification, as a negative electrode material, materials having a relatively low work function may be used, and a metal, a metal oxide, or a conductive polymer, and the like may be used. Specific examples of the negative electrode material include: a metal such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

In the organic light emitting device of the present specification, as a hole injection material, a publicly-known hole injection material may also be used, and it is possible to use, for example, a phthalocyanine compound such as copper phthalocyanine disclosed in US Patent No. 4,356,429 or starburst-type amine derivatives described in the document [Advanced Material, 6, p. 677 (1994)], for example, tris(4-carbazoyl-9-ylphenyl)amine (TCTA), 4,4',4''-tri[phenyl(m-tolyl)amino]triphenylamine (m-MTDATA), 1,3,5-tris[4-(3-methylphenylphenylamino)phenyl]benzene (m-MTDAPB), polyaniline/dodecylbenzenesulfonic acid or poly(3,4-ethylenedioxythiophene)/poly(4-styrenesulfonate), which is a soluble conductive polymer, polyaniline/camphor sulfonic acid or polyaniline/poly(4-styrene-sulfonate), and the like.

In the organic light emitting device of the present specification, as a hole transport material, a pyrazoline derivative, an arylamine-based derivative, a stilbene derivative, a triphenyldiamine derivative, and the like may be used, and a low-molecular weight or polymer material may also be used.

In the organic light emitting device of the present specification, as an electron transport material, it is possible to use an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, a metal complex of 8-hydroxyquinoline and a derivative thereof, and the like, and a low-molecular weight material and a polymer material may also be used.

In the organic light emitting device of the present specification, as an electron injection material, for example, LiF is representatively used in the art, but the present specification is not limited thereto.

In the organic light emitting device of the present specification, as a light emitting material, a red, green, or blue light emitting material may be added, and if necessary, two or more light emitting materials may be mixed and used. In this case, two or more light emitting materials may be deposited or used as an individual supply source, or pre-mixed to be deposited and used as one supply source. Further, as the light emitting material, a fluorescent material may also be used, but a phosphorescent material may also be used. As the light emitting material, it is also possible to use alone a material which emits light by combining holes and electrons each injected from the positive electrode and the negative electrode, but materials in which both a host material and a dopant material are involved in light emission may also be used.

When hosts of the light emitting material are mixed and used, the same series of hosts may also be mixed and used, and different series of hosts may also be mixed and used. For example, two or more types of materials selected from N-type host materials or P-type host materials may be used as a host material for a light emitting layer.

The organic light emitting device according to an exemplary embodiment of the present specification may be a top emission type, a bottom emission type, or a dual emission type according to the material to be used.

The first heterocyclic compound, the second heterocyclic compound, and the third heterocyclic compound according to an exemplary embodiment of the present specification may act even in organic electronic devices including organic solar cells, organic photoconductors, organic transistors, and the like, based on the principle similar to those applied to organic light emitting devices.

The organic light emitting device of the present specification may further include one or two or more layers selected from the group consisting of a light emitting layer, a hole injection layer, a hole transport layer, a hole transport auxiliary layer, an electron injection layer, an electron transport layer, an electron blocking layer, and a hole blocking layer.

FIGS. 1 to 3 exemplify the stacking sequence of the electrodes and the organic material layer of the organic light emitting device according to an exemplary embodiment of the present specification. However, the scope of the present application is not intended to be limited by these drawings, and the structure of the organic light emitting device known in the art may also be applied to the present application.

According to FIG. 1, an organic light emitting device in which a positive electrode 200, an organic material layer 300, and a negative electrode 400 are sequentially stacked on a substrate 100 is illustrated. However, the organic light emitting device is not limited only to such a structure, and as illustrated in FIG. 2, an organic light emitting device in which a negative electrode, an organic material layer, and a positive electrode are sequentially stacked on a substrate may also be implemented. The first heterocyclic compound, the second heterocyclic compound and the third heterocyclic compound may be included in the organic material layer 300, and the organic material layer 300 may be one or more layers.

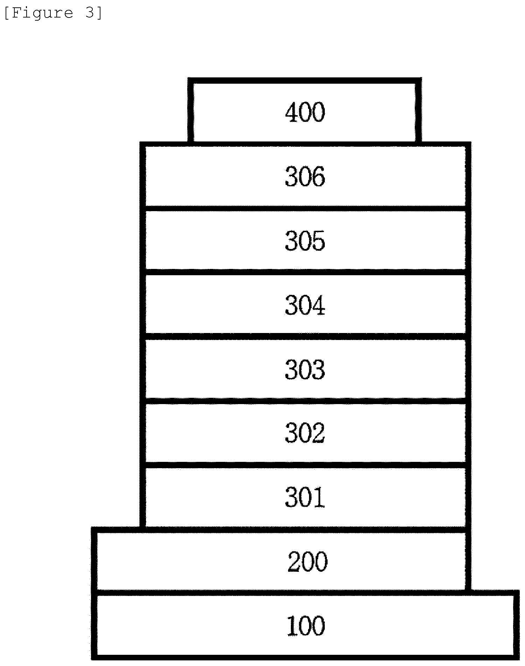

FIG. 3 exemplifies a case where an organic material layer is a multilayer. The organic light emitting device according to FIG. 3 includes a hole injection layer 301, a hole transport layer 302, a light emitting layer 303, a hole blocking layer 304, an electron transport layer 305, and an electron injection layer 306. The composition for an organic light emitting device (including the first to third heterocyclic compounds) may be included in the light emitting layer 303. However, the scope of the present application is not limited by the stacking structure as described above, and if necessary, the other layers except for the light emitting layer may be omitted, and another necessary functional layer may be further added.

The scope of the present application is not limited by the stacking structure as described above, and if necessary, the other layers except for the hole transport layer and/or the electron blocking layer may be omitted, and another necessary functional layer may be further added.

The organic light emitting device according to an exemplary embodiment of the present specification includes a first electrode; a first stack provided on the first electrode and including a first light emitting layer; a charge generation layer provided on the first stack; a second stack provided on the charge generation layer and including a second light emitting layer; and a second electrode provided on the second stack.

Furthermore, the first stack and the second stack may each independently further include one or more of the above-described hole injection layer, hole transport layer, light emitting layer, hole blocking layer, electron transport layer, electron injection layer, and the like.

The first heterocyclic compound, the second heterocyclic compound, and the third heterocyclic compound may be used in forming an organic material layer of an organic light emitting device, and particularly, may also be more preferably used as an electron blocking or hole transport material.

If necessary, when a different type of compound other than the first heterocyclic compound, the second heterocyclic compound, and the third heterocyclic compound is mixed to form a mixture, the mixture may be in a premixed form, and a powder-state material may be mixed before forming the organic material layer of the organic light emitting device, and a compound that is in a liquid state at or above a suitable temperature may be mixed. The compound is in a solid state at a temperature which is equal to or less than the melting point of each material, and may be maintained as a liquid phase when the temperature is adjusted.

The first heterocyclic compound, the second heterocyclic compound, and the third heterocyclic compound may further include materials publicly-known in the art, such as solvents and additives.

### <Composition for organic material layer of organic light emitting device>

Hereinafter, the composition for an organic material layer of an organic light emitting device according to the present specification will be described.

The composition for an organic material layer of an organic light emitting device according to an exemplary embodiment of the present specification is characterized in that the composition includes a first heterocyclic compound, a second heterocyclic compound, and a third heterocyclic compound, the first heterocyclic compound is represented by Chemical Formula A, and the second heterocyclic compound and the third heterocyclic compound are different from each other, and are represented by Chemical Formula C.

In an exemplary embodiment of the present specification, the weight ratio of the first heterocyclic compound : the second heterocyclic compound : the third heterocyclic compound may be 0.1 to 3 : 0.1 to 2 : 0.1 to 2.

In an exemplary embodiment of the present specification, the weight ratio of the first heterocyclic compound : the second heterocyclic compound : the third heterocyclic compound may be 1 to 3 : 1 to 2 : 1 to 2.

In addition, the composition for an organic material layer including the first heterocyclic compound of Chemical Formula A and the second and third heterocyclic compounds of Chemical Formula C, which are different from each other, provides excellent thermal stability when used in an organic light emitting device, and such thermal stability may provide driving stability to organic light emitting devices in the future as well as improve service life characteristics.

### <Method for manufacturing organic light emitting device>

In an exemplary embodiment of the present specification, provided is a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using an organic material layer composition of the above-described organic light emitting device.

According to an exemplary embodiment of the present specification, the forming of the organic material layer may form the organic material layer using a thermal vacuum deposition method from an organic material layer composition of the organic light emitting device.

According to an exemplary embodiment of the present specification, the forming of the organic material layer may form the organic material layer by pre-mixing the first heterocyclic compound, the second heterocyclic compound, and the third heterocyclic compound and using a thermal vacuum deposition method.

The organic light emitting device according to an exemplary embodiment of the present specification may be manufactured by typical manufacturing methods and materials of the organic light emitting device, except that the above-described heterocyclic compound is used to form an organic material layer.

Specifically, for a method of forming an organic material layer, an organic material layer may be formed by not only a vacuum deposition method, but also a solution application method when the organic light emitting device is manufactured. Herein, the solution coating method means spin coating, dip coating, inkjet printing, screen printing, a spray method, roll coating, and the like, but is not limited thereto.

Hereinafter, the present specification will be described in more detail through Examples, but these Examples are provided only for exemplifying the present application, and are not intended to limit the scope of the present application.

### Preparation Examples.

### [Preparation Example 1] Preparation of Compound A26

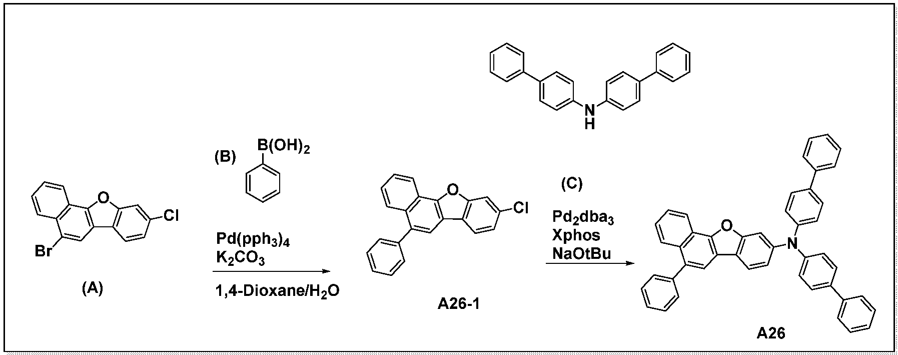

### 1) Preparation of Intermediate A26-1

After 30.0 g (90.5 mmol) of **(A)** 5-bromo-9-chloronaphtho[1,2-b]benzofuran, 12.1 g (99.6 mmol) of **(B)** phenylboronic acid, 5.2 g (4.5 mmol) of Pd(pph₃)₄, and 25.0 g (181.0 mmol) of K₂CO₃ were dissolved in 1,4-dioxane/H₂O (300 ml/60 ml) in a 1 L two-neck flask, the resulting solution was refluxed for 1 hour. The reaction product was purified by recrystallization with methanol, and 24.8 g (yield 83.3%) of Compound **A26-1** was obtained.

### 2) Preparation of Compound A26

After 10.0 g (30.4 mmol) of Compound A26-1, 11.3 g (30.4 mmol) of **(C)** di([1,1'-biphenyl]-4-yl)amine, 1.4 g (1.5 mmol) of Pd₂dba₃, 1.4 g (3.0 mmol) of Xphos, and 5.8 g (60.8 mmol) of NaOtBu were put into a 500 ml two-neck flask and dissolved in toluene (150 ml), the resulting solution was refluxed for 1 hour. The reaction product was purified by recrystallization with methanol, and 17.6 g (yield 87%) of Target Compound **A26** was obtained.

The following compound was synthesized in the same manner as in the preparation of Compound A26, except that (A), (B), and (C) in the following Table 1 were used as intermediates instead of (A), (B), and (C) in Preparation Example 1.

**[Table 1]**

| **Compound** | **(A)** | **(B)** | **(C)** | **Yield** |
|---|---|---|---|---|
| **A1** | 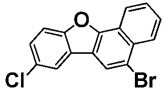 | 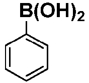 | 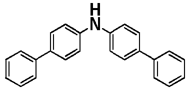 | 78% |
| **A3** | 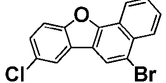 | 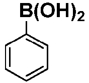 | 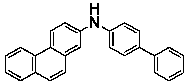 | 77% |
| **A16** | 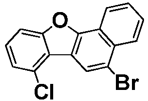 | 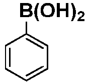 | 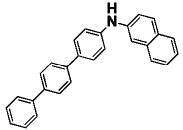 | 79% |
| **A21** | 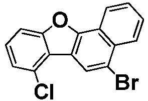 | 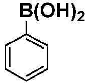 | 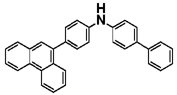 | 72% |
| **A26** | 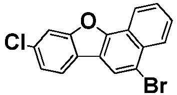 | 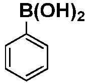 | 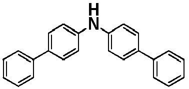 | 87% |
| **A41** | 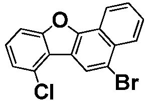 | 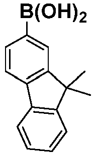 | 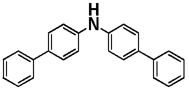 | 82% |
| **A42** | 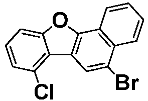 | 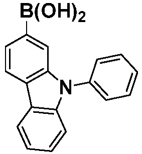 | 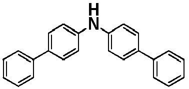 | 80% |
| **A50** | 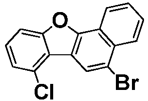 | 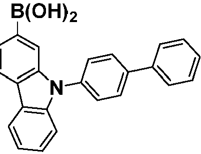 | 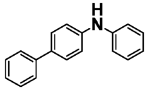 | 77% |
| **A61** | 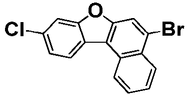 | 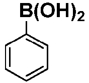 | 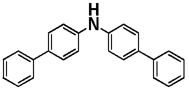 | 76% |
| **A66** | 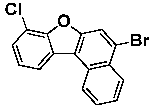 | 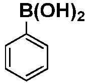 | 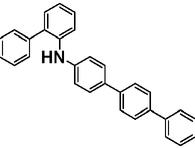 | 72% |
| **A94** | 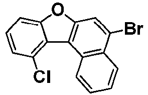 | 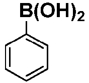 | 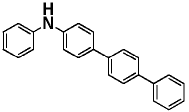 | 73% |
| **A101** | 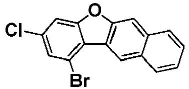 | 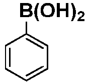 | 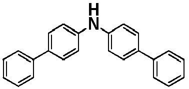 | 75% |
| **A119** | 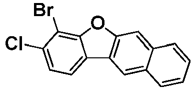 | 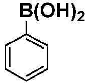 | 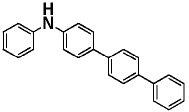 | 72% |
| **A122** | 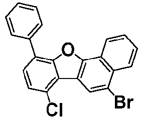 | 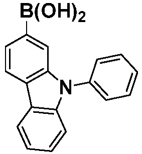 | 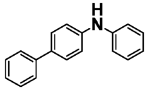 | 68% |
| **A127** | 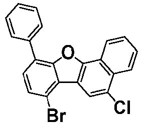 | 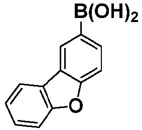 | 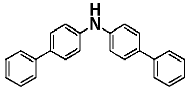 | 71% |
| **A136** | 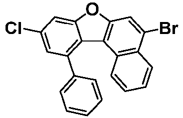 | 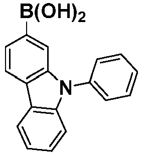 | 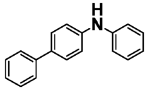 | 64% |
| **A138** | 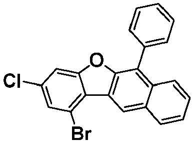 | 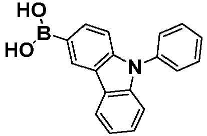 | 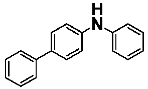 | 67% |
| **A157** | 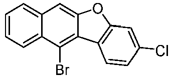 | 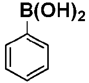 | 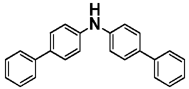 | 78% |
| **A158** | 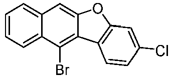 | 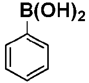 | 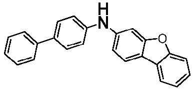 | 70% |
| **A159** | 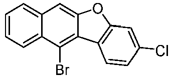 | 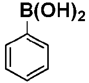 | 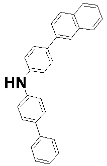 | 77% |
| **A181** | 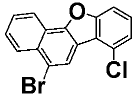 | 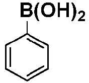 | 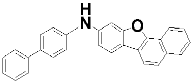 | 80% |
| **A222** | 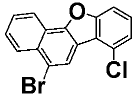 | 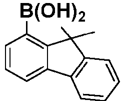 | 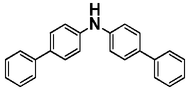 | 82% |
| **A278** | 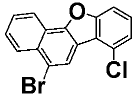 | 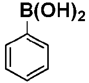 | 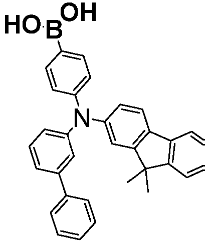 | 68% |
| **A296** | 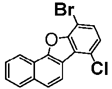 | 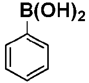 | 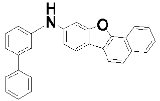 | 73% |
| **A298** | 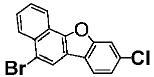 | 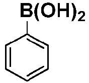 | 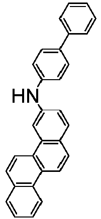 | 76% |

### [Preparation Example 2] Preparation of Compound A20

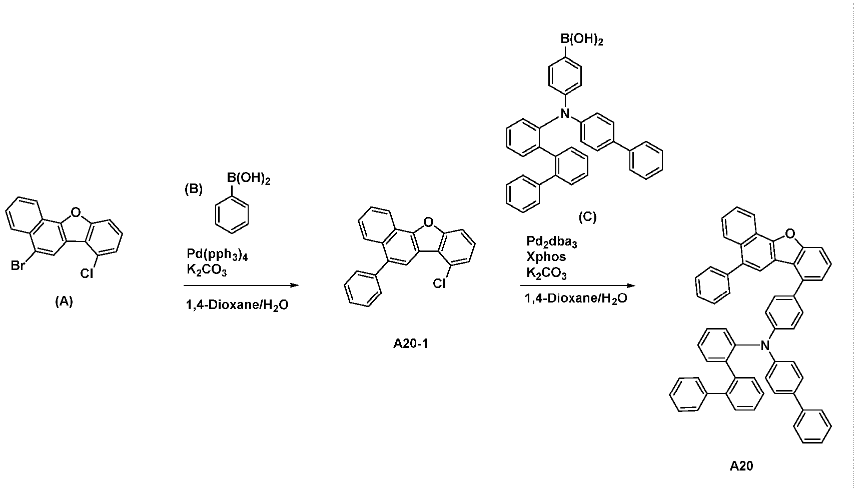

### 1) Preparation of Intermediate A20-1

After 30.0 g (90.5 mmol) of **(A)** 5-bromo-7-chloronaphtho[1,2-b]benzofuran, 12.1 g (99.6 mmol) of **(B)** phenylboronic acid, 5.2 g (4.5 mmol) of Pd(pph₃)₄, and 25.0 g (181.0 mmol) of K₂CO₃ were dissolved in 1,4-dioxane/H₂O (300 ml/60 ml) in a 1 L two-neck flask, the resulting solution was refluxed for 1 hour. The reaction product was purified by recrystallization with methanol, and 24.8 g (yield 83.3%) of Compound **A20-1** was obtained.

### 2) Preparation of Compound A20

After 10.0 g (30.4 mmol) of Compound A20-1, 15.7 g (30.4 mmol) of **(C)** (4-([1,1'-biphenyl]-4-yl([1,1':2',1"-terphenyl]-2-yl)amino)phenyl)boronic acid, 1.4 g (1.5 mmol) of Pd₂dba₃, 1.4 g (3.0 mmol) of Xphos and 8.4 g (60.8 mmol) of K₂CO₃ were dissolved in 1,4-dioxane/H₂O (100 ml/20 ml) in a 250 ml two-neck flask, the resulting solution was refluxed for 1 hour. The reaction product was purified by recrystallization with methanol, and 19.8 g (yield 85%) of Target Compound **A20** was obtained.

The following compound was synthesized in the same manner as in the preparation of Compound A20, except that (A), (B), and (C) in the following Table 2 were used as intermediates instead of (A), (B), and (C) in Preparation Example 2.

**[Table 2]**

| **Compound** | **(A)** | **(B)** | **(C)** | **Yield** |
|---|---|---|---|---|
| **A4** | 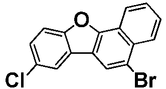 | 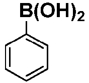 | 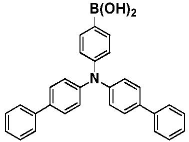 | 78% |
| **A7** | 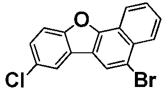 | 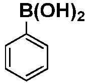 | 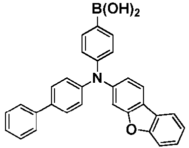 | 77% |
| **A12** | 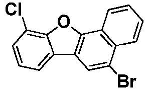 | 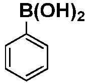 | 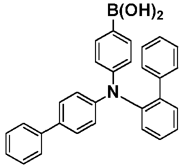 | 72% |
| **A17** | 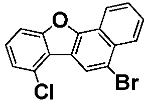 | 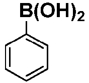 | 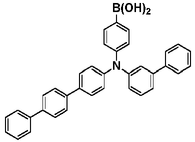 | 73% |
| **A20** | 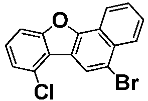 | 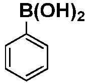 | 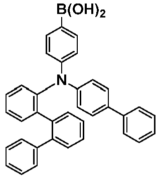 | 85% |
| **A24** | 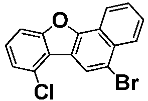 | 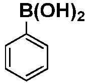 | 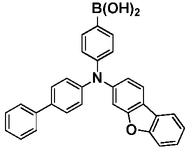 | 73% |
| **A37** | 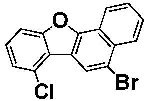 | 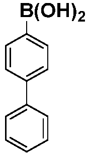 | 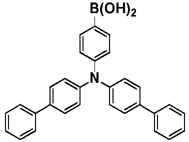 | 82% |
| **A39** | 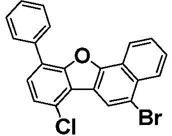 | 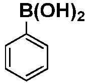 | 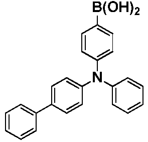 | 72% |
| **A48** | 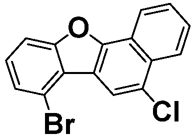 | 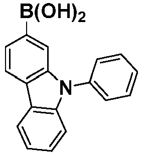 | 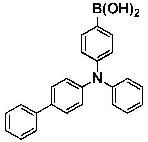 | 70% |
| **A59** | 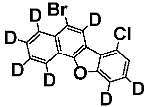 | 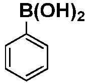 | 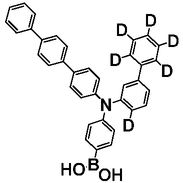 | 85% |
| **A76** | 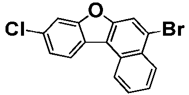 | 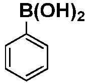 | 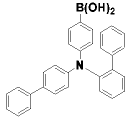 | 88% |
| **A89** | 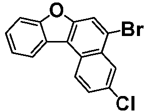 | 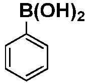 | 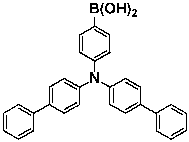 | 68% |
| **A98** | 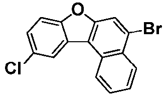 | 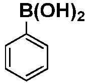 | 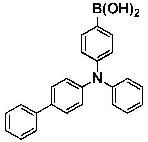 | 77% |
| **A106** | 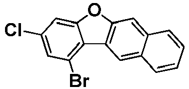 | 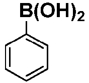 | 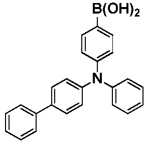 | 73% |
| **A126** | 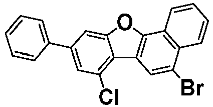 | 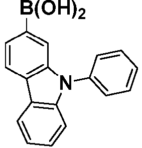 | 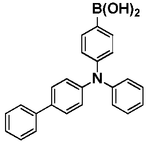 | 66% |
| **A128** | 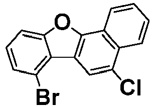 | 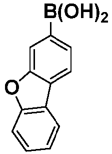 | 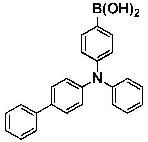 | 69% |

### [Preparation Example 3] Preparation of Compound C24

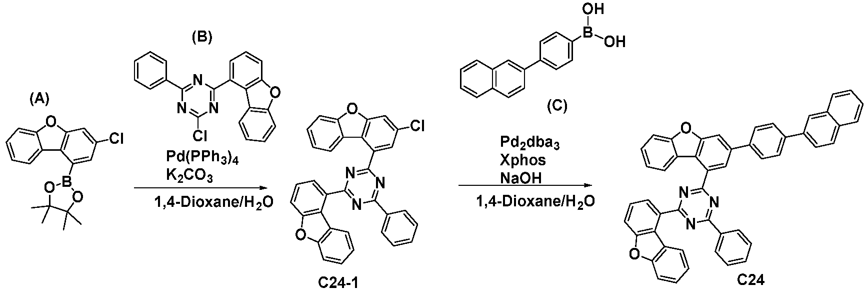

### 1) Preparation of Intermediate C24-1

**(A)** 2-(3-chlorodibenzo[b,d]furan-1-yl)-4,4,5,5-tetramethyl-1,3,2-dioxaborolane (8 g, 24.35 mmol), **(B)** 2-chloro-4-(dibenzo[b,d]furan-1-yl)-6-phenyl-1,3,5-triazine (8.62 g, 23.86 mmol), Pd(PPh₃)₄ (1.41 g, 1.22 mmol), and K₂CO₃ (7.74 g, 73.04 mmol) were put into 1.4-dioxane/H₂O (80 mL/16 mL), and the resulting mixture was stirred at 110°C for 2 hours. After the mixture was cooled to room temperature, the resulting solid was filtered to obtain Intermediate **C24-1** (11 g, 86.23%).

### 2) Preparation of Compound C24

After Intermediate C24-1 (11.0 g, 20.9 mmol), **(C)** (4-(naphthalen-2-yl)phenyl)boronic acid (6.25 g, 25.19 mmol), pd₂dba₃ (0.6 g, 1.15 mmol), Xphos (1.0 g, 2.1 mmol), and NaOH (2.52 g, 62.98 mmol) were put into 1.4-dioxane/H₂O (110 mL/22 mL), the resulting mixture was stirred at 120°C for 2 hours. After the mixture was cooled to room temperature, the resulting solid was filtered. The filtered solid was purified with silica gel to obtain Compound **C24** (12 g, 83%).

The following compound was synthesized in the same manner as in the preparation of Compound C24, except that (A), (B), and (C) in the following Table 3 were used as intermediates instead of (A), (B), and (C) in Preparation Example 3. The portions marked with '-' for reference are those in which (C) is not introduced, and the corresponding portion of the target compound is hydrogen.

**[Table 3]**

| **Compound** | **(A)** | **(B)** | **(C)** | **Yield** |
|---|---|---|---|---|
| **C7** | 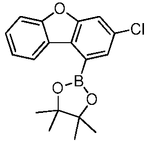 | 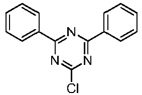 | 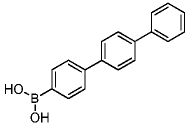 | 79% |
| **C15** | 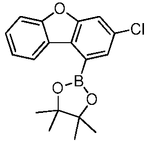 | 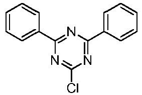 | 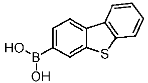 | 67% |
| **C17** | 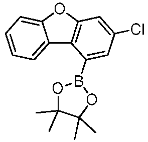 | 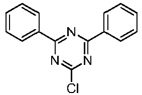 | 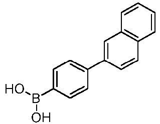 | 81% |
| **C18** | 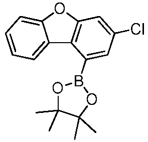 | 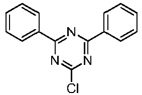 | 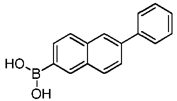 | 82% |
| **C24** | 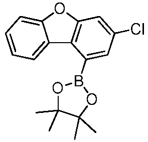 | 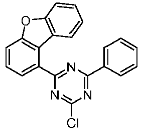 | 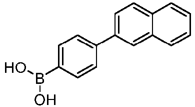 | 83% |
| **C40** | 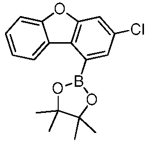 | 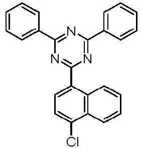 | 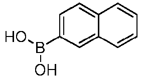 | 80% |
| **C51** | 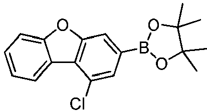 | 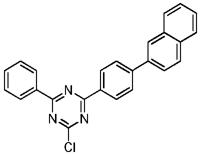 | 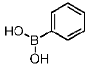 | 84% |
| **C52** | 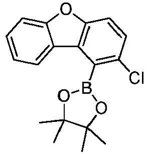 | 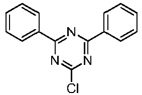 | 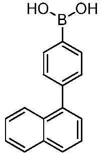 | 71% |
| **C54** | 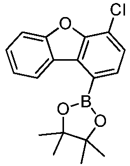 | 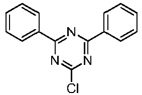 | 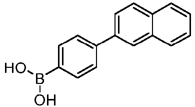 | 86% |
| **C55** | 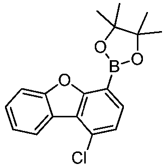 | 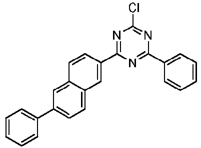 | 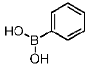 | 82% |
| **C73** | 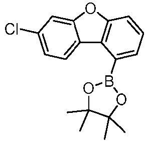 | 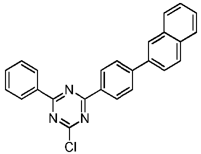 | 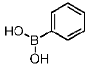 | 85% |
| **C80** | 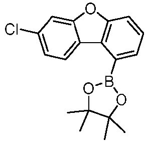 | 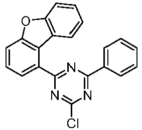 | 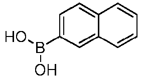 | 84% |
| **C92** | 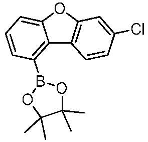 | 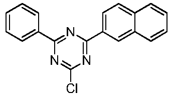 | 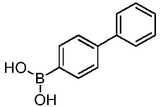 | 82% |
| **C99** | 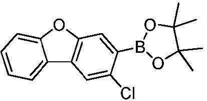 | 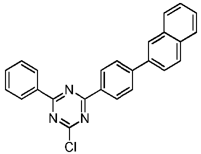 | 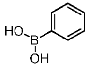 | 72% |
| **C100** | 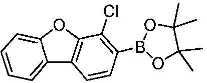 | 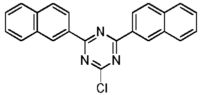 | 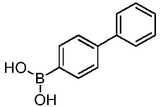 | 75% |
| **C107** | 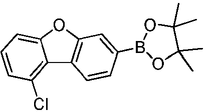 | 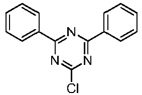 | 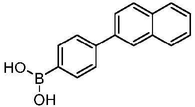 | 82% |
| **C119** | 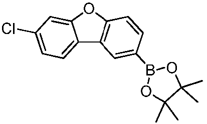 | 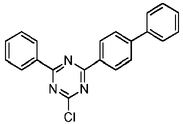 | 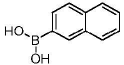 | 85% |
| **C122** | 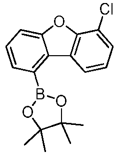 | 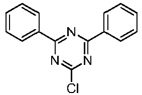 | 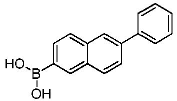 | 84% |
| **C131** | 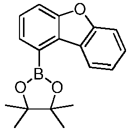 | 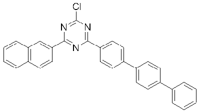 | - | 89% |
| **C134** | 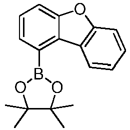 | 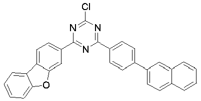 | - | 92% |
| **C143** | 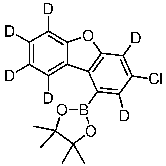 | 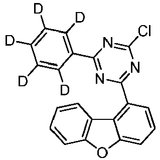 | 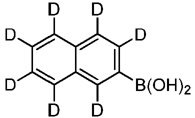 | 78% |
| **C145** | 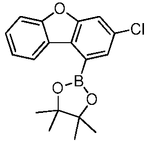 | 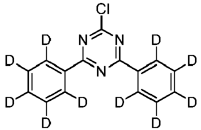 | 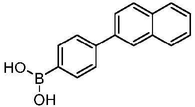 | 77% |
| **C165** | 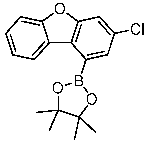 | 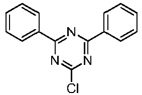 | 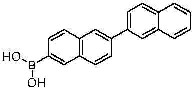 | 70% |
| **C167** | 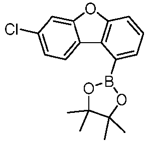 | 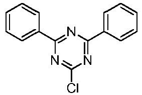 | 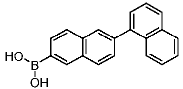 | 68% |
| **C203** | 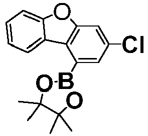 | 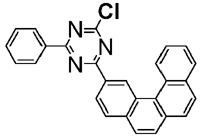 | 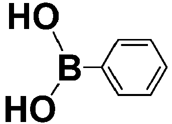 | 79% |
| **C205** | 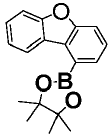 | 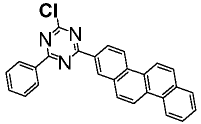 | - | 67% |
| **C210** | 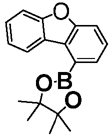 | 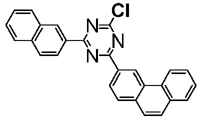 | - | 70% |
| **C217** | 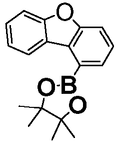 | 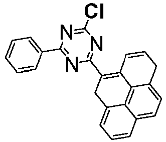 | - | 68% |
| **C245** | 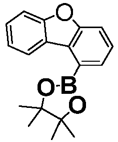 | 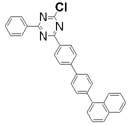 | - | 71% |
| **C290** | 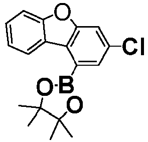 | 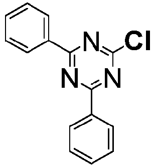 | 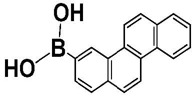 | 73% |
| **C312** | 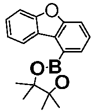 | 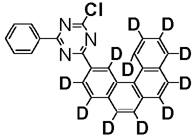 | - | 75% |
| **C320** | 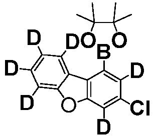 | 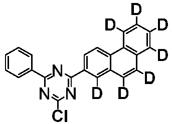 | 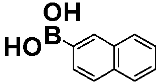 | 79% |
| **C328** | 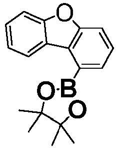 | 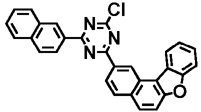 | - | 77% |
| **C357** | 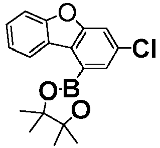 | 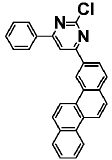 | 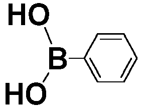 | 70% |
| **C379** | 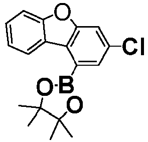 | 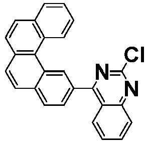 | 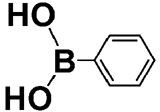 | 80% |
| **C404** | 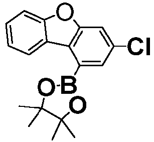 | 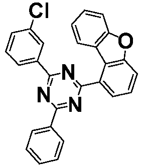 | 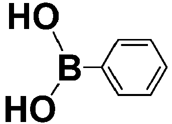 | 79% |
| **C446** | 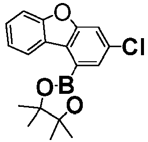 | 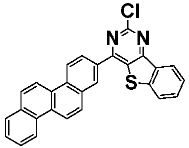 | 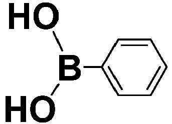 | 82% |

Compounds were prepared in the same manner as in the Preparation Examples, and the synthesis confirmation results thereof are each shown in the following Tables 4 and 5. The following Table 4 shows the measured values of ¹H NMR (CDCl₃, 400 Mz), and the following Table 5 shows the measured values of field desorption mass spectrometry (FD-MS).

**[Table 4]**

| **Compound No.** | **¹H NMR (CDCl₃, 400MHz)** |
|---|---|
| **A1** | δ = 8.55 (1H, s), 8.18 (1H, d), 7.79 (2H, d), 7.71 (1H, d), 7.65 (1H, d), 7.55 (2H, d), 7.54 (4H, d), 7.52 (4H, d), 7.51 (6H, d), 7.41 (4H, dd), 6.69 (4H, d), 6.39 (1H, d) |
| **A3** | δ = 8.93 (1H, s), 8.68 (1H, d), 8.55 (1H, d), 8.18 (1H, d), 8.12 (1H, d), 7.88 (1H, d), 7.82 (1H, d), 7.79 (2H, d), 7.71 (3H, d), 7.65 (1H, dd), 7.55 (2H, d), 7.54 (2H, d), 7.52 (2H, dd), 7.51 (4H, dd), 7.41 (3H, s), 7.32 (1H, t), 7.08 (1H, t), 6.69 (2H, dd), 6.39 (1H, dd) |
| **A4** | δ = 8.55 (1H, s), 8.18 (1H, d), 7.81 (1H, d), 7.79 (2H, d), 7.72 (1H, d), 7.71 (2H, d), 7.55 (2H, d), 7.54 (6H, d), 7.52 (4H, d), 7.51 (6H, dd), 7.41 (3H, d), 6.69 (6H, d) |
| **A7** | δ = 8.55 (1H, s), 8.18 (1H, d), 7.89 (1H, d), 7.81 (1H, d), 7.79 (2H, d), 7.72 (1H, d), 7.71 (2H, d), 7.66 (1H, d), 7.64 (1H, d), 7.55 (2H, dd), 7.54 (4H, d), 7.52 (2H, d), 7.51 (4H, dd), 7.43 (1H, dd), 7.41 (2H, s), 7.38 (1H, t), 7.32 (1H, t), 6.69 (4H, dd), 6.33 (1H, dd) |
| **A12** | δ =8.55 (1H, s), 8.18 (1H, d), 7.85 (1H, d), 7.81 (1H, d), 7.79 (2H, d), 7.71 (1H, d), 7.55 (2H, d), 7.54 (5H, d), 7.52 (2H, d), 7.51 (6H, dd), 7.41 (3H, d), 7.38 (1H, d), 7.16 (1H, dd), 7.08 (2H, dd), 6.87 (1H, s), 6.69 (5H, t) |
| **A16** | δ = 8.55 (1H, s), 8.18 (1H, d), 7.88 (1H, d), 7.84 (1H, d), 7.79 (2H, d), 7.77 (1H, d), 7.74 (1H, d), 7.71 (1H, d), 7.55 (2H, d), 7.54 (2H, dd), 7.52 (2H, d), 7.51 (4H, d), 7.5 (1H, dd), 7.49 (1H, dd), 7.41 (2H, s), 7.36 (1H, t), 7.25 (4H, t), 7.13 (1H, dd), 7.02 (1H, dd), 6.69 (2H, t), 6.33 (1H, d) |
| **A17** | δ = 8.55 (1H, s), 8.18 (1H, d), 7.79 (2H, d), 7.75 (1H, d), 7.71 (1H, d), 7.62 (1H, d), 7.55 (2H, d), 7.54 (4H, d), 7.52 (4H, d), 7.51 (6H, dd), 7.44 (2H, d), 7.41 (3H, d), 7.25 (4H, dd), 6.89 (1H, dd), 6.88 (1H, s), 6.69 (4H, t), 6.59 (1H, t) |
| **A20** | δ = 8.97 (1H, d), 8.25 (2H, d), 8.10 (1H, d), 7.79 (3H, d), 7.75 (2H, d), 7.64 (1H, t), 7.63 (2H, m), 7.57 (1H, d), 7.55 (2H, d), 7.49 (2H, t), 7.48 (1H, t), 7.47 (1H, t), 7.46 (1H, t), 7.41 (3H, t), 7.34 (1H, 5), 7.27 (4H, d), 7.14 (1H, t) |
| **A21** | δ = 8.93 (2H, s), 8.55 (1H, d), 8.18 (1H, d), 8.12 (2H, d), 7.93 (1H, d), 7.88 (2H, d), 7.82 (2H, d), 7.79 (2H, d), 7.71 (1H, d), 7.55 (2H, dd), 7.54 (4H, d), 7.52 (2H, d), 7.51 (4H, dd), 7.41 (2H, dd), 7.13 (1H, s), 7.02 (1H, t), 6.69 (4H, t), 6.33 (1H, dd) |
| **A24** | δ = 8.55 (1H, s), 8.18 (1H, d), 7.89 (1H, d), 7.79 (2H, d), 7.75 (1H, d), 7.71 (1H, d), 7.66 (1H, d), 7.64 (1H, d), 7.62 (1H, d), 7.55 (2H, dd), 7.54 (4H, d), 7.52 (2H, d), 7.51 (4H, dd), 7.44 (1H, dd), 7.43 (1H, s), 7.41 (2H, t), 7.38 (1H, t), 7.32 (1H, dd), 6.69 (4H, dd), 6.33 (1H, t) |
| **A26** | δ = 8.55 (1H, s), 8.18 (1H, d), 7.79 (2H, d), 7.71 (1H, d), 7.64 (1H, d), 7.55 (2H, d), 7.54 (4H, d), 7.52 (4H, d), 7.51 (6H, d), 7.43 (1H, dd), 7.41 (3H, d), 6.69 (4H, d), 6.33 (1H, dd) |
| **A41** | δ = 8.97 (1H, d), 8.18 (1H, d), 8.09 (1H, d), 7.89 (1H, s), 7.78 (1H, d), 7.75 (4H, d), 7.64 (1H, t), 7.55 (4H, d), 7.49 (4H, t), 7.48 (1H, t), 7.41 (2H, t), 7.28 (1H, t), 7.27 (4H, d), 7.24 (1H, t), 7.16 (1H, d), 6.91 (1H, d), 1.69 (6H, d) |
| **A50** | δ = 8.97 (1H, d),8.20 (2H, d), 8.19 (2H, d), 8.18 (1H, d), 7.92 (2H, d), 7.79 (1H, d), 7.75 (4H, d), 7.74 (1H, s), 7.64 (1H, t), 7.55 (2H, d), 7.49 (4H, d), 7.48 (1H, t), 7.41 (2H, t), 7.40 (1H, d), 7.38 (1H, s), 7.27 (2H, d), 7.24 (3H, t), 7.18 (1H, t), 7.16 (1H, d), 7.08 (2H, d), 7.00 (1H, t) |
| **A61** | δ = 8.55 (2H, s), 7.79 (2H, d), 7.64 (2H, d), 7.55 (2H, d), 7.54 (4H, d), 7.52 (4H, d), 7.51 (6H, d), 7.43 (1H, d), 7.41 (3H, d), 6.69 (4H, dd), 6.33 (1H, d) |
| **A66** | δ = 8.55 (2H, s), 7.79 (2H, d), 7.64 (1H, d), 7.55 (2H, d), 7.54 (2H, d), 7.52 (2H, d), 7.51 (4H, d), 7.41 (2H, d), 7.25 (5H, d), 7.2 (2H, dd), 7.07 (1H, d), 6.81 (1H, d), 6.69 (2H, dd), 6.63 (2H, dd), 6.39 (1H, s) |
| **A76** | δ = 8.97 (2H, d), 8.10 (1H, d), 7.79 (2H, d), 7.78 (1H, d), 7.76 (1H, s), 7.75 (2H, d), 7.57 (1H, d), 7.55 (4H, d), 7.48 (2H, t), 7.46 (2H, t), 7.43 (2H, t), 7.41 (3H, t), 7.34 (1H, t), 7.31 (1H, s), 7.27 (5H, d), 7.14 (1H, t), 7.08 (1H, d) |
| **A89** | δ = 8.09 (1H, d), 8.04 (1H, s), 7.79 (2H, d), 7.75 (4H, d), 7.55 (6H, d), 7.54 (1H, d), 7.49 (4H, t), 7.48 (1H, d), 7.46 (2H, t), 7.41 (3H, t), 7.39 (1H, t), 7.31 (1H, t), 7.30 (1H, s), 7.27 (4H, d) |
| **A94** | δ = 8.55 (2H, s), 7.79 (2H, d), 7.64 (1H, d), 7.55 (2H, d), 7.54 (2H, d), 7.52 (2H, d), 7.51 (4H, d), 7.41 (2H, d), 7.25 (4H, d), 7.2 (2H, dd), 7.13 (1H, d), 7.02 (1H, d), 6.81 (1H, dd), 6.69 (2H, dd), 6.63 (2H, s), 6.33 (1H, t) |
| **A98** | δ = 8.55 (2H, s), 7.81 (1H, d), 7.79 (2H, d), 7.72 (1H, d), 7.71 (1H, d), 7.64 (1H, d), 7.55 (2H, d), 7.54 (4H, d), 7.52 (2H, d), 7.51 (4H, dd), 7.41 (2H, d), 7.2 (2H, d), 6.81 (1H, dd), 6.69 (4H, dd), 6.63 (2H, s) |
| **A101** | δ = 8.16 (2H, s), 7.79 (2H, d), 7.67 (2H, d), 7.54 (4H, d), 7.52 (4H, d), 7.51 (7H, d), 7.49 (1H, d), 7.42 (1H, d), 7.41 (3H, d), 7.39 (1H, dd), 6.69 (4H, d) |
| **A106** | δ = 8.16 (2H, s), 7.79 (2H, d), 7.67 (2H, d), 7.6 (1H, d), 7.57 (1H, d), 7.54 (4H, d), 7.52 (2H, d), 7.51 (4H, d), 7.49 (1H, d), 7.42 (1H, dd), 7.41 (2H, d), 7.2 (2H, d), 6.81 (1H, dd), 6.69 (4H, dd), 6.63 (2H, s) |
| **A119** | δ = 8.16 (2H, s), 7.67 (2H, d), 7.6 (1H, d), 7.54 (2H, d), 7.52 (4H, d), 7.51 (4H, d), 7.49 (1H, d), 7.42 (1H, d), 7.41 (2H, d), 7.25 (4H, dd), 7.2 (2H, d), 6.81 (1H, d), 6.69 (2H, dd), 6.63 (2H, dd), 6.39 (1H, s) |
| **A126** | c 8.19 (2H, d), 8.18 (1H, d), 7.86 (1H, s), 7.79 (1H, d), 7.75 (4H, d), 7.74 (1H, s), 7.64 (1H, t), 7.62 (2H, t), 7.58 (1H, t), 7.55 (2H, d), 7.52 (1H, s), 7.49 (4H, t), 7.41 (2H, t) 7.27 (4H, d), 7.24 (2H, t), 7.20 (1H, t), 7.18 (1H, t), 7.08 (2H, d), 7.00 (1H, t) |
| **A127** | δ = 8.22 (1H, s), 8.18 (1H, d), 8.12 (1H, d), 7.82 (1H, d), 7.76 (1H, d), 7.75 (4H, d), 7.69 (1H, d), 7.64 (1H, t), 7.55 (4H, d), 7.49 (4H, t), 7.46 (2H, t), 7.41 (3H, t), 7.39 (1H, t), 7.27 (4H, d) |
| **A128** | δ = 8.97 (1H, d), 8.18 (1H, d), 7.98 (1H, d), 7.78 (1H, d), 7.76 (1H, s), 7.75 (2H, d), 7.64 (1H, t), 7.60 (1H, d), 7.57 (1H, d), 7.55 (4H, d), 7.54 (1H, d), 7.49 (2H, t), 7.48 (1H, t), 7.47 (1H, t), 7.41 (1H, t), 7.39 (1H, t), 7.27(2H, d), 7.24 (2H, t), 7.08 (2H, d), 7.00 (1H, t) |
| **A136** | δ = 8.97 (2H, d), 8.20 (1H, s), 8.19 (2H, d), 8.13 (1H, s), 7.79 (3H, t), 7.75 (2H, d), 7.74 (1H, s), 7.62 (2H, t), 7.58 (1H, t), 7.55 (2H, d), 7.50 (2H, d), 7.49 (2H, t), 7.41 (2H, t), 7.40 (1H, d), 7.08 (2H, d), 7.00 (1H, s) |
| **A138** | δ = 8.97 (1H, d), 8.55 (1H, d), 8.20 (1H, s), 7.89 (1H, s), 7.84 (1H, d), 7.75 (2H, d), 7.62 (2H, t), 7.59(1H, d), 7.55 (2H, d), 7.51 (2H, d), 7.50 (2H, d), 7.49 (2H, t), 7.48 (2H, t), 7.46 (2H, t), 7.41 (2H, t), 7.27 (2H, d), 7.24 (2H, t), 7.16 (1H, t), 7.11 (1H, t), 7.08 (2H, d), 7.00 (1H, t) |
| **A157** | δ = 8.97(1H, s), 8.03(1H, d), 7.84(1H, d), 7.75(4H, d), 7.65(2H, d), 7.55(7H, d), 7.49(4H, d), 7.48(2H, d), 7.41(3H, d), 7.36(1H, dd), 7.27(4H, d), 6.91(1H, d) |
| **A158** | δ = 8.97(1H, s), 8.03(2H, d), 7.98(1H, d), 7.84(1H, d), 7.75(2H, d), 7.65(2H, d), 7.55(6H, d), 7.54(1H, d), 7.49(2H, d), 7.48(2H, dd), 7.41(2H, d), 7.39(1H, d), 7.36(1H, dd), 7.31(1H, dd), 7.27(2H, s), 6.91 (2H, t) |
| **A159** | δ = 8.97(1H, s), 8.09(1H, d), 8.06(1H, d), 8.03(1H, d), 7.99(1H, d), 7.84(1H, d), 7.75(2H, d), 7.65(2H, d), 7.63(1H, d), 7.58(1H, dd), 7.55(8H, d), 7.49(2H, d), 7.48(2H, dd), 7.38(1H, dd), 7.36(1H, s), 7.27 (4H, t), 6.91 (1H, t) |
| **A181** | δ = 8.97(1H, s), 8.19(1H, d), 8.18(1H, d), 8.03(1H, d), 7.84(1H, d), 7.79(2H, d), 7.75(2H, d), 7.64(1H, d), 7.59(1H, d), 7.55(3H, dd), 7.49(2H, d), 7.48(3H, d), 7.46(2H, dd), 7.41(2H, dd), 7.38(1H, s), 7.27 (2H, t), 7.24 (1H, t), 7.23 (1H, dd), 7.16 (1H, dd), 6.91 (2H, t) |
| **A222** | δ = 8.97(1H, s), 8.18(1H, d), 8(1H, d), 7.9(1H, d), 7.75(4H, d), 7.68(1H, d), 7.64(1H, d), 7.57(1H, d), 7.55(5H, d), 7.49(4H, dd), 7.48(1H, d), 7.38(2H, d), 7.28(1H, dd), 7.27(4H, dd), 7.24(1H, s), 7.16 (1H, t), 6.91 (1H, t) |
| **A278** | δ = 8.97(1H, s), 8.18(1H, d), 7.9(1H, d), 7.86(1H, d), 7.79(2H, d), 7.75(2H, d), 7.64(1H, d), 7.6(1H, d), 7.57(1H, d), 7.55(4H, dd), 7.49(2H, d), 7.48(1H, d), 7.47(1H, dd), 7.46(2H, dd), 7.38(2H, s), 7.33 (1H, t), 7.28 (1H, t), 7.27 (3H, dd), 7.18 (1H, dd), 7.17 (1H, t), 7.16 (1H, d) |
| **A296** | δ = 8.19(2H, s), 8.03(1H, d), 7.84(2H, d), 7.75(2H, d), 7.59(3H, d), 7.55(2H, d), 7.51(2H, d), 7.49(2H, d), 7.48(4H, d), 7.46(2H, dd), 7.41(2H, d), 7.27(1H, d), 7.23(2H, dd), 7.18(1H, dd), 7.17(1H, s), 7.1 (1H, t), 6.91 (1H, t) |
| **A298** | δ = 8.97(1H, s), 8.92(1H, d), 8.84(1H, d), 8.71(1H, d), 8.18(1H, d), 8.09(1H, d), 8.07(1H, d), 8.03(1H, d), 7.92(1H, d), 7.9(1H, dd), 7.79(2H, d), 7.75(2H, d), 7.7(1H, dd), 7.68(1H, dd), 7.64(1H, s), 7.63 (1H, t), 7.6 (1H, t), 7.55 (3H, dd), 7.49 (2H, dd), 7.48 (1H, t), 7.46 (2H, d), 7.38 (1H, d), 7.27 (2H, d) |
| **C7** | δ = 8.28 (4H, s), 7.89 (1H, d), 7.66 (1H, d), 7.6 (1H, d), 7.57 (1H, d), 7.52 (2H, d), 7.51 (6H, d), 7.41 (3H, d), 7.38 (1H, d), 7.32 (1H, dd), 7.25 (8H, d) |
| **C15** | δ = 8.45 (1H, d), 8.36 (4H, d), 8.20 (1H, s), 8.17 (1H, d), 7.98 (1H, d), 7.97 (1H, d), 7.87 (1H, d), 7.86 (1H, s), 7.81 (1H, s), 7.56 (1H, t), 7.54 (1H, d), 7.50 (6H, t), 7.39 (1H, t), 7.31 (2H, t) |
| **C17** | δ = 8.28 (4H, s), 8 (2H, d), 7.92 (1H, d), 7.89 (1H, d), 7.73 (1H, d), 7.66 (1H, d), 7.6 (1H, d), 7.59 (2H, d), 7.58 (1H, d), 7.57 (1H, dd), 7.51 (4H, d), 7.41 (2H, d), 7.38 (1H, dd), 7.32 (1H, dd), 7.25 (4H, s) |
| **C18** | δ = 8.28 (4H, s), 7.92 (2H, d), 7.89 (1H, d), 7.73 (2H, d), 7.66 (1H, d), 7.6 (1H, d), 7.58 (2H, d), 7.57 (1H, d), 7.52 (2H, d), 7.51 (6H, dd), 7.41 (3H, d), 7.38 (1H, d), 7.32 (1H, dd) |
| **C24** | δ = 8.28 (2H, s), 8 (2H, d), 7.92 (1H, d), 7.89 (2H, d), 7.75 (1H, d), 7.73 (1H, d), 7.66 (2H, d), 7.62 (1H, d), 7.6 (1H, d), 7.59 (2H, dd), 7.58 (1H, d), 7.57 (1H, d), 7.51 (2H, dd), 7.44 (1H, dd), 7.41 (1H, s), 7.38 (2H, t), 7.32 (2H, t), 7.25 (4H, dd) |
| **C40** | δ = 9.02 (1H, d), 8.95 (1H, d), 8.36 (4H, d), 8.06 (2H, d), 7.99 (2H, d), 7.86 (1H, s), 7.81 (1H, s), 7.78 (1H, d), 7.63 (1H, t), 7.58 (1H, t), 7.55 (1H, s), 7.54 (1H, d), 7.50 (6H, t), 7.39 (1H, t), 7.31 (1H, d) |
| **C51** | δ = 8.28 (2H, s), 8 (2H, d), 7.92 (1H, d), 7.89 (1H, d), 7.85 (2H, d), 7.79 (2H, d), 7.73 (1H, d), 7.66 (1H, d), 7.6 (1H, d), 7.59 (2H, dd), 7.58 (1H, d), 7.57 (1H, d), 7.51 (4H, dd), 7.41 (2H, dd), 7.38 (1H, s), 7.32 (1H, t), 7.25 (2H, t) |
| **C52** | δ = 8.55 (1H, s), 8.42 (1H, d), 8.28 (4H, d), 8.08 (1H, d), 8.04 (1H, d), 7.89 (1H, d), 7.87 (1H, d), 7.68 (1H, d), 7.66 (1H, d), 7.61 (1H, dd), 7.55 (2H, d), 7.51 (4H, d), 7.41 (2H, dd), 7.38 (1H, dd), 7.32 (1H, s), 7.25 (4H, t) |
| **C54** | δ = 8.28 (4H, s), 8 (2H, d), 7.92 (1H, d), 7.89 (1H, d), 7.87 (1H, d), 7.81 (1H, d), 7.73 (1H, d), 7.66 (1H, d), 7.59 (2H, d), 7.58 (1H, dd), 7.51 (4H, d), 7.41 (2H, d), 7.38 (1H, dd), 7.32 (1H, dd), 7.25 (4H, s) |
| **C55** | δ = 9.09 (1H, s), 8.49 (1H, d), 8.28 (2H, d), 7.92 (2H, d), 7.89 (1H, d), 7.87 (1H, d), 7.81 (1H, d), 7.79 (2H, d), 7.73 (1H, d), 7.66 (1H, dd), 7.58 (1H, d), 7.52 (2H, d), 7.51 (6H, dd), 7.41 (3H, dd), 7.38 (1H, s), 7.32 (1H, t) |
| **C73** | δ = 8.28 (2H, s), 8 (2H, d), 7.92 (1H, d), 7.89 (1H, d), 7.85 (2H, d), 7.73 (1H, d), 7.66 (1H, d), 7.6 (1H, d), 7.59 (2H, d), 7.58 (1H, dd), 7.57 (1H, d), 7.52 (2H, d), 7.51 (4H, dd), 7.41 (2H, dd), 7.38 (1H, s), 7.32 (1H, t), 7.25 (2H, t) |
| **C80** | δ = 8.28 (2H, s), 8 (2H, d), 7.92 (1H, d), 7.89 (2H, d), 7.75 (1H, d), 7.73 (1H, d), 7.66 (2H, d), 7.62 (1H, d), 7.6 (1H, d), 7.59 (2H, dd), 7.58 (1H, d), 7.57 (1H, d), 7.51 (2H, dd), 7.44 (1H, dd), 7.41 (1H, s), 7.38 (2H, t), 7.32 (2H, t) |
| **C92** | δ = 9.09 (1H, s), 8.49 (1H, d), 8.28 (2H, d), 8 (2H, d), 7.95 (1H, d), 7.92 (1H, d), 7.75 (2H, d), 7.64 (1H, d), 7.62 (1H, d), 7.59 (2H, dd), 7.52 (2H, d), 7.51 (4H, d), 7.44 (1H, dd), 7.41 (2H, dd), 7.25 (4H, s) |
| **C99** | δ = 8.28 (2H, s), 8 (2H, d), 7.92 (1H, d), 7.89 (1H, d), 7.85 (2H, d), 7.79 (2H, d), 7.77 (1H, d), 7.73 (1H, d), 7.7 (1H, d), 7.66 (1H, dd), 7.59 (2H, d), 7.58 (1H, d), 7.51 (4H, dd), 7.41 (2H, dd), 7.38 (1H, s), 7.32 (1H, t), 7.25 (2H, t) |
| **C100** | δ = 9.09 (2H, s), 8.49 (2H, d), 8 (4H, d), 7.92 (2H, d), 7.91 (1H, d), 7.89 (1H, d), 7.81 (1H, d), 7.66 (1H, d), 7.59 (4H, d), 7.52 (2H, dd), 7.51 (2H, d), 7.41 (1H, d), 7.38 (1H, dd), 7.32 (1H, dd), 7.25 (4H, s) |
| **C107** | δ = 8.28 (4H, s), 8 (2H, d), 7.95 (1H, d), 7.92 (1H, d), 7.75 (2H, d), 7.73 (1H, d), 7.64 (1H, d), 7.62 (1H, d), 7.59 (2H, d), 7.58 (1H, dd), 7.51 (4H, d), 7.44 (1H, d), 7.41 (2H, dd), 7.25 (4H, dd) |
| **C119** | δ = 8.28 (2H, s), 8 (2H, d), 7.95 (1H, d), 7.92 (1H, d), 7.85 (2H, d), 7.81 (1H, d), 7.75 (1H, d), 7.73 (1H, d), 7.72 (1H, d), 7.71 (1H, dd), 7.64 (1H, d), 7.59 (2H, d), 7.58 (1H, dd), 7.52 (2H, dd), 7.51 (4H, s), 7.41 (2H, t), 7.25 (2H, t) |
| **C122** | δ = 8.28 (4H, s), 7.92 (2H, d), 7.85 (1H, d), 7.81 (1H, d), 7.75 (1H, d), 7.73 (2H, d), 7.62 (1H, d), 7.58 (2H, d), 7.52 (2H, d), 7.51 (6H, dd), 7.44 (1H, d), 7.41 (3H, d), 7.38 (1H, dd) |
| **C131** | δ = 9.09 (1H, s), 8.49 (1H, d), 8 (2H, d), 7.92 (1H, d), 7.89 (1H, d), 7.85 (2H, d), 7.75 (1H, d), 7.66 (1H, d), 7.62 (1H, d), 7.59 (2H, dd), 7.52 (2H, d), 7.51 (2H, d), 7.44 (1H, dd), 7.41 (1H, dd), 7.38 (1H, s), 7.32 (1H, t), 7.25 (6H, t) |
| **C134** | δ = 8 (2H, s), 7.95 (1H, d), 7.92 (1H, d), 7.89 (2H, d), 7.85 (2H, d), 7.75 (2H, d), 7.73 (1H, d), 7.66 (2H, d), 7.64 (1H, d), 7.62 (1H, dd), 7.59 (2H, d), 7.58 (1H, d), 7.44 (1H, dd), 7.38 (2H, dd), 7.32 (2H, s), 7.25 (2H, t) |
| **C143** | δ = 7.89 (1H, s), 7.75 (1H, d), 7.66 (1H, d), 7.62 (1H, d), 7.44 (1H, d), 7.38 (1H, d), 7.32 (1H, d) |
| **C145** | δ = 8 (2H, s), 7.92 (1H, d), 7.89 (1H, d), 7.73 (1H, d), 7.66 (1H, d), 7.6 (1H, d), 7.59 (2H, d), 7.58 (1H, d), 7.57 (1H, d), 7.38 (1H, dd), 7.32 (1H, d), 7.25 (4H, d) |
| **C165** | δ = 8.36 (4H, d), 8.09 (1H, d), 8.06 (1H, d), 7.99 (1H, d), 7.98 (1H, d), 7.97 (2H, d), 7.86 (1H, s), 7.81 (1H. s), 7.63 (1H, t), 7.61 (2H, s), 7.58 (1H, t), 7.55 (1H, s), 7.54 (1H, d), 7.50 (6H, t), 7.40 (2H, d), 7.39 (1H, t), 7.38 (1H, d), 7.31 (1H, t) |
| **C167** | δ = 8.95 (1H, d), 8.50 (1H, d), 8.36 (4H, d), 7.97 (2H, d), 7.78 (2H, d), 7.77 (1H, t), 7.76 (1H, s), 7.61 (2H, s), 7.60 (1H, d), 7.57 (2H, d), 7.50 (6H, t), 7.47 (1H, t), 7.41 (1H, t), 7.40 (1H, d), 7.35 (1H, t) |
| **C203** | δ = 9.27(1H, s), 8.98(1H, d), 8.52(1H, d), 8.49(1H, d), 8.36(2H, d), 8.15(1H, d), 8.08(1H, d), 7.98(1H, d), 7.9(1H, d), 7.86(2H, dd), 7.81(1H, d), 7.75(3H, d), 7.68(1H, dd), 7.63(1H, dd), 7.54(1H, s), 7.5 (3H, t), 7.49 (2H, t), 7.41 (1H, dd), 7.39 (1H, dd), 7.31 (1H, t) |
| **C205** | δ = 9.11(1H, s), 8.92(1H, d), 8.84(1H, d), 8.46(1H, d), 8.36(2H, d), 8.21(1H, d), 8.09(1H, d), 7.98(1H, d), 7.92(1H, d), 7.9(1H, dd), 7.7(1H, d), 7.68(1H, d), 7.63(1H, dd), 7.6(1H, dd), 7.57(1H, s), 7.54 (1H, t), 7.5 (3H, t), 7.47 (1H, dd), 7.39 (1H, dd), 7.31 (1H, t) |
| **C210** | δ = 9.27(1H, s), 9.09(1H, d), 8.85(1H, d), 8.52(1H, d), 8.49(1H, d), 8.16(1H, d), 8.15(1H, d), 8.08(1H, d), 8(1H, d), 7.98(1H, dd), 7.9(1H, d), 7.75(2H, d), 7.68(1H, dd), 7.63(1H, dd), 7.61(1H, s), 7.6 (1H, t), 7.57 (2H, t), 7.54 (1H, dd), 7.47 (1H, dd), 7.39 (1H, t), 7.31 (1H, d) |
| **C217** | δ = 8.36(2H, s), 7.98(1H, d), 7.6(1H, d), 7.57(1H, d), 7.56(1H, d), 7.54(1H, d), 7.51(1H, d), 7.5(3H, d), 7.47(1H, d), 7.39(1H, dd), 7.31(1H, d), 7.28(1H, d), 7.05(1H, dd), 6.84(1H, dd), 6.25(1H, s), 6.17 (1H, t), 3.66 (1H, t), 3.33 (1H, dd), |
| **C245** | δ = 8.95(1H, s), 8.5(1H, d), 8.36(2H, d), 8.25(2H, d), 7.98(1H, d), 7.89(1H, d), 7.78(1H, d), 7.77(1H, d), 7.6(1H, d), 7.57(1H, dd), 7.54(1H, d), 7.5(3H, d), 7.47(1H, dd), 7.41(1H, dd), 7.39(1H, s), 7.35 (1H, t), 7.31 (1H, t), 7.25 (6H, dd) |
| **C290** | δ = 9.27(1H, s), 8.92(1H, d), 8.84(1H, d), 8.37(1H, d), 8.36(4H, d), 8.35(1H, d), 8.09(1H, d), 7.98(1H, d), 7.92(1H, d), 7.9(1H, dd), 7.86(1H, d), 7.81(1H, d), 7.7(1H, dd), 7.68(1H, dd), 7.63(1H, s), 7.54 (1H, t), 7.5 (7H, t), 7.39 (1H, dd) |
| **C312** | δ = 8.36(2H, s), 7.98(1H, d), 7.6(1H, d), 7.57(1H, d), 7.54(1H, d), 7.5(3H, d), 7.47(1H, d), 7.39(1H, d), 7.31(1H, d) |
| **C320** | δ = 9.11(1H, s), 8.36(2H, d), 8.21(1H, d), 8.09(1H, d), 8.06(1H, d), 7.99(1H, d), 7.63(1H, d), 7.58(1H, d), 7.55(1H, d), 7.5(3H, dd), 7.38(1H, d) |
| **C328** | δ = 9.09(1H, s), 8.49(2H, d), 8.46(1H, d), 8.16(1H, d), 8.08(1H, d), 8(1H, d), 7.98(2H, d), 7.93(1H, d), 7.61(1H, d), 7.6(1H, dd), 7.57(2H, d), 7.54(2H, d), 7.5(1H, dd), 7.47(1H, dd), 7.39(2H, s), 7.31 (2H, t), 7.29 (1H, t) |
| **C357** | δ = 9.27(1H, s), 8.92(1H, d), 8.84(1H, d), 8.52(1H, d), 8.23(1H, d), 8.15(1H, d), 8.09(1H, d), 7.98(1H, d), 7.94(2H, d), 7.92(1H, dd), 7.9(1H, d), 7.86(1H, d), 7.81(1H, dd), 7.75(2H, dd), 7.7(1H, s), 7.68 (1H, t), 7.63 (1H, t), 7.55 (2H, dd), 7.54 (1H, dd), 7.49 (3H, t), 7.41 (1H, d), 7.39 (1H, d), 7.31 (1H, d) |
| **C379** | δ = 9.27(1H, s), 8.98(1H, d), 8.52(1H, d), 8.49(1H, d), 8.15(1H, d), 8.13(1H, d), 8.08(1H, d), 7.98(1H, d), 7.9(1H, d), 7.86(2H, dd), 7.84(1H, d), 7.83(1H, d), 7.81(1H, dd), 7.75(3H, dd), 7.68(1H, s), 7.63 (1H, t), 7.58 (1H, t), 7.54 (1H, dd), 7.49 (2H, dd), 7.41 (1H, t), 7.39 (1H, d), 7.31 (1H, d) |
| **C404** | δ = 8.38(1H, s), 8.36(2H, d), 7.98(2H, d), 7.94(1H, d), 7.86(1H, d), 7.81(1H, d), 7.75(2H, d), 7.71(1H, d), 7.61(1H, d), 7.6(1H, dd), 7.57(1H, d), 7.54(2H, d), 7.5(3H, dd), 7.49(2H, dd), 7.47(1H, s), 7.41 (1H, t), 7.39 (2H, t), 7.31 (2H, dd) |
| **C446** | δ = 9.11(1H, s), 8.92(1H, d), 8.84(1H, d), 8.46(1H, d), 8.21(1H, d), 8.09(1H, d), 7.98(1H, d), 7.92(1H, d), 7.9(1H, d), 7.86(2H, dd), 7.81(1H, d), 7.78(1H, d), 7.75(2H, dd), 7.7(1H, dd), 7.68(1H, s), 7.63 (1H, t), 7.54 (1H, t), 7.49 (2H, dd), 7.41 (1H, dd), 7.39 (1H, t), 7.33 (1H, d), 7.31 (2H, d) |

**[Table 5]**

| Compound No. | FD-MS | Compound No. | FD-MS |
|---|---|---|---|
| A1 | m/z= 613.24 (C46H31NO, 613.74) | A59 | m/z= 778.38 (C58H26D13NO, 779.04) |
| A3 | m/z= 637.24 (C48H31NO, 637.77) | A61 | m/z= 613.24 (C46H31NO, 613.76) |
| A4 | m/z= 689.27 (C52H35NO,689.84) | A89 | m/z= 689.27 (C52H35NO, 689.86) |
| A7 | m/z= 703.25 (C52H33NO2,703.82) | A94 | m/z= 613.24 (C46H31NO, 613.76) |
| A12 | m/z= 689.27 (C52H35NO, 689.84) | A98 | m/z= 634.37 (C46H10D21NO, 634.87) |
| A16 | m/z= 663.26 (C50H33NO, 663.80) | A101 | m/z= 613.24 (C46H31NO, 613.74) |
| A17 | m/z= 765.30 (C58H39NO, 765.94) | A106 | m/z= 613.24 (C46H31NO, 613.74) |
| A20 | m/z= 765.30 (C58H39NO, 765.94) | A119 | m/z= 613.24 (C46H31NO, 613.74) |
| A21 | m/z= 713.27 (C54H35NO, 713.86) | A126 | m/z= 854.33 (C64H42N2O, 855.05) |
| A24 | m/z= 703.25 (C52H33NO2, 703.82) | A127 | m/z= 779.28 (C58H37NO2, 779.94) |
| A26 | m/z= 613.24 (C46H31NO, 613.74) | A128 | m/z= 703.25 (C52H33NO2, 703.84) |
| A41 | m/z= 613.24 (C46H31NO,613.74) | A136 | m/z= 778.30 (C58H38N2O, 778.85) |
| A50 | m/z= 778.30 (C55H38N2O,778.96) | A138 | m/z= 778.30 (C58H38N2O, 778.85) |
| A157 | m/z = 613.24 (C46H31NO, 613.76) | A158 | m/z = 627.22 (C46H29NO2, 627.74) |
| A159 | m/z = 631.17 (C43H25N3OS, 631.75) | A181 | m/z = 677.24 (C50H31NO2, 677.80) |
| A222 | m/z = 729.30 (C55H39NO, 729.92) | A278 | m/z = 729.30 (C55H39NO, 729.92) |
| A296 | m/z = 677.24 (C50H31NO2, 677.80) | A298 | m/z = 687.26 (C52H33NO, 687.84) |
| C7 | m/z = 627.23 (C45H29N3O, 627.73) | C122 | m/z = 601.22 (C43H27N3O, 601.69) |
| C15 | m/z = 581.16 (C39H23N3OS, 581.69) | C131 | m/z = 601.22 (C43H27N3O, 601.69) |
| C17 | m/z = 601.22 (C43H27N3O, 601.69) | C134 | m/z = 615.19 (C43H25N3O, 615.68) |
| C18 | m/z = 601.22 (C43H27N3O, 601.69) | C143 | m/z = 633.31 (C43H7D18N, 633.79) |
| C24 | m/z = 691.23 (C49H29N3O2, 691.77) | C145 | m/z = 611.28 (C43H17D10, 611.76) |
| C40 | m/z = 651.23 (C47H29N3O, 651.77) | C165 | m/z = 651.23 (C47H29N3O, 651.77) |
| C51 | m/z = 601.22 (C43H27N3O, 601.69) | C167 | m/z = 651.23 (C47H29N3O, 651.77) |
| C52 | m/z = 601.22 (C43H27N3O, 601.69) | C203 | m/z = 625.22 (C45H27N3O, 625.73) |
| C54 | m/z = 601.22 (C43H27N3O, 601.69) | C205 | m/z = 549.18 (C39H23N3O, 549.63) |
| C55 | m/z = 601.22 (C43H27N3O, 601.69) | C210 | m/z = 549.18 (C39H23N3O, 549.63) |
| C73 | m/z = 601.22 (C43H27N3O, 601.69) | C217 | m/z = 525.18 (C37H23N3O, 525.61) |
| C80 | m/z = 615.19 (C43H25N3O, 615.68) | C245 | m/z = 601.22 (C43H27N3O, 601.71) |
| C92 | m/z = 601.22 (C43H27N3O, 601.69) | C290 | m/z = 625.22 (C45H27N3O, 625.73) |
| C99 | m/z = 601.22 (C43H27N3O, 601.69) | C312 | m/z = 560.25 (C39H12D11N3O, 560.70) |
| C100 | m/z = 651.23 (C47H29N3O, 651.75) | C320 | m/z = 638.30 (C45H14D13N3O, 638.81) |
| C107 | m/z = 601.22 (C43H27N3O, 601.69) | C328 | m/z = 589.18 (C41H23N3O2, 589.65) |
| C119 | m/z = 601.22 (C43H27N3O, 601.69) | C357 | m/z = 624.22 (C46H28N2O, 624.74) |
| | | C379 | m/z = 598.20 (C44H26N2O, 598.71) |
| | | C404 | m/z = 641.21 (C45H27N3O2, 641.73) |
| | | C446 | m/z = 654.18 (C46H26N2OS, 654.79) |

### [Experimental Examples]

### <Experimental Example 1> Manufacture of Organic Light Emitting Device

### 1) Manufacture of organic light emitting device

A glass substrate, in which indium tin oxide (ITO) was thinly coated to have a thickness of 1,500 Å, was ultrasonically washed with distilled water. When the washing with distilled water was finished, the glass substrate was ultrasonically washed with a solvent such as acetone, methanol, and isopropyl alcohol, dried and then subjected to ultraviolet ozone (UVO) treatment for 5 minutes using UV in an ultraviolet (UV) washing machine. Thereafter, the substrate was transferred to a plasma washing machine (PT), and then was subjected to plasma treatment in a vacuum state for an ITO work function and in order to remove a residual film, and was transferred to a thermal deposition apparatus for organic deposition.

As the common layers, the hole injection layer 4,4',4"-tris[2-naphthyl(phenyl)amino]triphenylamine (2-TNATA) and the hole transport layer N,N'-di(1-naphthyl)-N,N'-diphenyl)-4,4'-diamine (NPB) were formed on the ITO transparent electrode (positive electrode).

A light emitting layer was thermally vacuum deposited thereon as follows. Specifically, the compounds described as the compounds Group A and Group C were used as the red hosts of the light emitting layer, and a light emitting layer having a thickness of 500 Å was deposited by doping the red host with a red phosphorescent dopant (piq)₂(Ir)(acac) in an amount of 3 wt%. Thereafter, bathocuproine (hereinafter, referred to as BCP) was deposited thereon as a hole blocking layer to have a thickness of 60 Å, and Alq₃ was deposited as an electron transport layer to have a thickness of 200 Å thereon.

Finally, an organic light emitting device was manufactured by depositing lithium fluoride (LiF) to have a thickness of 10 Å on the electron transport layer to form an electron injection layer, and then depositing an aluminum (Al) negative electrode to have a thickness of 1,200 Å on the electron injection layer to form a negative electrode.

Meanwhile, all the organic compounds required for manufacturing an OLED device were subjected to vacuum sublimed purification under 10⁻⁸ to 10⁻⁶ torr for each material, and used for the manufacture of the OLED.

### 2) Driving Voltage and Light Emitting Efficiency of Organic Light Emitting Device

For the organic light emitting devices of Example Compounds A and C in Tables 1 to 3, which were manufactured as above, electroluminescent light emission (EL) characteristics were measured using M7000 manufactured by McScience Inc., and with the measurement results, T₉₀ when the standard luminance was 6,000 cd/m₂ was measured using a service life measurement apparatus (M6000) manufactured by McScience Inc. T₉₀ means the service life (unit: hour) that is the time it takes for the luminance to reach 90% relative to the initial luminance.

The measured characteristics of the organic light emitting device are shown in the following Table 6. For reference, the following ratios are based on weight ratios, A is the first heterocyclic compound represented by Chemical Formula A, C is the second heterocyclic compound, and C' is the third heterocyclic compound, and although the second heterocyclic compound and the third heterocyclic compound are all the same in that the compounds are represented by Chemical Formula C, but the two compounds are represented by C and C' to distinguish the compounds because the structures of C and C' are different.

**[Table 6]**

| No. | Composition | | | Ratio (A:C:C') | Driving voltage (Vop) | Efficiency (cd/A) | Color coordinate (x,y) | Lifetime (T₉₀) |
|---|---|---|---|---|---|---|---|---|
| Comparative Example 1 | A12 | | | 1 | 4.99 | 26.4 | (0.679,0.320) | 110 |
| Comparative Example 2 | F | | | 1 | 5.3 | 14.6 | (0.679,0.320) | 52 |
| Comparative Example 3 | C7 | | | 1 | 3.85 | 31.4 | (0.679,0.320) | 20 |
| Comparative Example 4 | C92 | | | 1 | 3.79 | 30.8 | (0.679,0.320) | 35 |
| Comparative Example 5 | A12 | C7 | - | 1:1 | 3.09 | 52.0 | (0.679,0.320) | 247 |
| Comparative Example 6 | F | C7 | - | 1:1 | 4.2 | 36.8 | (0.679,0.320) | 115 |
| Comparative Example 7 | A12 | - | C92 | 1:1 | 3.19 | 48.6 | (0.679,0.320) | 348 |
| Comparative Example 8 | F | - | C92 | 1:1 | 4.3 | 36.3 | (0.679,0.320) | 139 |
| Example 1 | A12 | C7 | C92 | 2:2:1 | 3.04 | 70.9 | (0.679,0.320) | 462 |
| Comparative Example 9 | F | C7 | C92 | 2:2:1 | 3.6 | 49.9 | (0.679,0.320) | 214 |
| Comparative Example 10 | A50 | | | 1 | 4.86 | 23.3 | (0.683,0.316) | 106 |
| Comparative Example 11 | D | | | 1 | 5.1 | 17.1 | (0.683,0.316) | 43 |
| Comparative Example 12 | C24 | | | 1 | 3.8 | 33.6 | (0.683,0.316) | 19 |
| Comparative Example 13 | C134 | | | 1 | 3.74 | 29.8 | (0.683,0.316) | 39 |
| Comparative Example 14 | D | C24 | - | 1:1 | 4 | 40.6 | (0.683,0.316) | 99 |
| Comparative Example 15 | D | - | C134 | 1:1 | 4.1 | 37.5 | (0.683,0.316) | 131 |
| Comparative Example 16 | A50 | C24 | - | 1:1 | 2.96 | 51.2 | (0.683,0.316) | 238 |
| Comparative Example 17 | A50 | - | C134 | 1:1 | 3.06 | 45.1 | (0.683,0.316) | 348 |
| Example 2 | A50 | C24 | C134 | 2:1:1 | 3.36 | 69.4 | (0.683,0.316) | 459 |
| Comparative Example1 18 | D | C24 | C134 | 2:1:1 | 3.4 | 52.3 | (0.683,0.316) | 202 |
| Comparative Example 19 | A61 | | | 1 | 5 | 23.1 | (0.683,0.316) | 116 |
| Comparative Example 20 | E | | | 1 | 5.4 | 15.5 | (0.683,0.316) | 55 |
| Comparative Example 21 | C107 | | | 1 | 3.86 | 31.0 | (0.683,0.316) | 21 |
| Comparative Example 22 | C80 | | | 1 | 4.3 | 32.5 | (0.683,0.316) | 40 |
| Comparative Example 23 | E | C107 | - | 1:1 | 4.3 | 37.2 | (0.683,0.316) | 122 |
| Comparative Example 24 | E | - | C80 | 1:1 | 4.4 | 38.4 | (0.683,0.316) | 152 |
| Comparative Example 25 | A61 | C107 | - | 1:1 | 3.1 | 48.7 | (0.683,0.316) | 260 |
| Comparative Example 26 | A61 | - | C80 | 1:1 | 3.2 | 47.3 | (0.683,0.316) | 374 |
| Example 3 | A61 | C107 | C80 | 2:1:1 | 3.05 | 69.3 | (0.683,0.316) | 496 |
| Comparative Example 27 | E | C107 | C80 | 2:1:1 | 3.7 | 51.4 | (0.683,0.316) | 232 |
| Comparative Example 28 | A101 | | | 1 | 4.84 | 21.8 | (0.679,0.320) | 100 |
| Comparative Example 29 | C54 | | | 1 | 3.89 | 32.7 | (0.679,0.320) | 21 |
| Comparative Example 30 | C167 | | | 1 | 3.77 | 31.4 | (0.679,0.320) | 36 |
| Comparative Example 31 | A101 | C54 | - | 1:1 | 2.94 | 49.1 | (0.679,0.320) | 230 |
| Comparative Example 32 | A101 | - | C167 | 1:1 | 3.04 | 45.2 | (0.679,0.320) | 326 |
| Example 4 | A101 | C54 | C167 | 2:1:1 | 2.89 | 68.7 | (0.679,0.320) | 440 |
| Comparative Example 33 | D | C54 | C167 | 2:1:1 | 3.4 | 52.8 | (0.679,0.320) | 200 |
| Comparative Example 34 | A89 | | | 1 | 4.88 | 24.1 | (0.683,0.316) | 98 |
| Comparative Example 35 | C40 | | | 1 | 3.86 | 33.2 | (0.683,0.316) | 24 |
| Comparative Example 36 | C143 | | | 1 | 3.8 | 29.2 | (0.683,0.316) | 56 |
| Comparative Example 37 | A89 | C40 | - | 1:1 | 2.98 | 51.6 | (0.679,0.320) | 232 |
| Comparative Example 38 | A89 | - | C143 | 1:1 | 3.08 | 45.3 | (0.679,0.320) | 370 |
| Example 5 | A89 | C40 | C143 | 2:1.5:1.5 | 2.93 | 69.2 | (0.679,0.320) | 498 |
| Comparative Example 39 | F | C40 | C143 | 2:1.5:1.5 | 3.6 | 50.1 | (0.679,0.320) | 264 |
| Comparative Example 40 | A127 | | | 1 | 4.94 | 25.8 | (0.679,0.320) | 96 |
| Comparative Example 41 | C51 | | | 1 | 3.86 | 31.7 | (0.679,0.320) | 21 |
| Comparative Example 42 | C119 | | | 1 | 3.77 | 30.2 | (0.679,0.320) | 36 |
| Comparative Example 43 | A127 | C51 | - | 1:1 | 3.04 | 51.8 | (0.679,0.320) | 222 |
| Comparative Example 44 | A127 | - | C119 | 1:1 | 3.14 | 47.6 | (0.679,0.320) | 317 |
| Example 6 | A127 | C51 | C119 | 2:1.5:1.5 | 2.99 | 70.2 | (0.679,0.320) | 428 |
| Comparative Example 45 | E | C51 | C119 | 2:1.5:1.5 | 3.7 | 50.3 | (0.679,0.320) | 224 |
| Comparative Example 46 | A17 | | | 1 | 4.94 | 28.4 | (0.679,0.320) | 117 |
| Comparative Example 47 | C100 | | | 1 | 3.89 | 29.7 | (0.679,0.320) | 23 |
| Comparative Example 48 | C145 | | | 1 | 3.85 | 32.0 | (0.679,0.320) | 62 |
| Comparative Example 49 | A17 | C100 | - | 1:1 | 3.04 | 52.3 | (0.679,0.320) | 266 |
| Comparative Example 50 | A17 | - | C145 | 1:1 | 3.14 | 51.3 | (0.679,0.320) | 320 |
| Example 7 | A | C100 | C145 | 2:2:1 | 2.99 | 72.1 | (0.679,0.320) | 545 |
| Comparative Example 51 | E | C100 | C145 | 2:2:1 | 3.68 | 50.2 | (0.679,0.320) | 266 |
| Comparative Example 52 | A126 | | | 1 | 4.93 | 24.1 | (0.683,0.316) | 107 |
| Comparative Example 53 | C165 | | | 1 | 3.81 | 30.6 | (0.683,0.316) | 19 |
| Comparative Example 54 | C122 | | | 1 | 3.75 | 28.2 | (0.683,0.316) | 34 |
| Comparative Example 55 | A126 | C165 | - | 1:1 | 3.03 | 49.2 | (0.683,0.316) | 239 |
| Comparative Example 56 | A126 | - | C122 | 1:1 | 3.13 | 44.5 | (0.683,0.316) | 338 |
| Example 8 | A126 | C165 | C122 | 2:2:1 | 2.98 | 66.3 | (0.683,0.316) | 448 |
| Comparative Example 57 | E | C165 | C122 | 2:2:1 | 3.7 | 48.3 | (0.683,0.316) | 216 |
| Example 9 | A20 | C18 | C131 | 2:2:1 | 3.08 | 69.3 | (0.679,0.320) | 512 |
| Example 10 | A26 | C17 | C24 | 2:2:1 | 3.01 | 73.0 | (0.679,0.320) | 546 |
| Example 11 | A94 | C15 | C92 | 2:2:1 | 3.09 | 62.3 | (0.683,0.316) | 423 |
| Example 12 | A136 | C99 | C24 | 2:1:1 | 3.06 | 68.1 | (0.683,0.316) | 415 |
| Example 13 | A16 | C17 | C24 | 2:1:1 | 2.97 | 71.9 | (0.679,0.320) | 431 |
| Example 14 | A3 | C54 | C80 | 2:1:1 | 2.99 | 72.6 | (0.679,0.320) | 400 |
| Example 15 | A24 | C100 | C131 | 2:1:1 | 2.89 | 69.0 | (0.683,0.316) | 434 |
| Example 16 | A41 | C40 | C119 | 2:1:1 | 2.86 | 71.8 | (0.683,0.316) | 422 |
| Example 17 | A59 | C7 | C145 | 2:1:1 | 2.98 | 73.4 | (0.679,0.320) | 655 |
| Example 18 | A98 | C99 | C143 | 2:1:1 | 2.97 | 65.8 | (0.683,0.316) | 470 |
| Example 19 | A106 | C51 | C92 | 2:1:1 | 2.87 | 67.8 | (0.679,0.320) | 414 |
| Example 20 | A119 | C17 | C145 | 2:1:1 | 3.03 | 65.6 | (0.679,0.320) | 529 |
| Example 21 | A128 | C18 | C80 | 2:1.5:1.5 | 2.85 | 70.1 | (0.683,0.316) | 467 |
| Example 22 | A136 | C165 | C122 | 2:1.5:1.5 | 3.08 | 63.9 | (0.683,0.316) | 405 |
| Comparative Example 58 | A20 | | | 1 | 4.99 | 26.4 | (0.679,0.320) | 100 |
| Comparative Example 59 | A2 6 | | | 1 | 4.91 | 27.4 | (0.679,0.320) | 129 |
| Comparative Example 60 | A94 | | | 1 | 5.04 | 22.1 | (0.683,0.316) | 94 |
| Comparative Example 61 | A136 | | | 1 | 5.01 | 22.8 | (0.683,0.316) | 90 |
| Comparative Example 62 | A16 | | | 1 | 4.91 | 26.1 | (0.679,0.320) | 88 |
| Comparative Example 63 | A3 | | | 1 | 4.94 | 25.5 | (0.679,0.320) | 82 |
| Comparative Example 64 | A24 | | | 1 | 4.84 | 26.7 | (0.683,0.316) | 93 |
| Comparative Example 65 | A41 | | | 1 | 4.81 | 26.4 | (0.683,0.316) | 91 |
| Comparative Example 66 | A59 | | | 1 | 4.93 | 28.3 | (0.679,0.320) | 152 |
| Comparative Example 67 | A98 | | | 1 | 4.92 | 24.3 | (0.683,0.316) | 86 |
| Comparative Example 68 | A106 | | | 1 | 4.82 | 22.2 | (0.679,0.320) | 92 |
| Comparative Example 69 | A119 | | | 1 | 4.98 | 19.8 | (0.679,0.320) | 80 |
| Comparative Example 70 | A128 | | | 1 | 4.8 | 24.7 | (0.683,0.316) | 83 |
| Comparative Example 71 | A136 | | | 1 | 5.03 | 21.1 | (0.683,0.316) | 78 |
| Comparative Example 72 | C17 | | | 1 | 3.72 | 30.2 | (0.679,0.320) | 47 |
| Comparative Example 73 | C18 | | | 1 | 3.72 | 30.4 | (0.679,0.320) | 44 |
| Comparative Example 74 | C134 | | | 1 | 3.74 | 29.8 | (0.683,0.316) | 39 |
| Comparative Example 75 | C15 | | | 1 | 3.66 | 25.0 | (0.679,0.320) | 22 |
| Comparative Example 76 | C99 | | | 1 | 3.87 | 28.7 | (0.679,0.320) | 26 |
| Comparative Example 77 | C131 | | | 1 | 3.77 | 29.8 | (0.679,0.320) | 39 |
| Comparative Example 78 | C203 | | | 1 | 3.74 | 33.2 | (0.679,0.320) | 47 |
| Comparative Example 79 | C205 | | | 1 | 3.77 | 32.0 | (0.679,0.320) | 36 |
| Comparative Example 80 | C210 | | | 1 | 3.75 | 32.6 | (0.679,0.320) | 38 |
| Comparative Example 81 | C217 | | | 1 | 3.83 | 30.8 | (0.679,0.320) | 27 |
| Comparative Example 82 | C245 | | | 1 | 3.79 | 31.6 | (0.679,0.320) | 34 |
| Comparative Example 83 | C290 | | | 1 | 3.80 | 31.2 | (0.683,0.316) | 33 |
| Comparative Example 84 | C312 | | | 1 | 3.70 | 34.4 | (0.683,0.316) | 74 |
| Comparative Example 85 | C320 | | | 1 | 3.72 | 33.9 | (0.683,0.316) | 78 |
| Comparative Example 86 | A157 | | | 1 | 4.8 | 25.4 | (0.679,0.320) | 105 |
| Comparative Example 87 | A158 | | | 1 | 4.84 | 25.1 | (0.679,0.320) | 100 |
| Comparative Example 88 | A159 | | | 1 | 4.84 | 21.4 | (0.679,0.320) | 125 |
| Comparative Example 89 | A181 | | | 1 | 4.94 | 28.9 | (0.679,0.320) | 110 |
| Comparative Example 90 | A222 | | | 1 | 4.77 | 23.3 | (0.679,0.320) | 99 |
| Comparative Example 91 | A278 | | | 1 | 4.75 | 23.1 | (0.679,0.320) | 118 |
| Comparative Example 92 | A296 | | | 1 | 5.01 | 21.1 | (0.679,0.320) | 99 |
| Comparative Example 93 | A298 | | | 1 | 4.92 | 23.9 | (0.679,0.320) | 100 |
| Comparative Example 94 | C328 | | | 1 | 3.91 | 33.4 | (0.679,0.320) | 33 |
| Comparative Example 95 | C357 | | | 1 | 3.66 | 30.4 | (0.683,0.316) | 33 |
| Comparative Example 96 | C379 | | | 1 | 3.77 | 29.4 | (0.683,0.316) | 31 |
| Comparative Example 97 | C404 | | | 1 | 3.88 | 32.4 | (0.679,0.320) | 20 |
| Comparative Example 98 | C446 | | | 1 | 3.7 | 31.4 | (0.683,0.316) | 44 |
| Comparative Example 99 | A126 | C328 | - | 2:2:1 | 3.03 | 51.8 | (0.683,0.316) | 266 |
| Example 23 | A20 | C18 | C203 | 2:2:1 | 2.94 | 74.7 | (0.683,0.316) | 590 |
| Example 24 | A17 | C100 | C205 | 2:2:1 | 2.95 | 73.9 | (0.679,0.320) | 550 |
| Example 25 | A17 | C100 | C210 | 2:2:1 | 2.94 | 74.2 | (0.679,0.320) | 570 |
| Example 26 | A61 | C107 | C217 | 2:1:1 | 2.99 | 73.1 | (0.679,0.320) | 516 |
| Example 27 | A2 6 | C17 | C245 | 2:1:1 | 2.94 | 73.8 | (0.683,0.316) | 540 |
| Example 28 | A158 | C18 | C290 | 2:1:1 | 3.02 | 72.1 | (0.683,0.316) | 504 |
| Example 29 | A59 | C7 | C320 | 2:2:1 | 2.92 | 75.0 | (0.683,0.316) | 684 |
| Example 30 | A157 | C17 | C312 | 2:1:1 | 2.88 | 75.5 | (0.679,0.320) | 700 |
| Example 31 | A126 | C328 | C122 | 2:1:1 | 2.99 | 68.6 | (0.683,0.316) | 418 |
| Example 32 | A159 | C357 | C80 | 2:1:1 | 2.89 | 67.4 | (0.683,0.316) | 554 |
| Example 33 | A298 | C357 | C24 | 2:2:1 | 2.97 | 70.3 | (0.683,0.316) | 426 |
| Example 34 | A222 | C404 | C92 | 2:1:1 | 2.82 | 69.7 | (0.683,0.316) | 431 |
| Example 35 | A278 | C446 | C134 | 2:1:1 | 2.8 | 67.4 | (0.683,0.316) | 563 |
| Example 36 | A181 | C379 | C167 | 2:2:1 | 2.99 | 71.8 | (0.683,0.316) | 496 |
| Example 37 | A296 | C404 | C143 | 2:1:1 | 3.06 | 66.6 | (0.683,0.316) | 442 |

Comparative Compounds D to F used in Table 6 above are as follows.

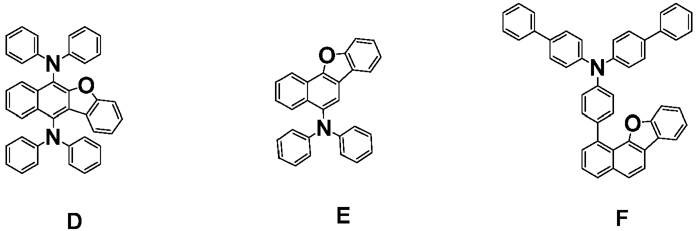

As can be seen from the results in Table 6 above, Comparative Compounds D, E and F used in the comparative example group are in the form in which one or two arylamine groups are substituted on the naphthobenzofuran core, and correspond to heterocyclic compounds that do not satisfy Chemical Formula A.

It is determined that the heterocyclic compound according to the present invention (which satisfies the above-described Chemical Formula A and is represented by A12 and the like) has a form in which the benzene moiety and the naphthalene moiety of naphthobenzofuran are substituted with a (hetero)aryl group and a (hetero)arylamine group corresponding to Ar3, respectively, to expand conjugation and increase hole or electron mobility, thereby improving device characteristics.

In contrast, it can be confirmed that Comparative Compounds D, E and F have a non-extended conjugation form, exhibit low Tg, and are not excellent in thermal stability, and thus exhibit short service life.

It could be confirmed that when an organic material layer of an organic light emitting device is formed by premixing and depositing one type of first heterocyclic compound satisfying Chemical Formula A and two types of different second and third heterocyclic compounds satisfying Chemical Formula C according to the present application, the driving voltage of the organic light emitting device can be adjusted and the efficiency or service life effect can be improved.

Specifically, the heterocyclic compound represented by Chemical Formula A is characterized by low voltage and long service life. It could be confirmed that when the ratio (weight ratio) of the heterocyclic compound represented by Chemical Formula C, which is characterized by relatively higher efficiency and longer service life, is appropriately mixed, the voltage and efficiency effect and the service life effect are additionally improved. That is, it could be confirmed that the first heterocyclic compound represented by Chemical Formula A is a p-type host including an amine substituent, and thus exhibits fast hole mobility, and the second and third heterocyclic compounds represented by Chemical Formula C are unipolar N-type hosts with fast electron mobility, when the compounds are combined, the compounds play a role in balancing the charge within the device, thereby improving efficiency and service life.

When only two types of the heterocyclic compounds of Chemical Formula A and Chemical Formula C were mixed and deposited, the driving voltage, efficiency, and service life tended to be improved compared to when only one material of the compounds was deposited, but the efficiency and service life did not reach the levels of the Example in which three types of different compounds were mixed.

The present invention is not limited to the Examples, but may be prepared in various forms, and a person with ordinary skill in the art to which the present invention pertains will understand that the present invention can be implemented in another specific form without changing the technical spirit or essential feature of the present invention. Therefore, it should be understood that the above-described Examples are illustrative only in all aspects and are not restrictive.

## Claims

1. An organic light emitting device comprising:
a first electrode;
a second electrode provided to face the first electrode; and
an organic material layer having one or more layers provided between the first electrode and the second electrode,
wherein one or more layers of the organic material layer comprise a first heterocyclic compound, a second heterocyclic compound, and a third heterocyclic compound,
the first heterocyclic compound is represented by the following Chemical Formula A, and
the second heterocyclic compound and the third heterocyclic compound are different from each other, and are each represented by the following Chemical Formula C: 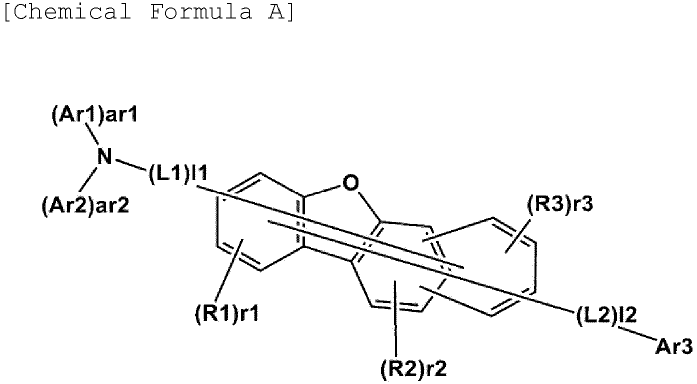 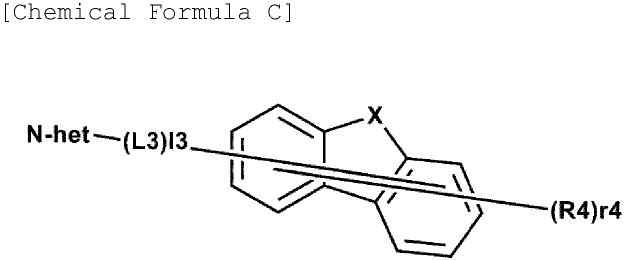
in Chemical Formulae A and C,
L1 to L3 are the same as or different from each other, and are each independently a direct bond; a substituted or unsubstituted C6 to C60 arylene group; or a substituted or unsubstituted C2 to C60 heteroarylene group,
Ar1 to Ar3 are the same as or different from each other, and are each independently a substituted or unsubstituted C6 to C60 aryl group; or a substituted or unsubstituted C2 to C60 heteroaryl group,
R1 to R3 are the same as or different from each other, and are each independently hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group,
R4 is hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; or -(L4)l4-Ar4,
Ar4 is a substituted or unsubstituted C6 to C60 aryl group; or a substituted or unsubstituted C2 to C60 heteroaryl group,
L4 is a direct bond; a substituted or unsubstituted C6 to C60 arylene group; or a substituted or unsubstituted C2 to C60 heteroarylene group,
l1 to l4 are the same as or different from each other, and are each independently an integer from 1 to 3, and when each of l1 to l4 is 2 or higher, groups in the parenthesis are the same as or different from each other,
each of r1 and r3 is an integer from 0 to 4,
r2 is an integer from 0 to 2,
the sum of r1, r2 and r3 is 8,
when each of r1, r2 and r3 is 2 or an integer higher than 2, groups in the parenthesis are the same as or different from each other,
r4 is an integer from 0 to 7, and when r4 is an integer of 2 or higher, groups in the parenthesis are the same as or different from each other,
each of ar1 and ar2 is an integer from 1 to 4, and when each of ar1 and ar2 is an integer of 2 or higher, groups in the parenthesis are the same as or different from each other,
X is O; or S, and
N-het is a substituted or unsubstituted C2 to C60 heteroaryl group, and comprises one or more N's.

2. The organic light emitting device of claim 1, wherein the N-het is represented by the following Structural Formula N: 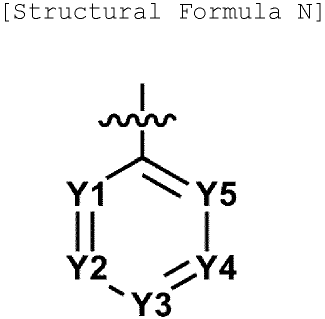
In Structural Formula N, 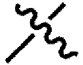 means a linking position in Chemical Formula C,
Y1 to Y5 are the same as or different from each other, and are each independently CRa or N, and at least one is N, and
Ra is a substituted or unsubstituted C6 to C60 aryl group; a substituted or unsubstituted C2 to C60 heteroaryl group; or a combination thereof, or two or more adjacent Ra groups are bonded to form a ring.

3. The organic light emitting device of claim 1, wherein Chemical Formula A is represented by any one of the following Chemical Formulae A-1 to A-3: 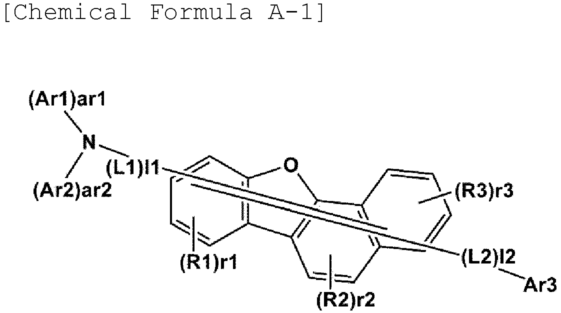 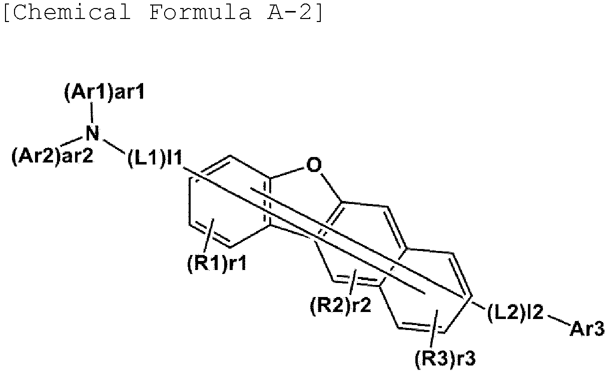 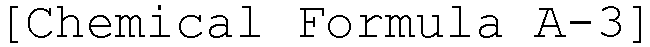 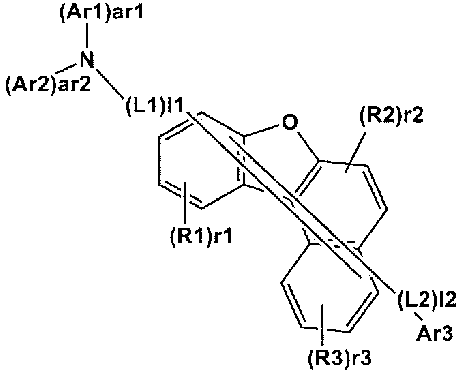
in Chemical Formulae A-1 to A-3,
each of the substituents is the same as that defined in Chemical Formula A.

4. The organic light emitting device of claim 1, wherein Chemical Formula C is represented by any one of the following Chemical Formulae C-1 to C-3: 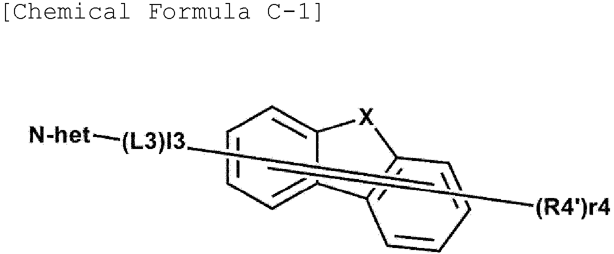 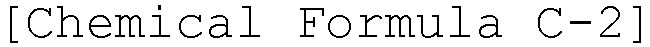 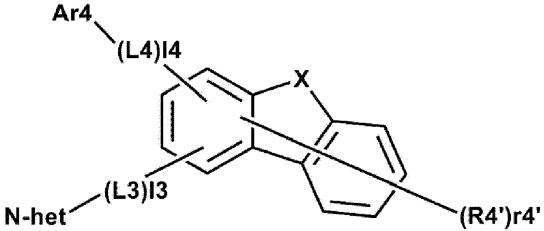 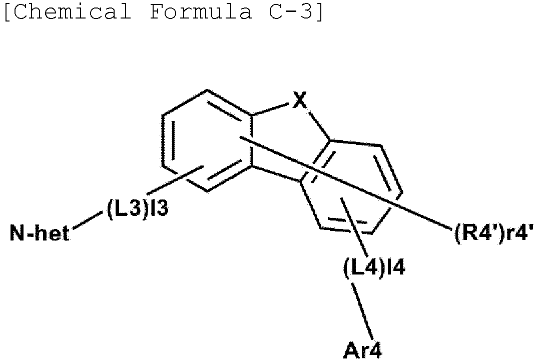
in Chemical Formulae C-1 to C-3,
each of the substituents is the same as that defined in Chemical Formula C,
R4"s are the same as or different from each other, and are each independently hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group, and
r4' is an integer from 0 to 6, and when r4' is an integer of 2 or higher, groups in the parenthesis are the same as or different from each other.

5. The organic light emitting device of claim 1, wherein Chemical Formula A is represented by any one of the following Chemical Formulae A-4 to A-10: 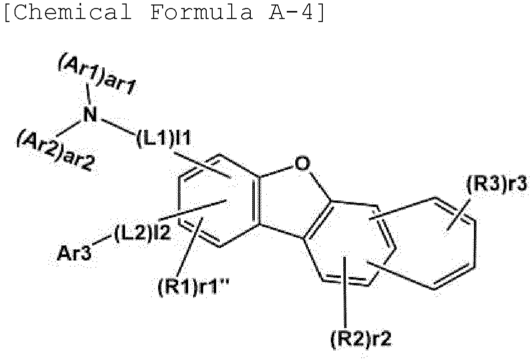 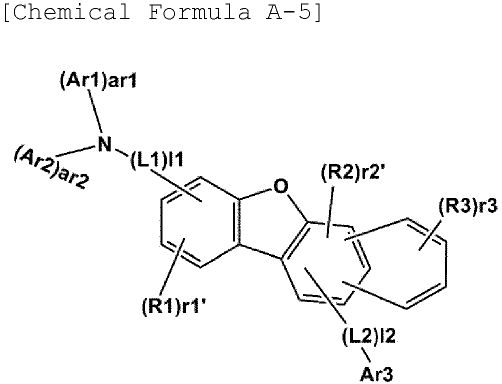 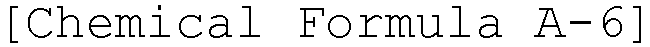 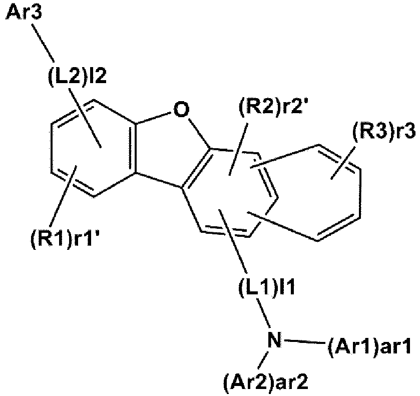 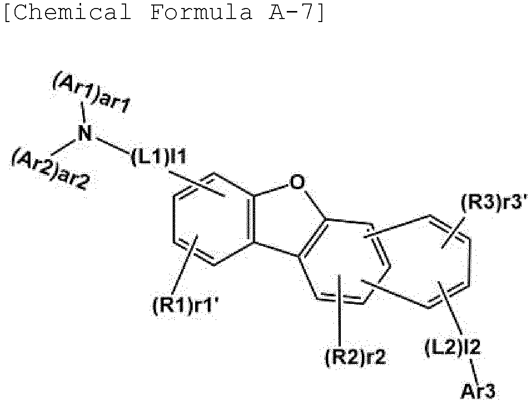 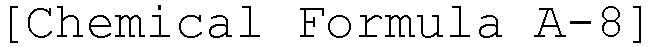 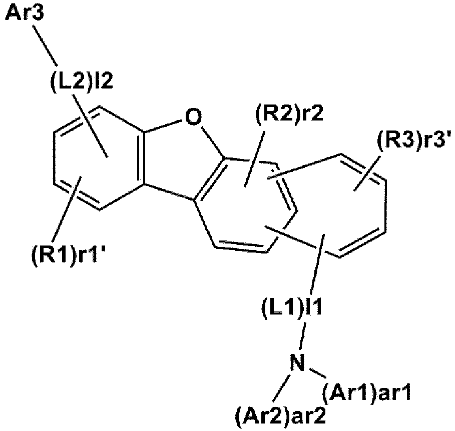 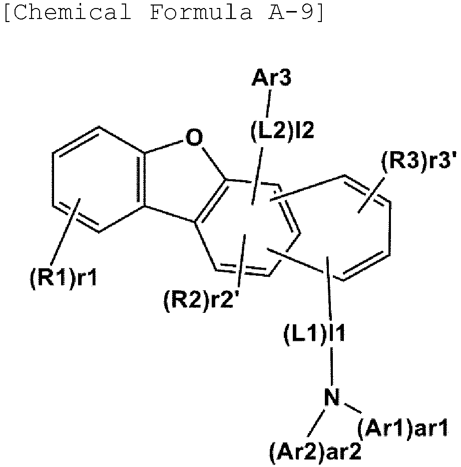 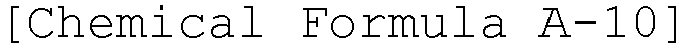 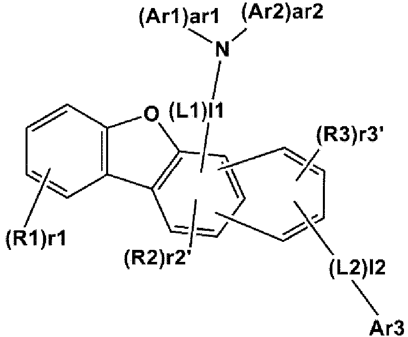
in Chemical Formulae A-4 to A-10,
each of the substituents is the same as that defined in Chemical Formula A,
r1' is an integer from 0 to 3,
r1" is an integer from 0 to 2,
r2' is 0 or 1,
r3' is an integer from 0 to 3, and
when each of r1', r1" and r3' is 2 or an integer higher than 2, groups in the parenthesis are the same as or different from each other.

6. The organic light emitting device of claim 1, wherein the "substituted or unsubstituted" means being unsubstituted or substituted with one or more substituents selected from the group consisting of deuterium; a C1 to C30 alkyl group; and a C6 to C30 aryl group.

7. The organic light emitting device of claim 1, wherein a deuterium content of the first heterocyclic compound is 0%, or 1% to 100%.

8. The organic light emitting device of claim 1, wherein a deuterium content of the second heterocyclic compound is 0%, or 1% to 100%.

9. The organic light emitting device of claim 1, wherein a deuterium content of the third heterocyclic compound is 0%, or 1% to 100%.

10. The organic light emitting device of claim 1, wherein the first heterocyclic compound is selected from the following:

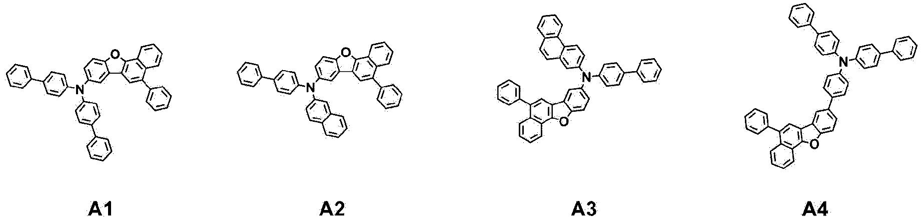

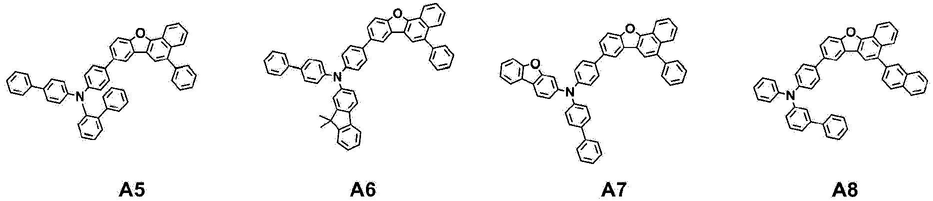

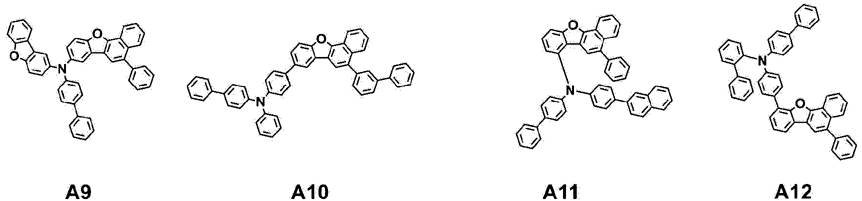

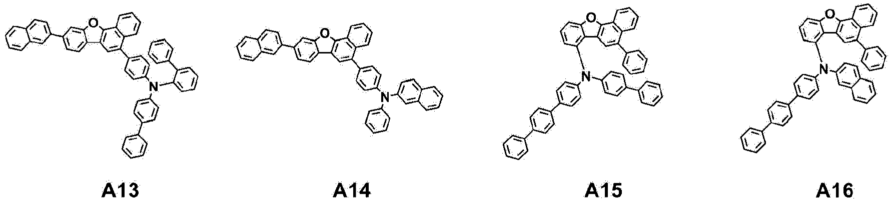

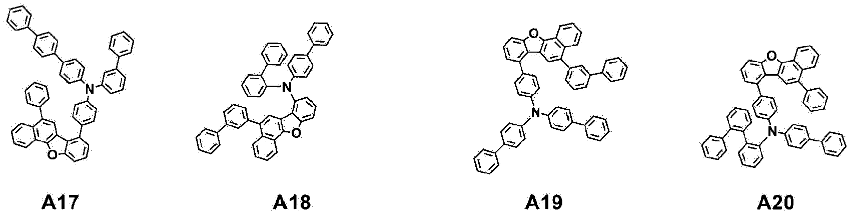

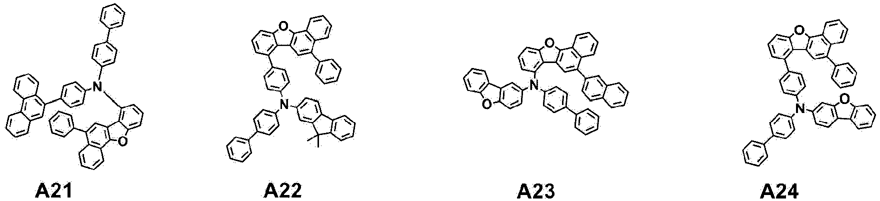

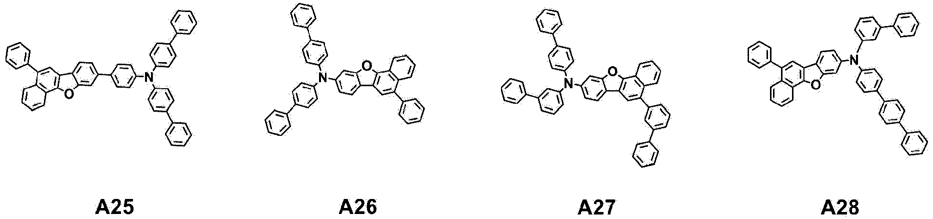

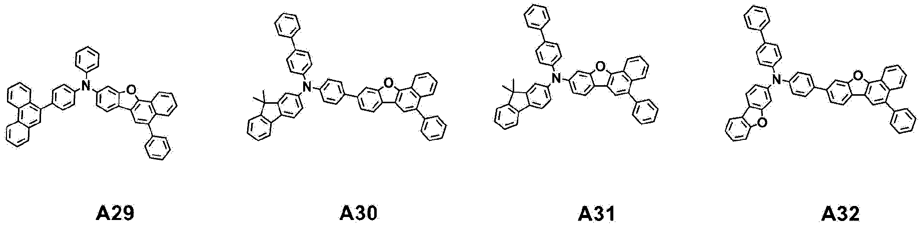

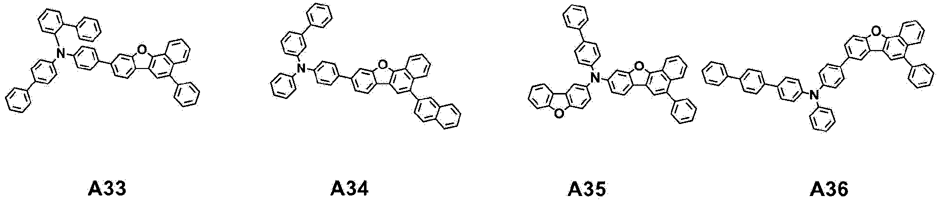

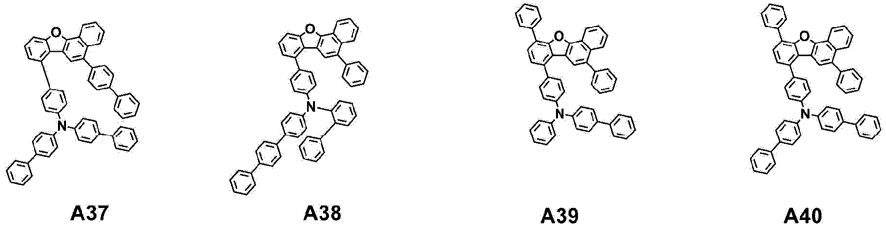

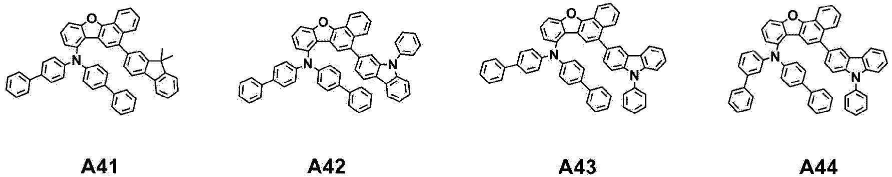

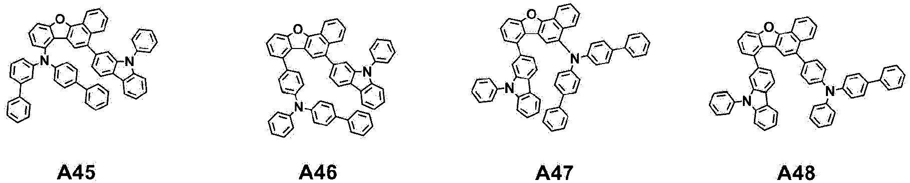

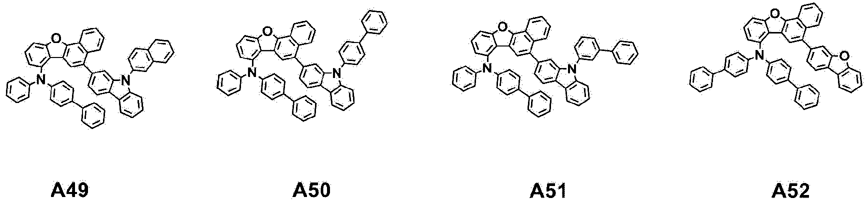

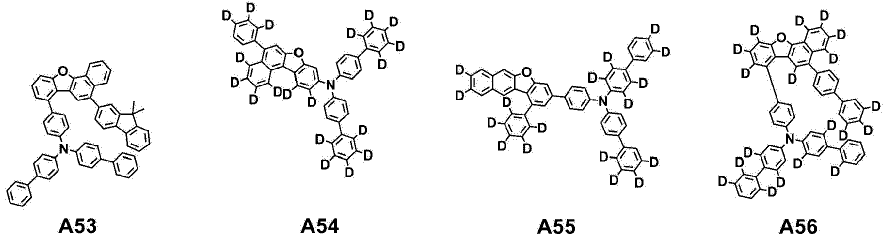

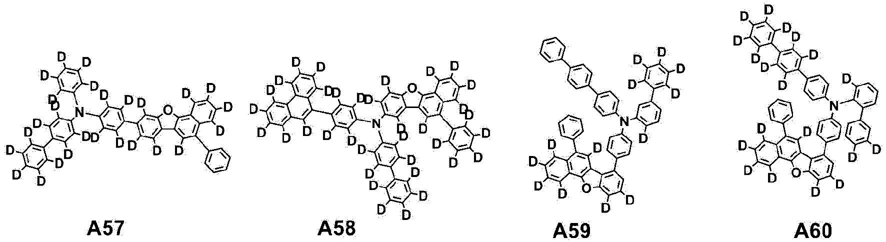

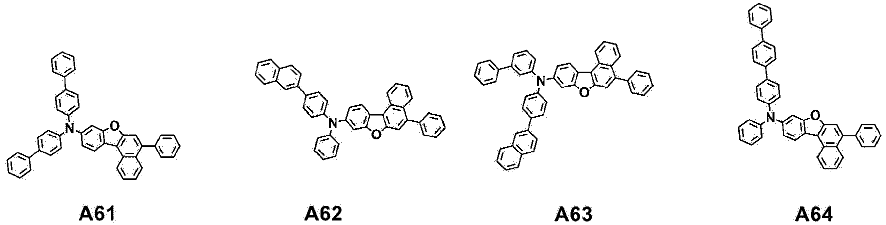

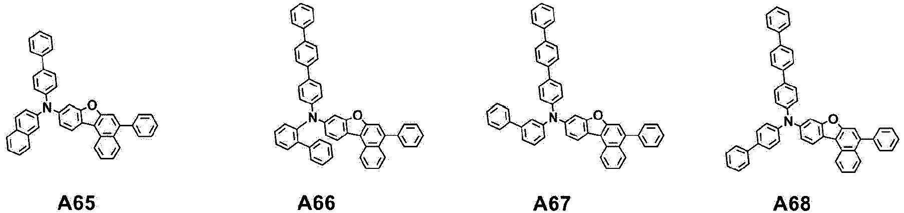

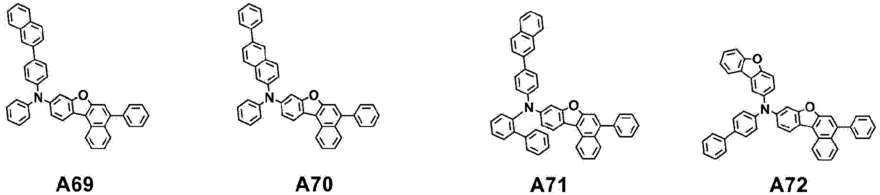

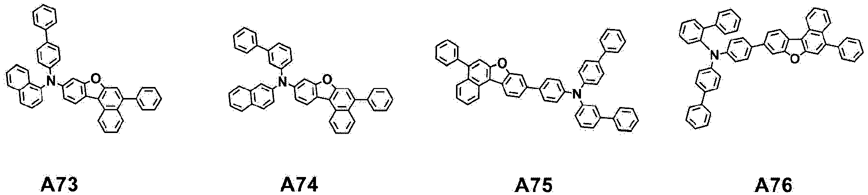

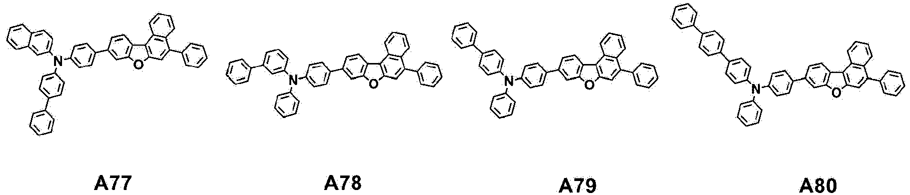

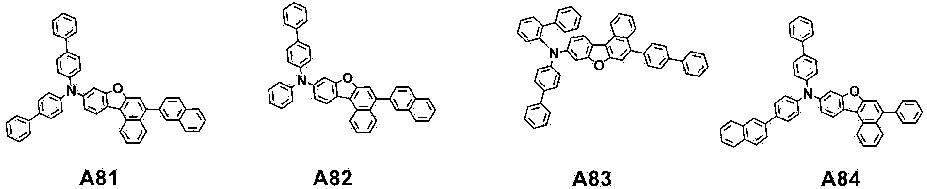

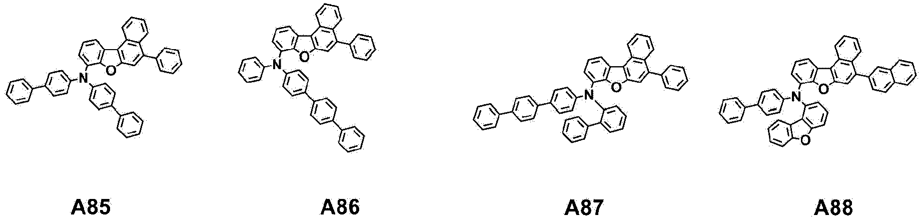

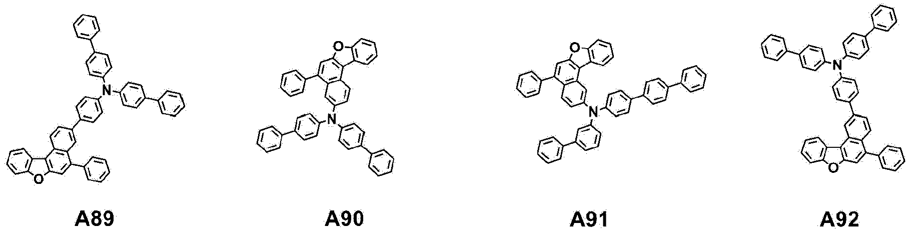

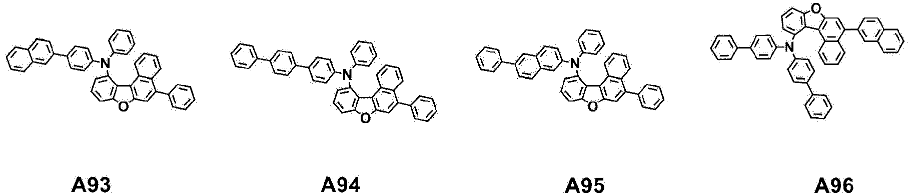

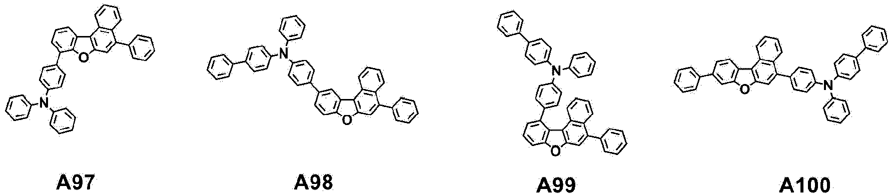

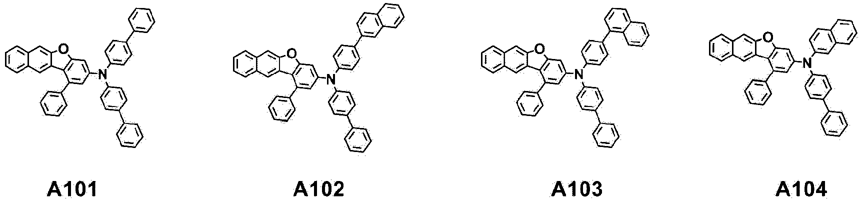

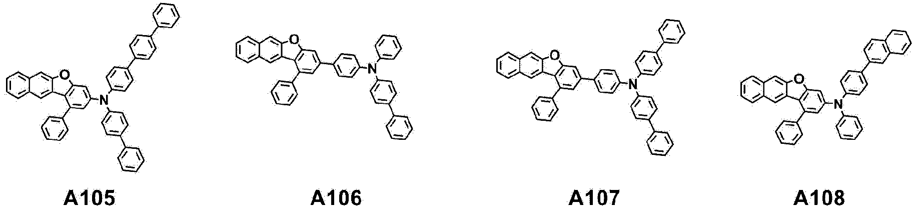

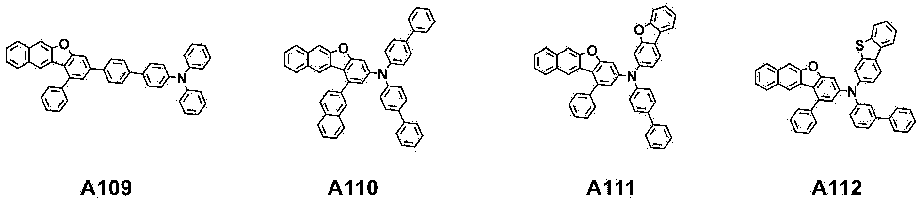

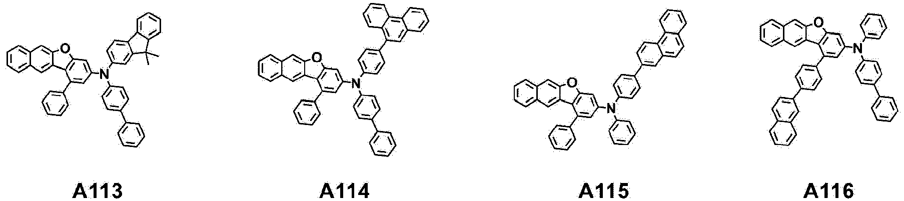

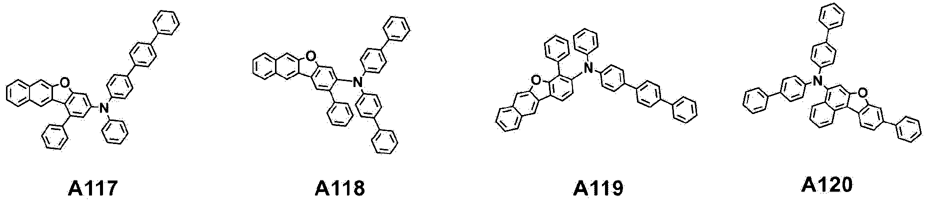

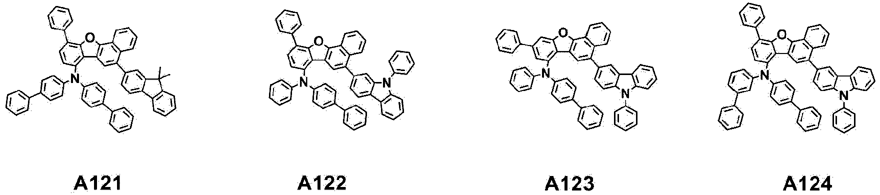

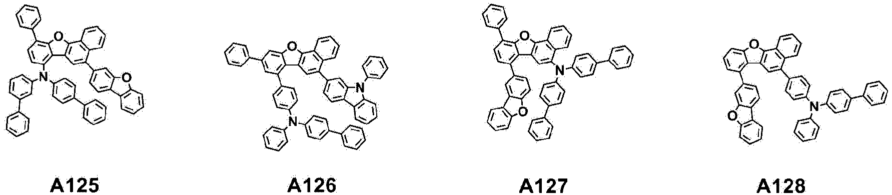

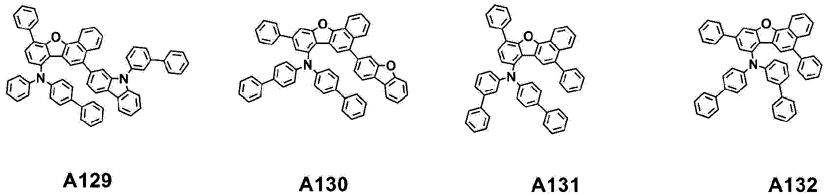

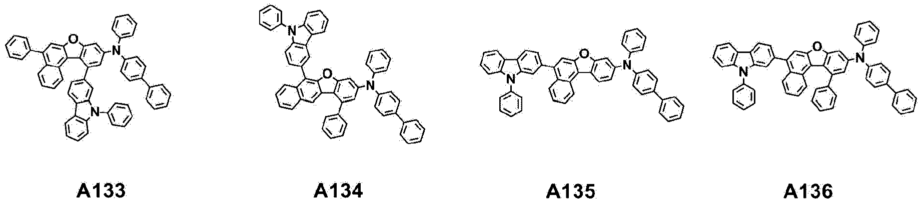

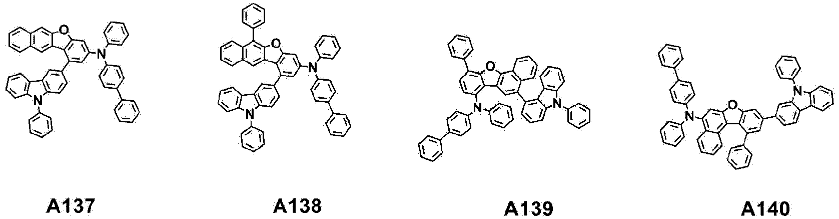

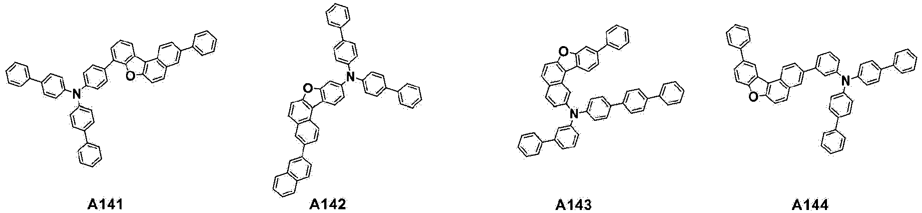

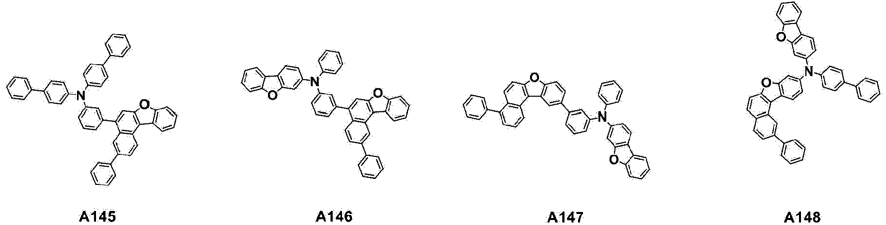

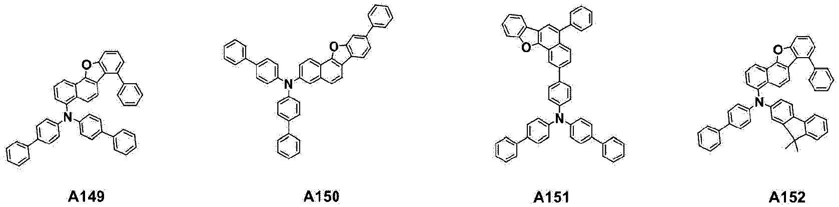

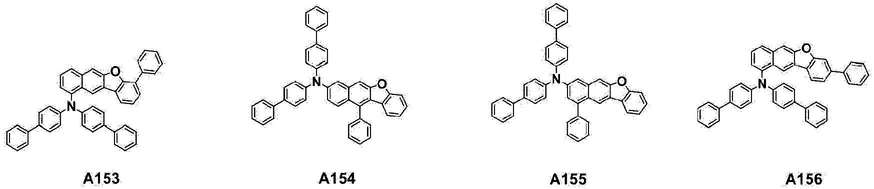

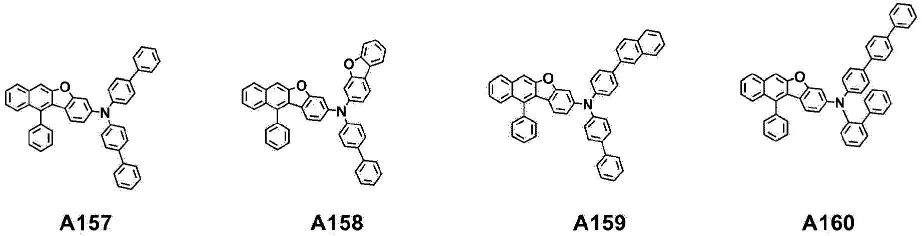

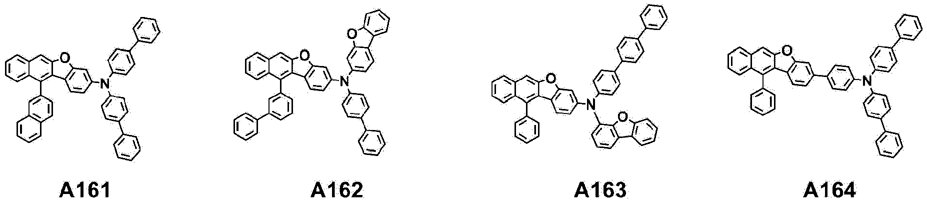

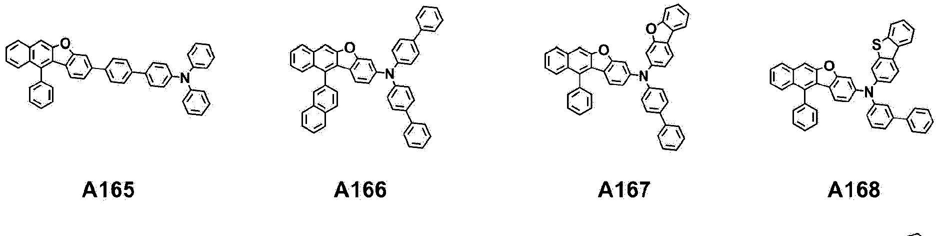

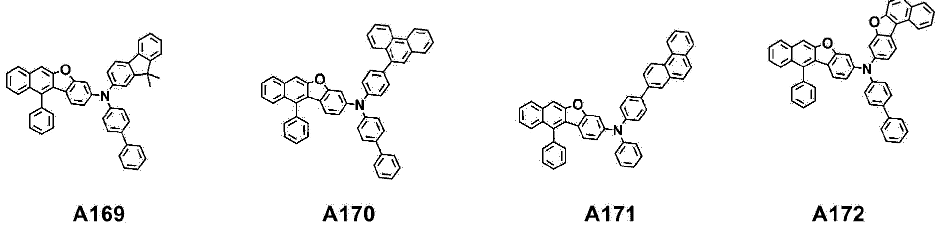

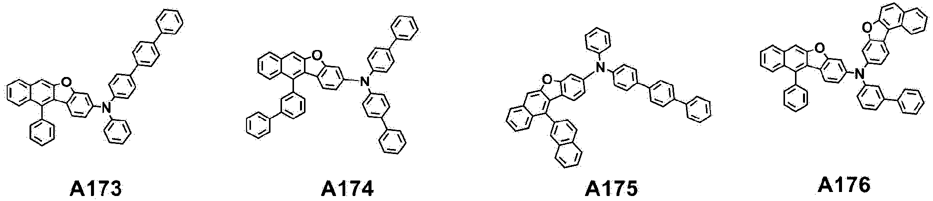

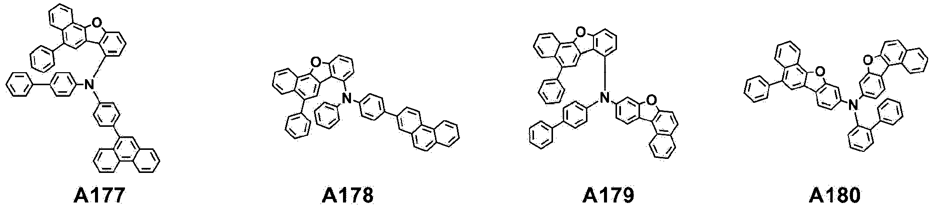

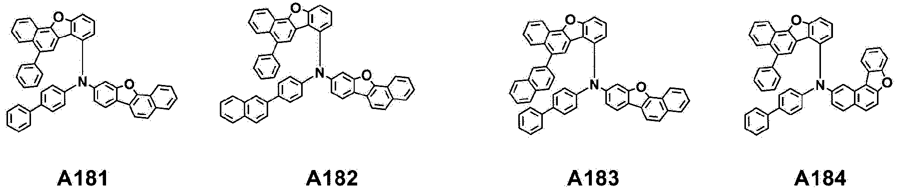

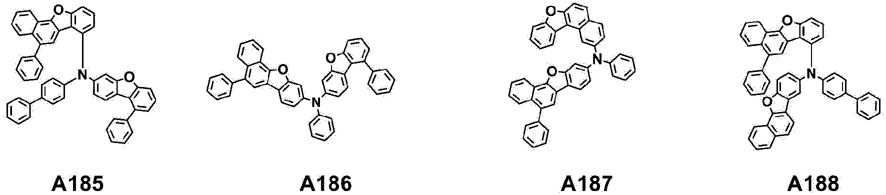

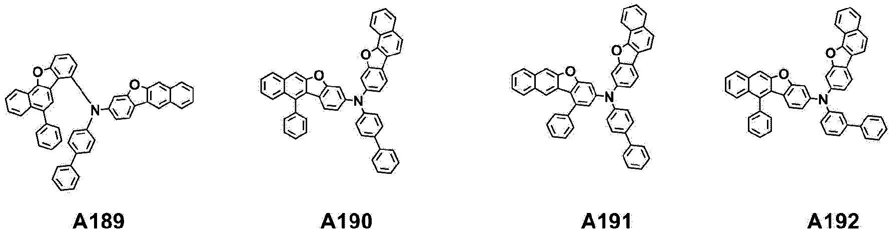

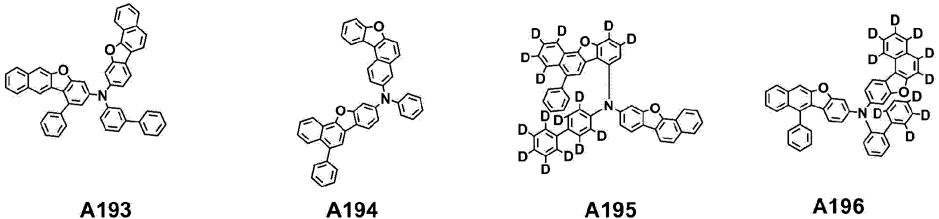

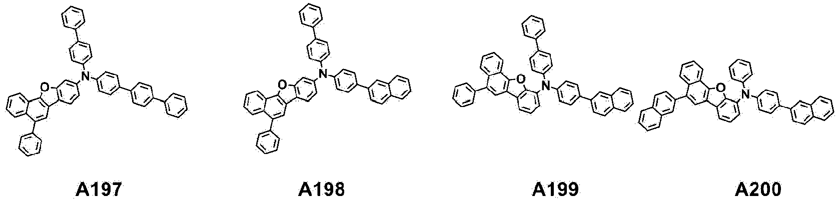

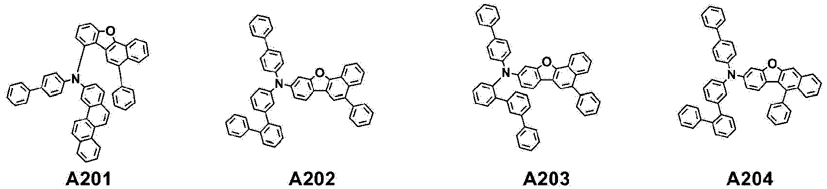

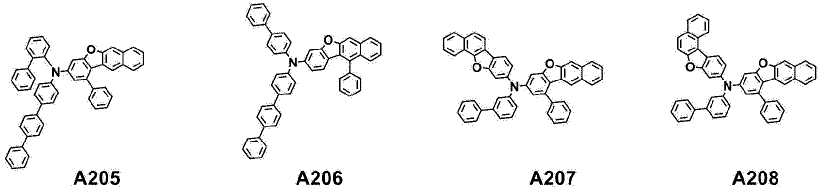

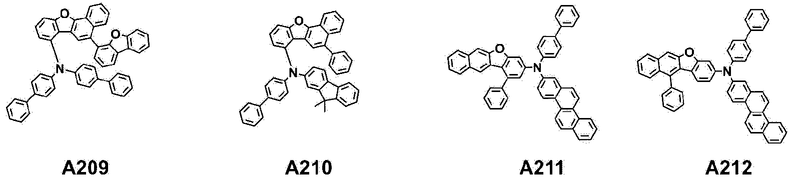

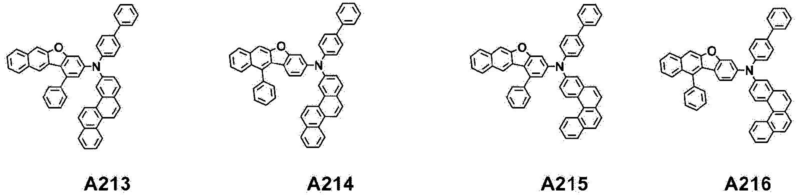

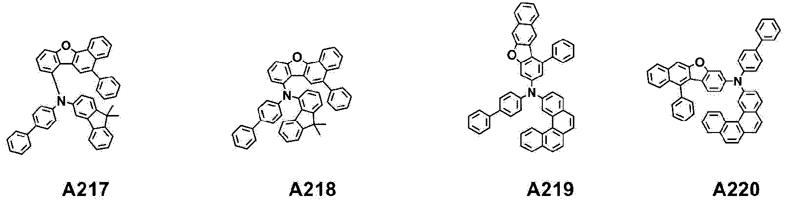

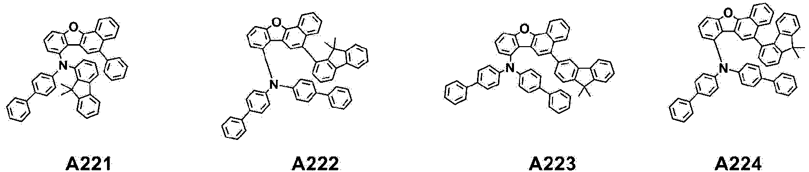

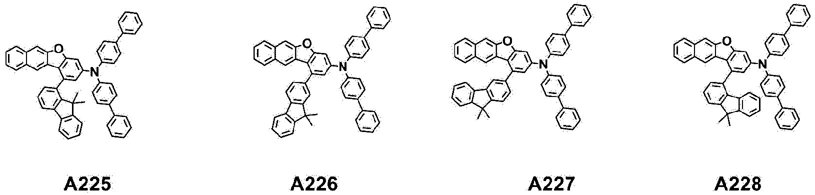

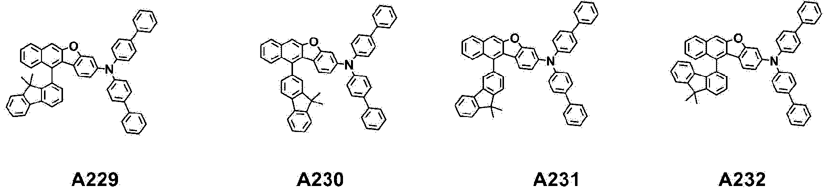

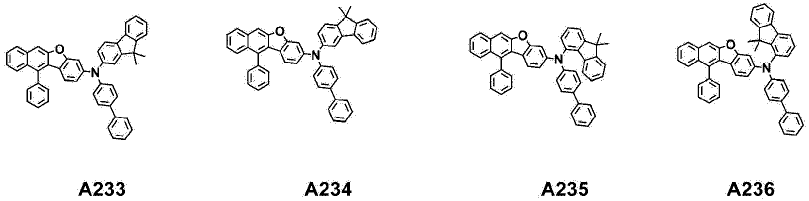

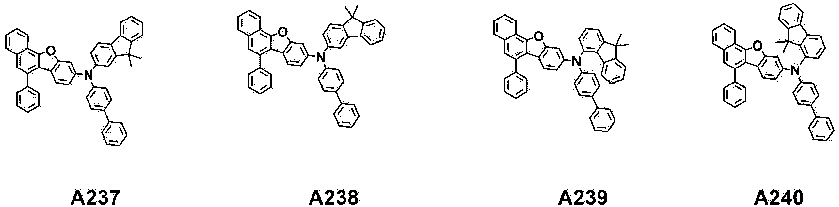

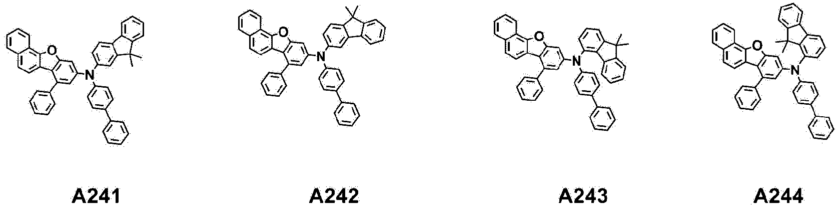

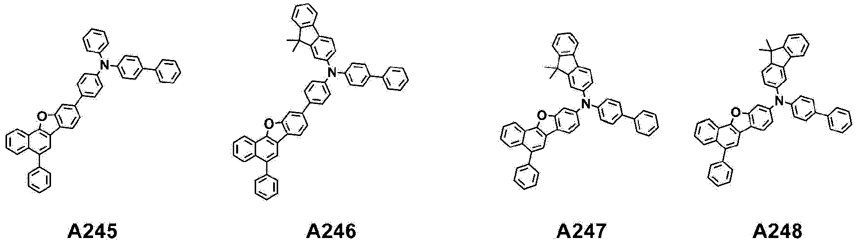

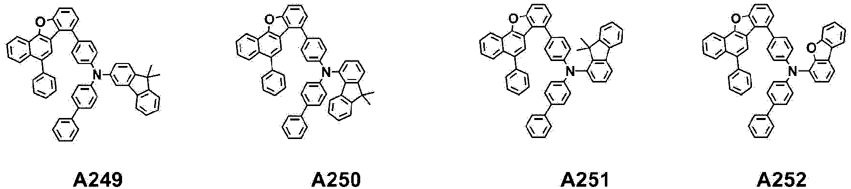

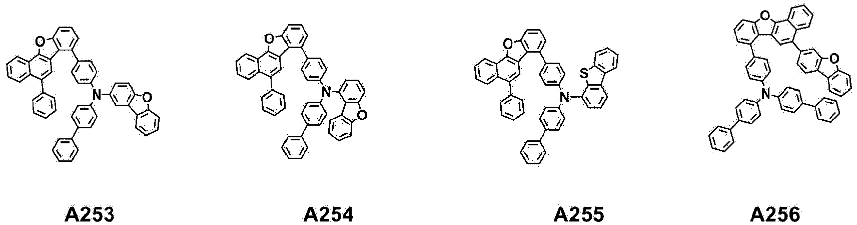

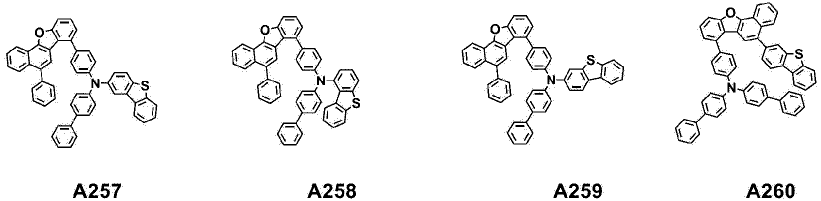

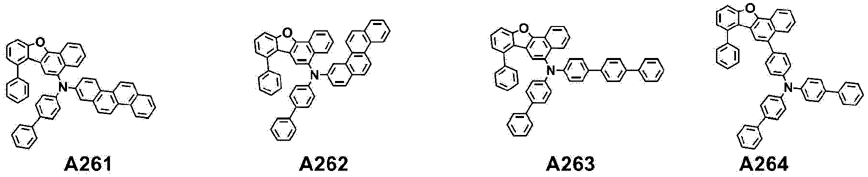

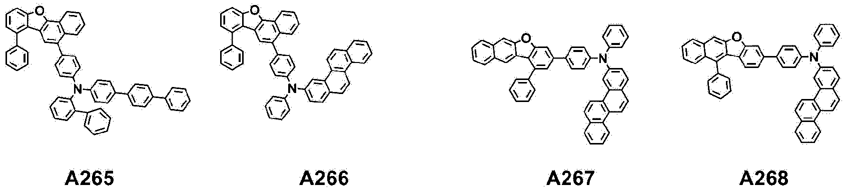

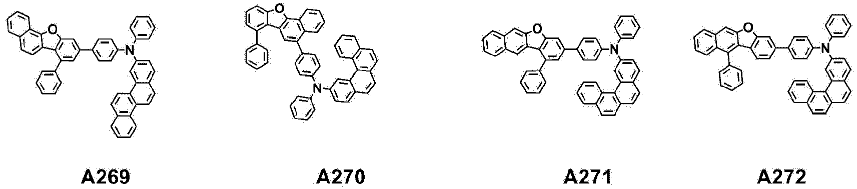

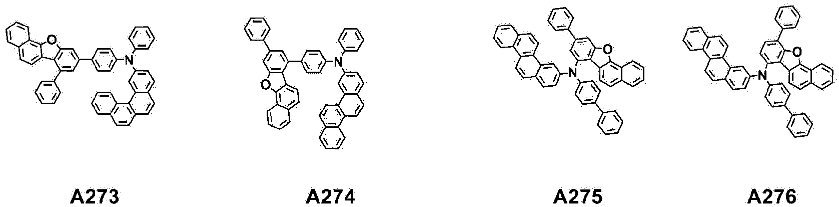

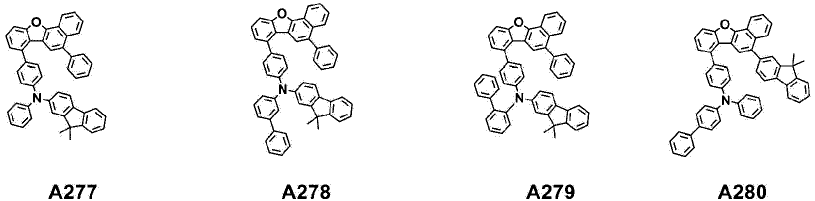

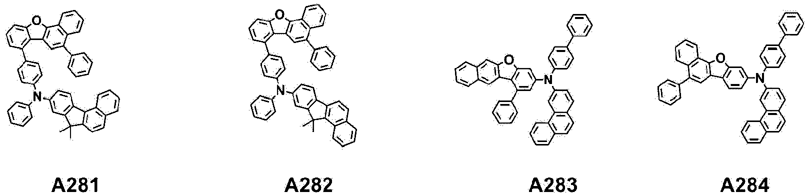

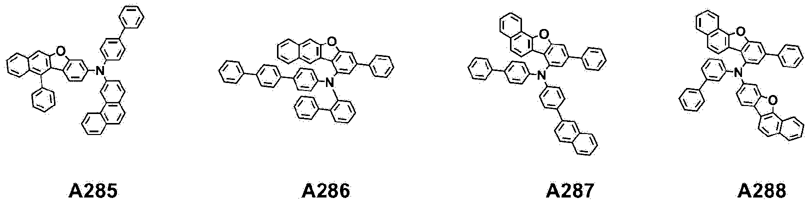

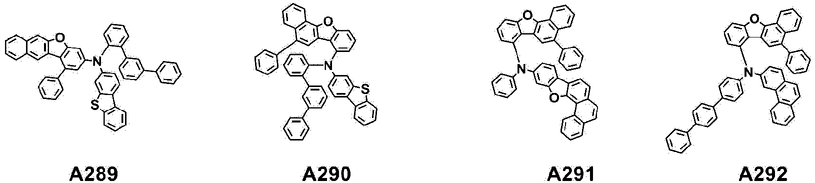

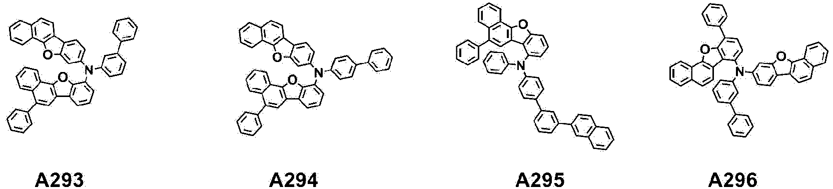

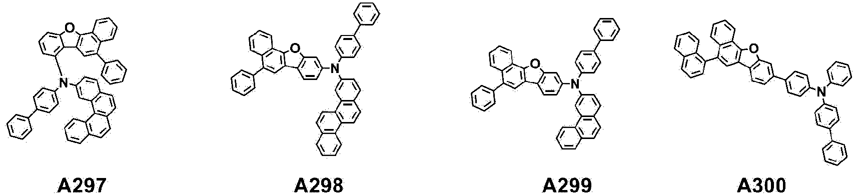

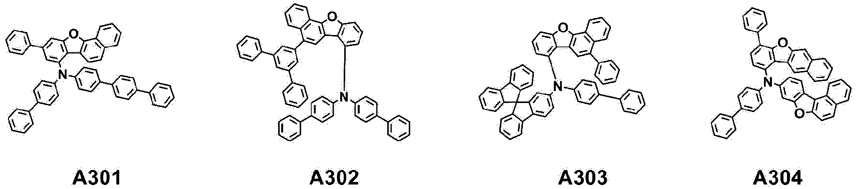

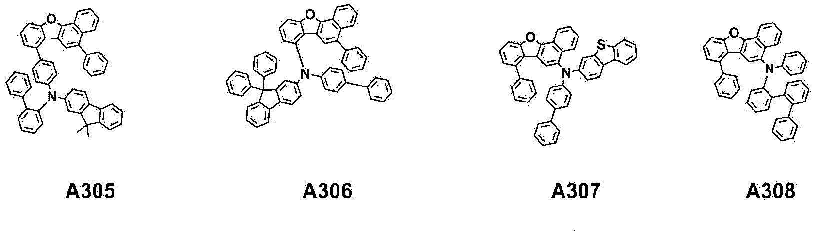

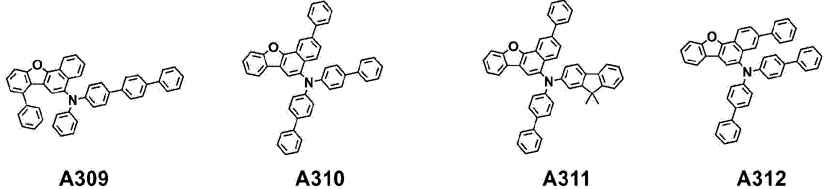

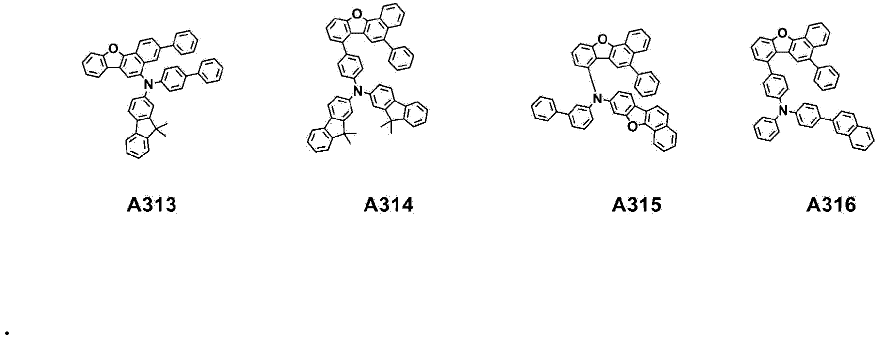

11. The organic light emitting device of claim 1, wherein the second heterocyclic compound and the third heterocyclic compound are different from each other, and are each selected from the following: 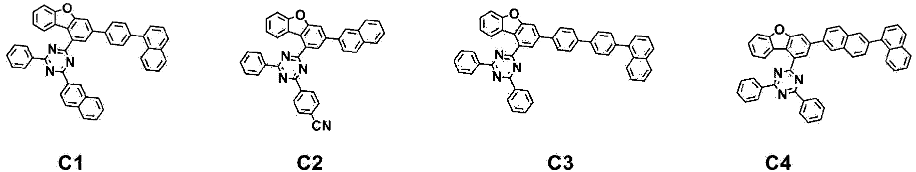 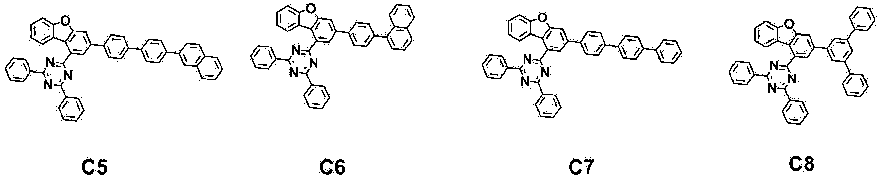 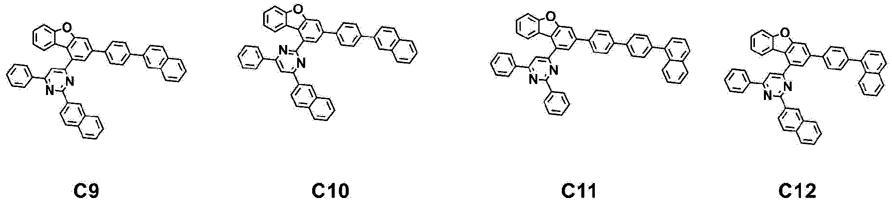 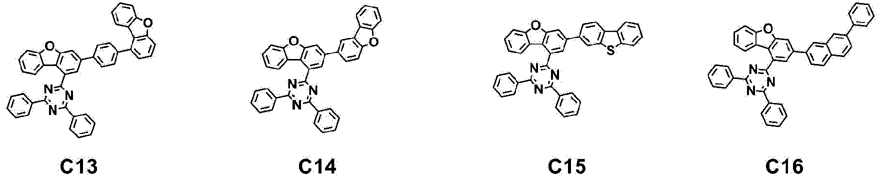 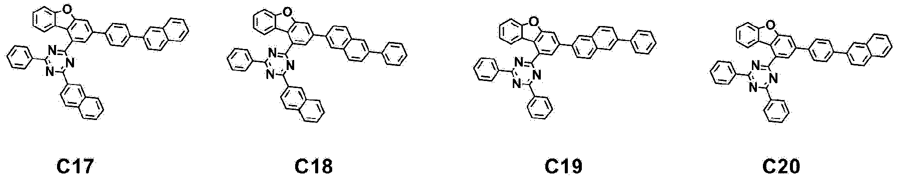 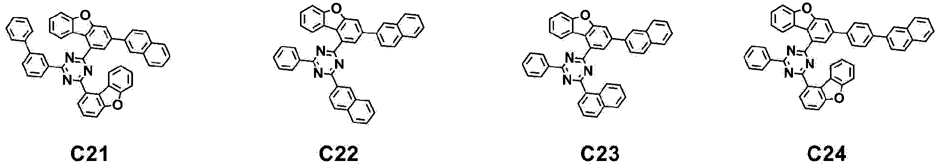 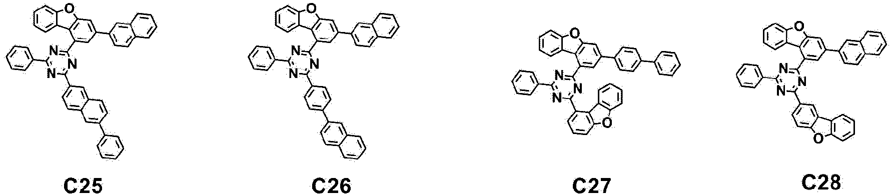 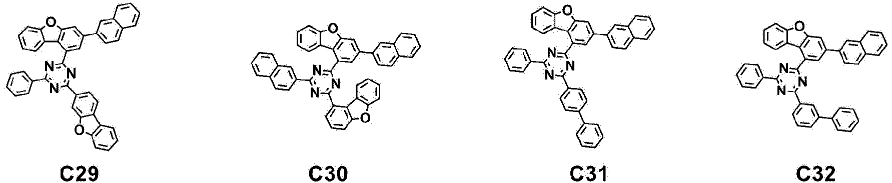 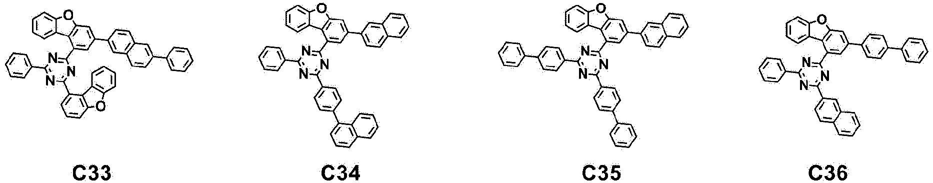 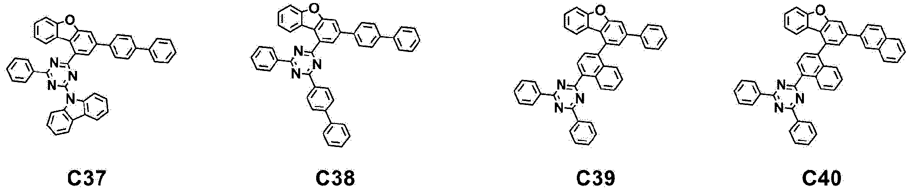 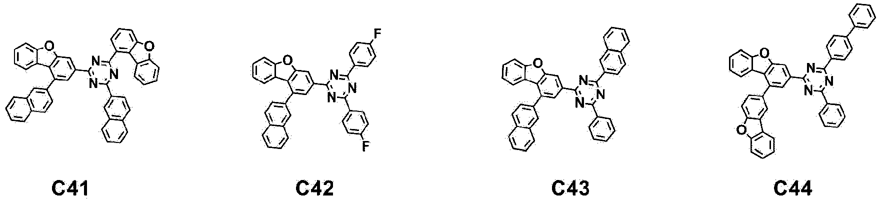 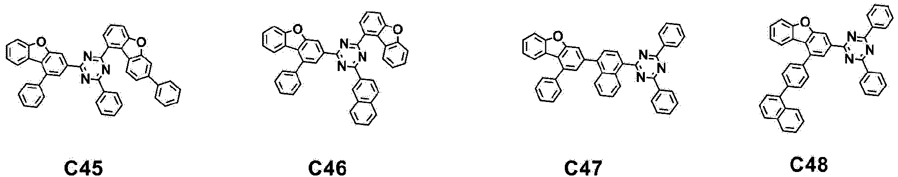 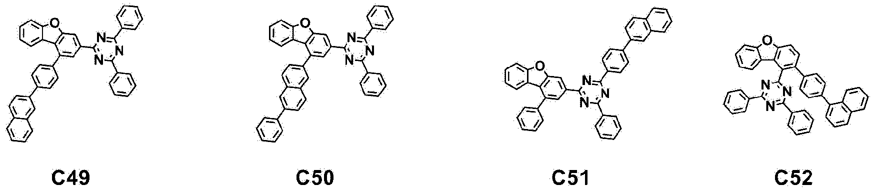 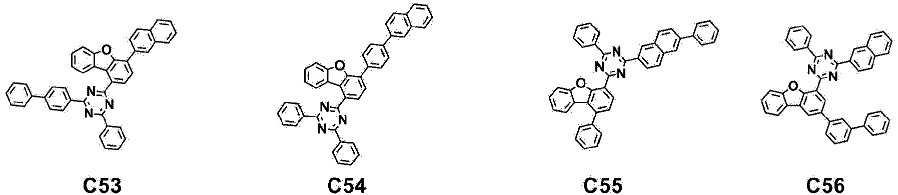 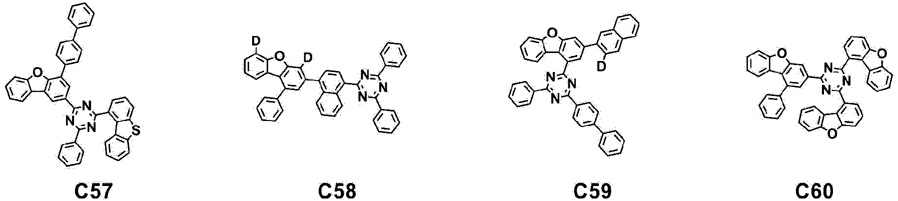 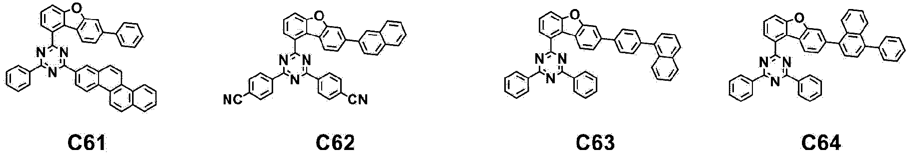 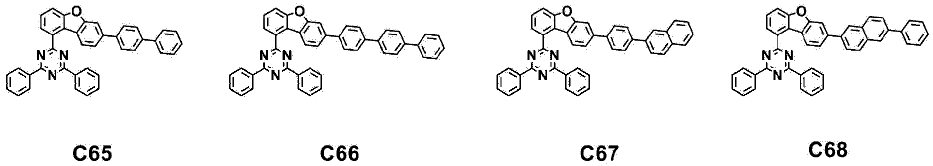 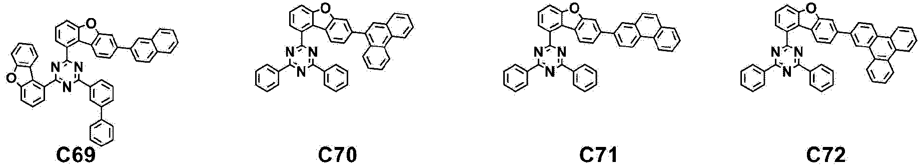 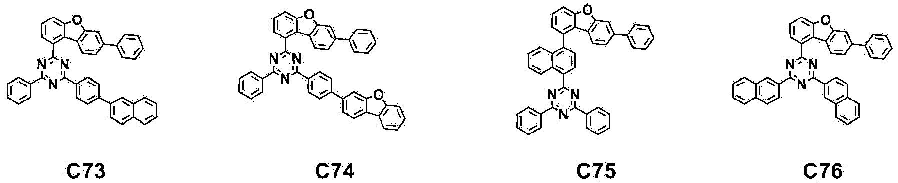 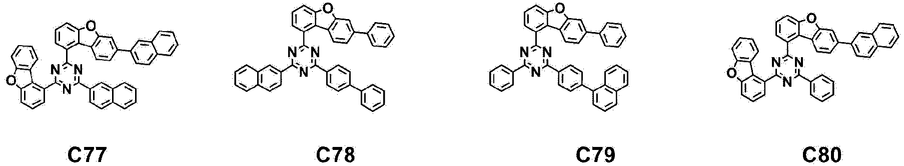 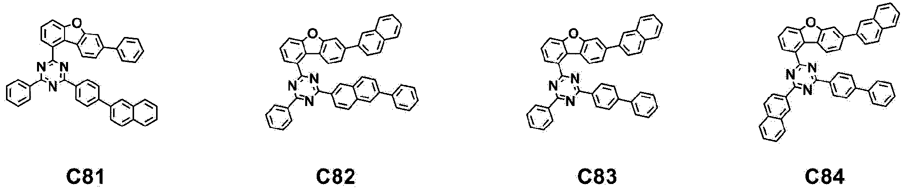 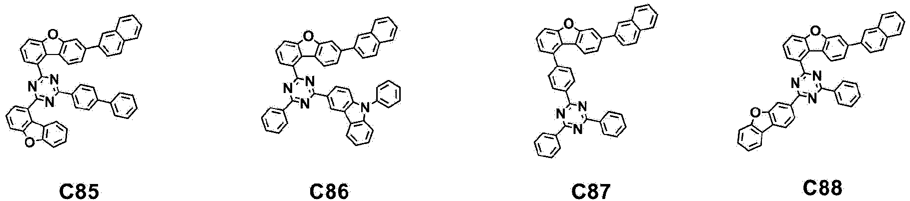 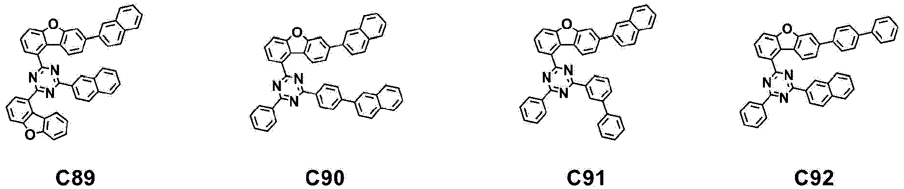 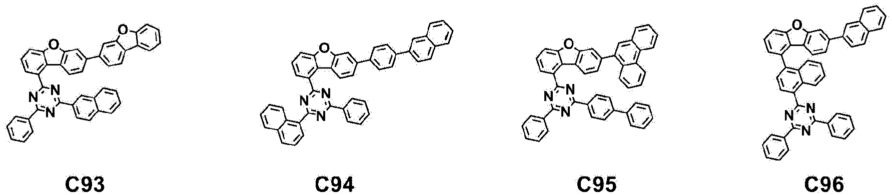 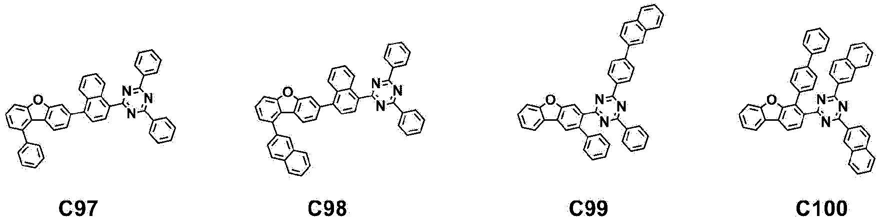 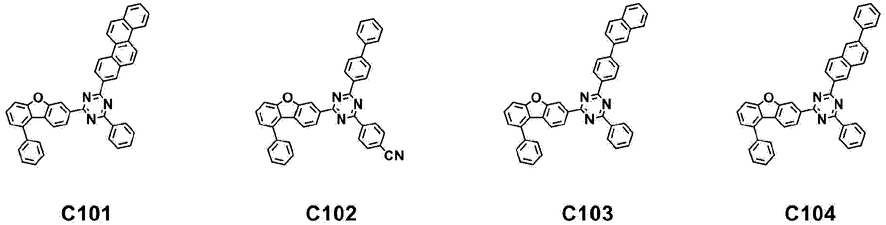 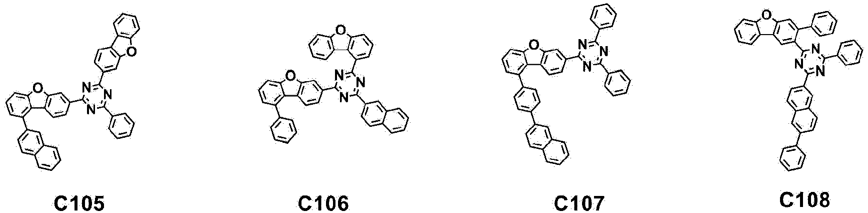 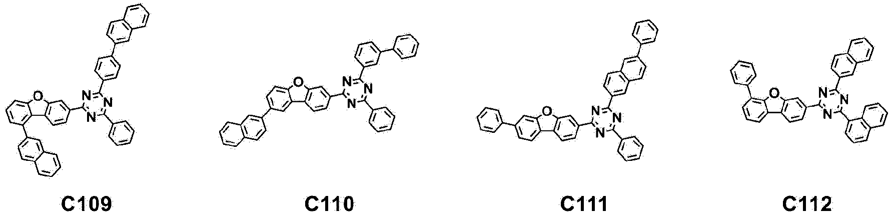 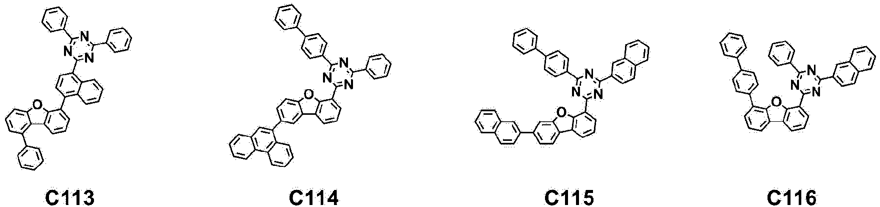 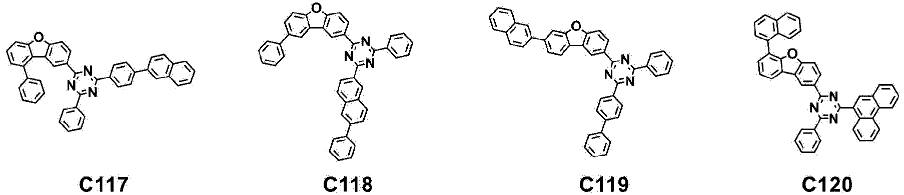 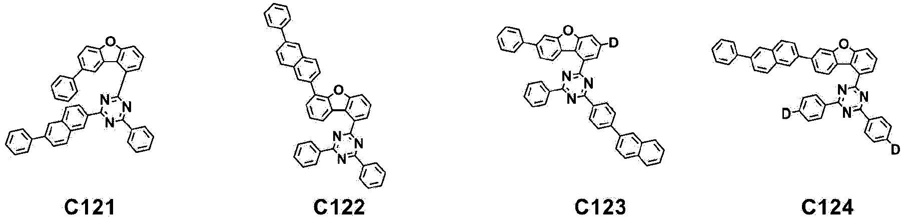 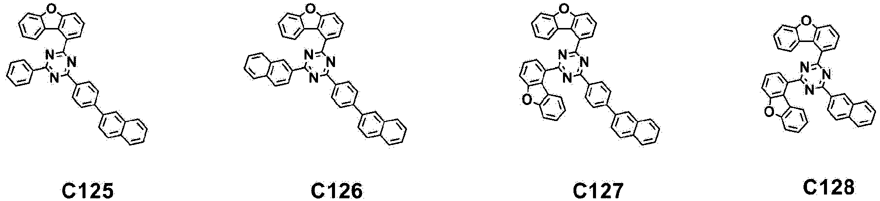 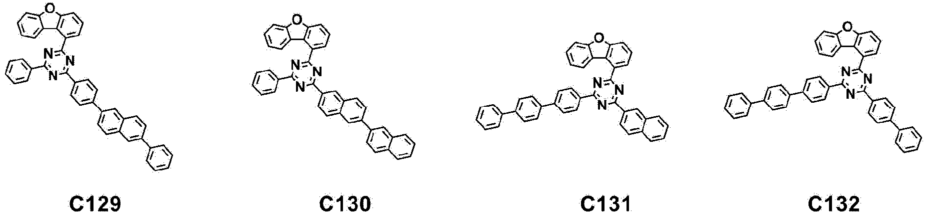 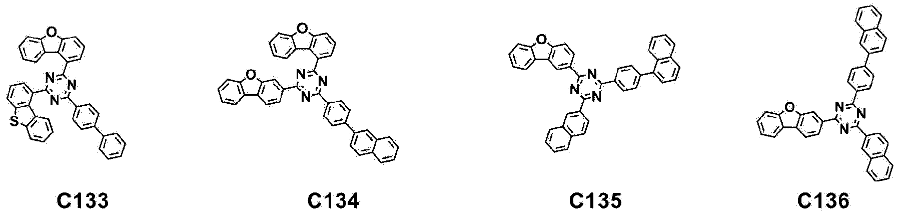 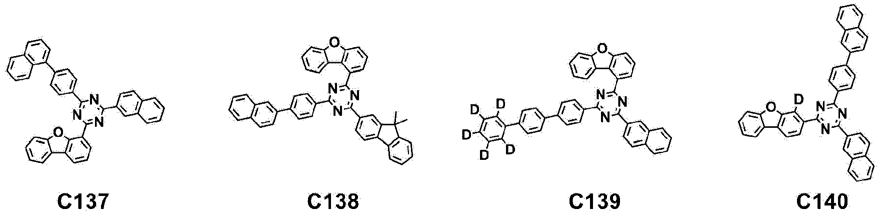 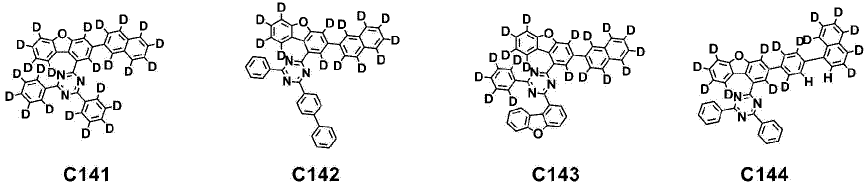 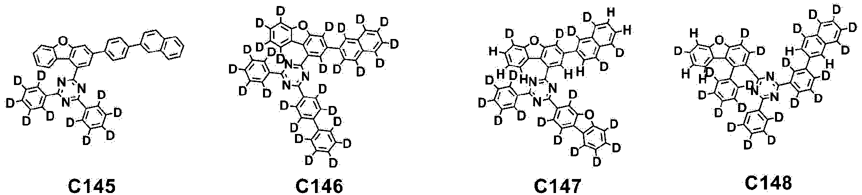 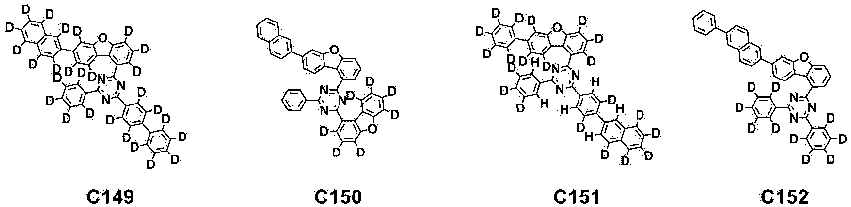 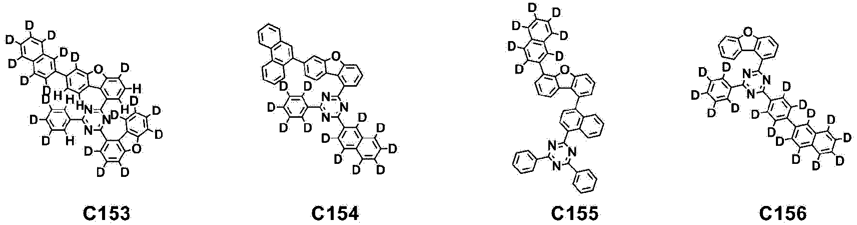 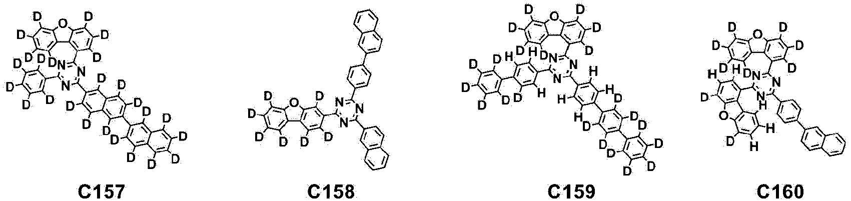 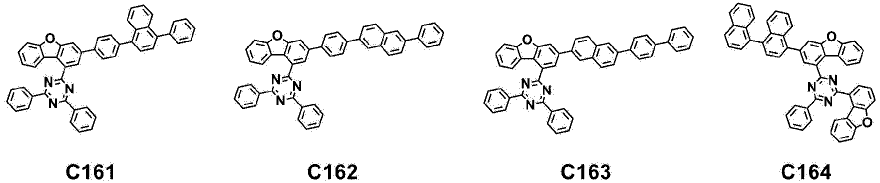 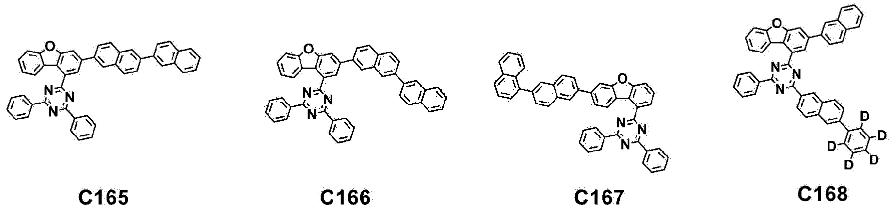 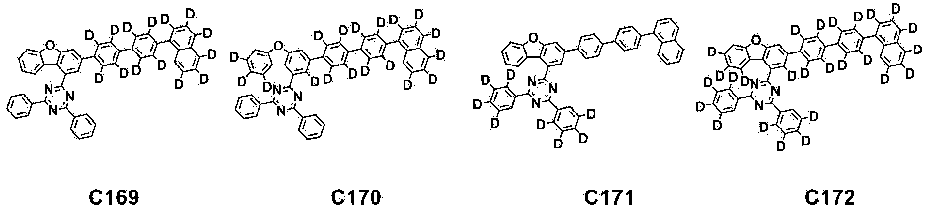 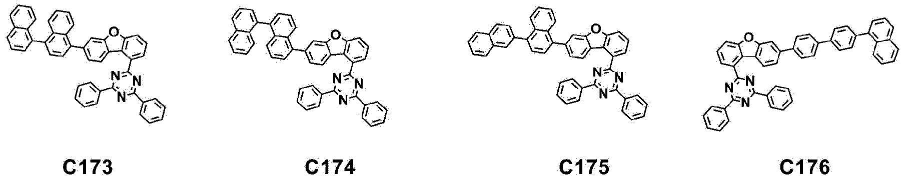 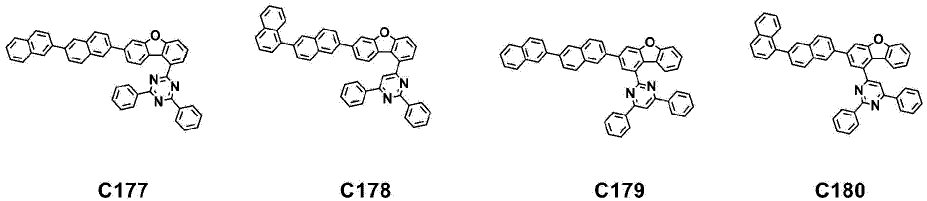 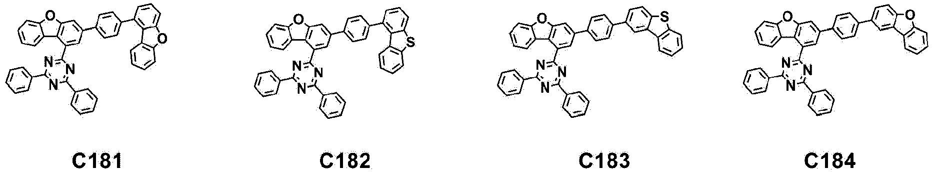 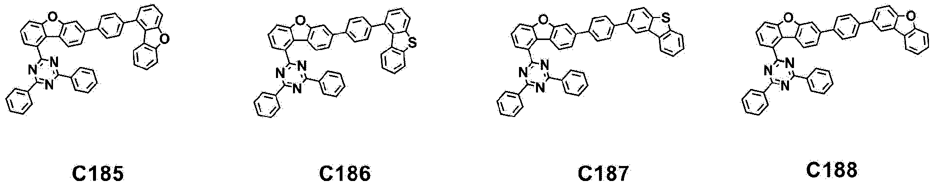 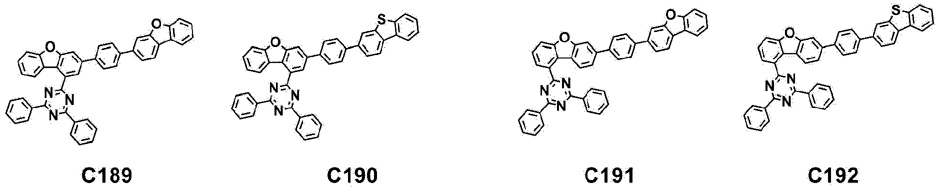 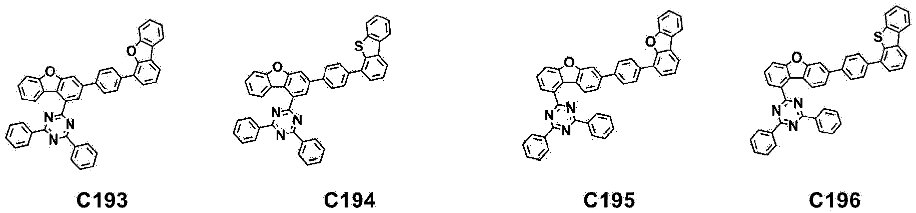 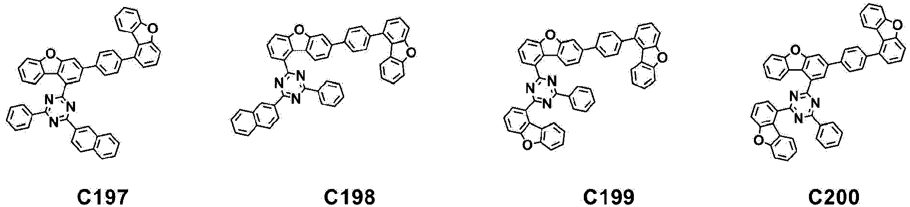 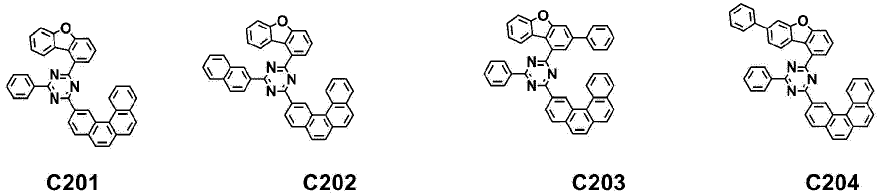 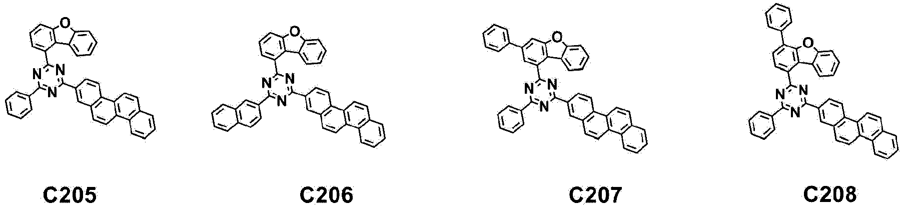 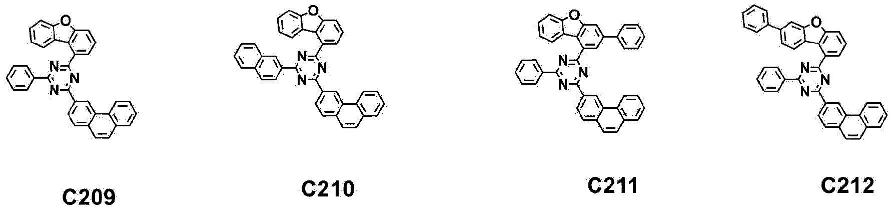 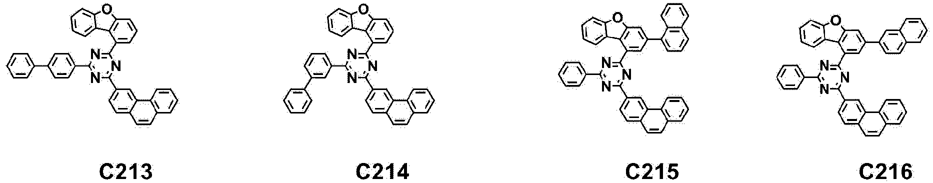 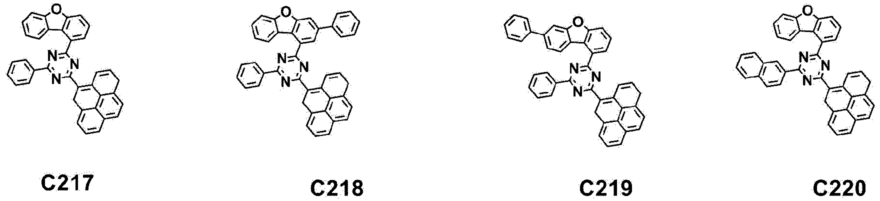 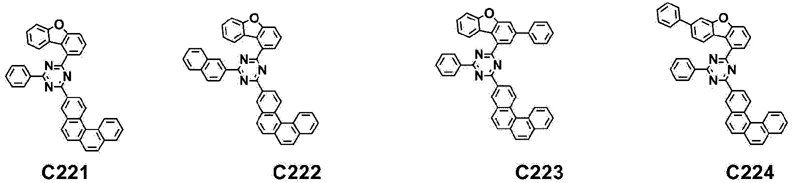 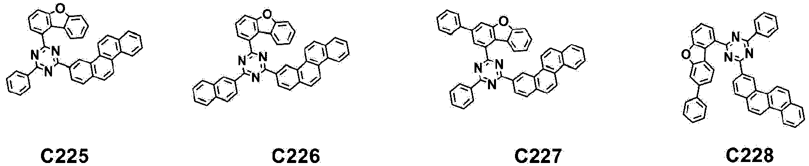 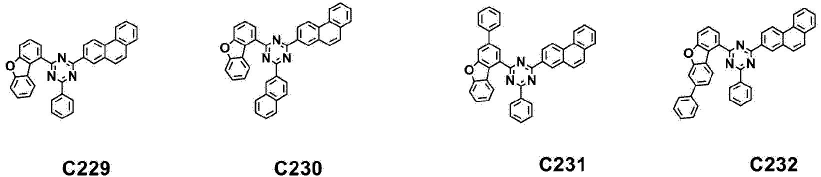 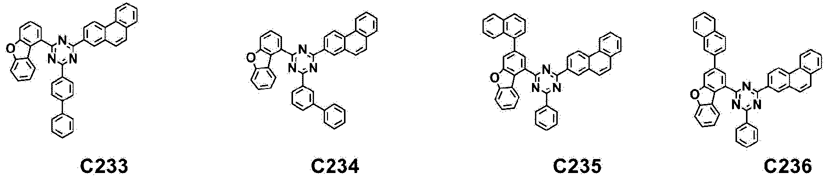 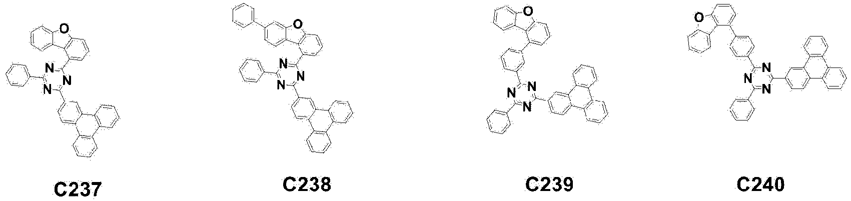 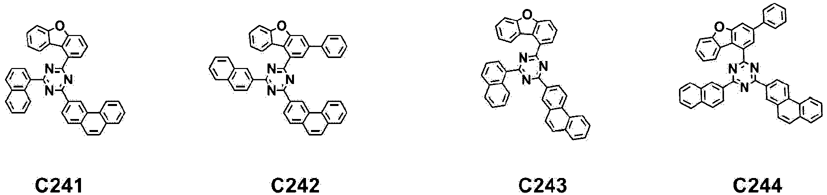 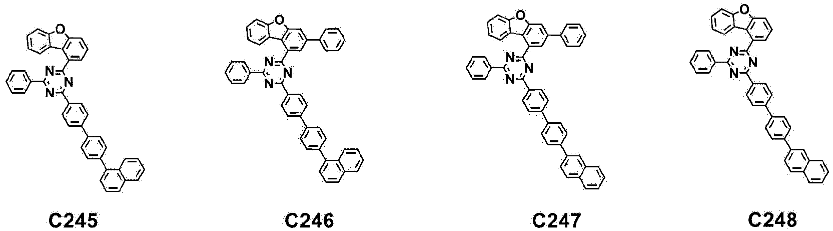 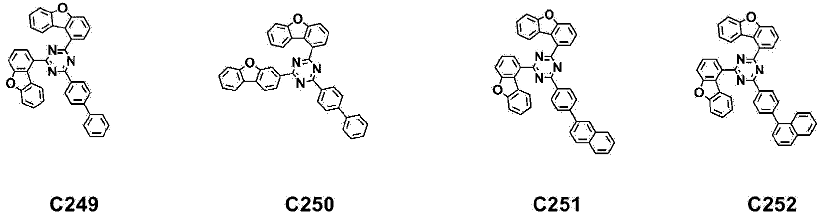 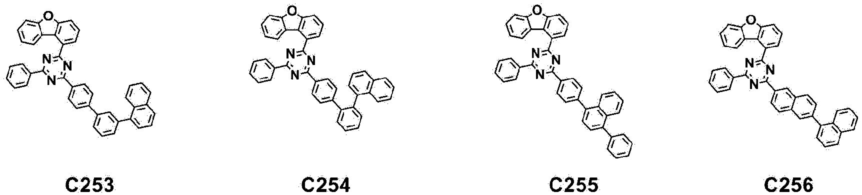 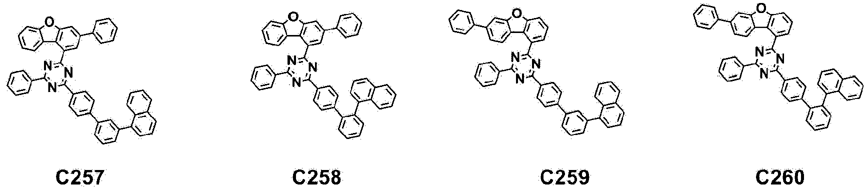 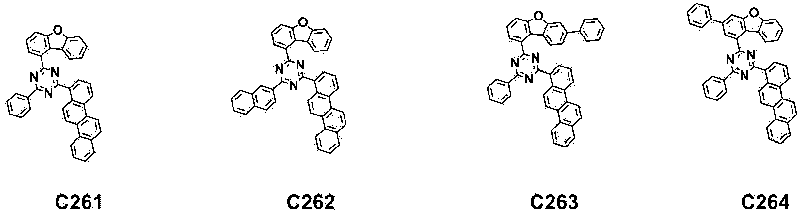 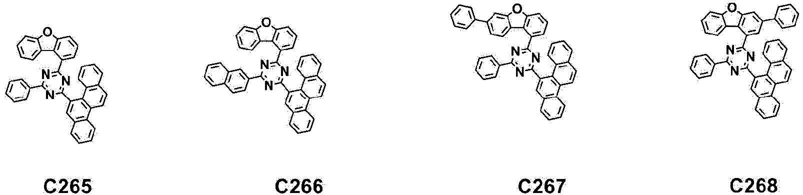 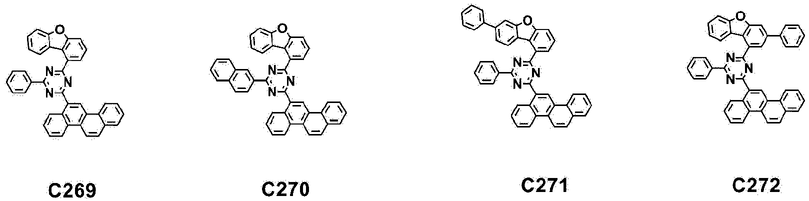 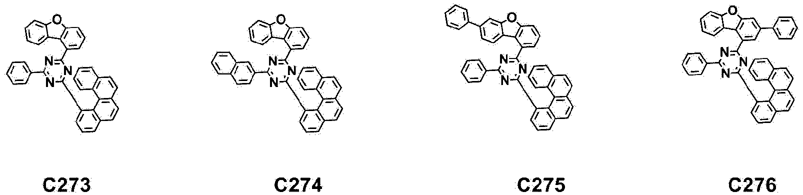 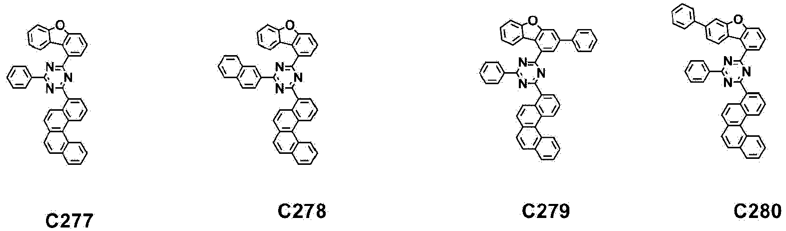 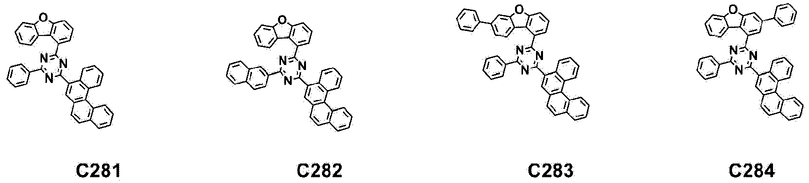 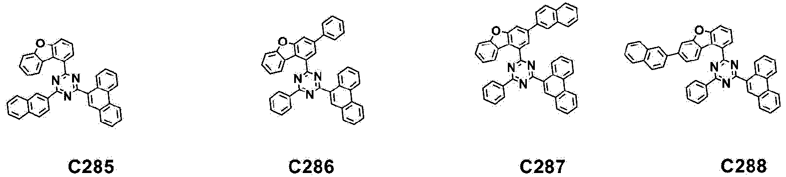 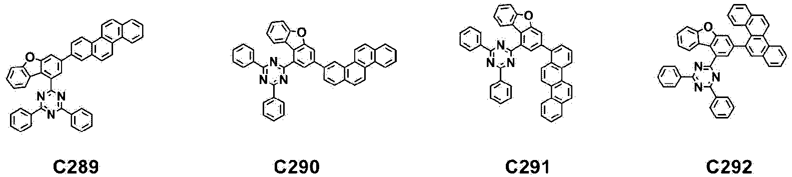 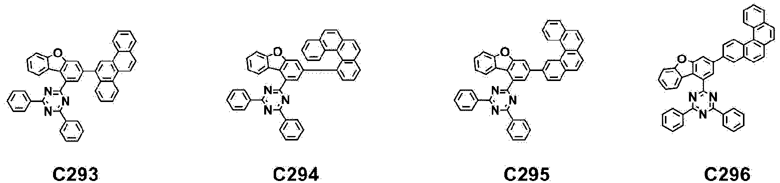 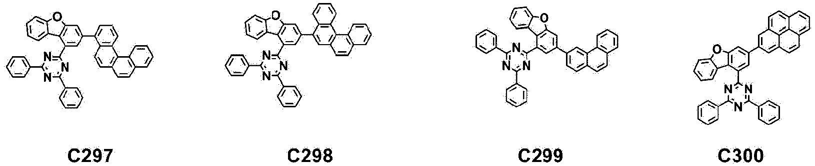 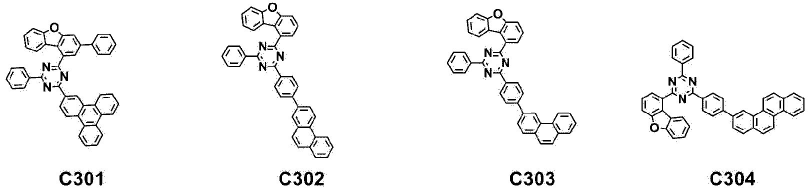 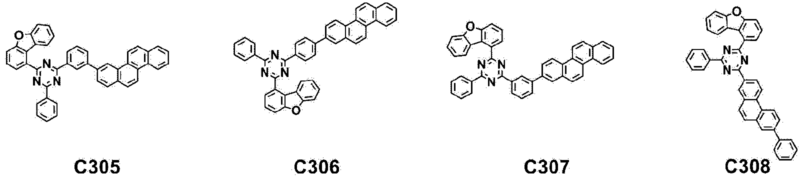 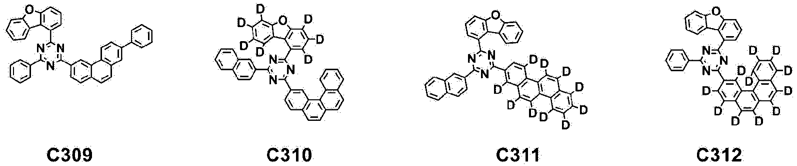 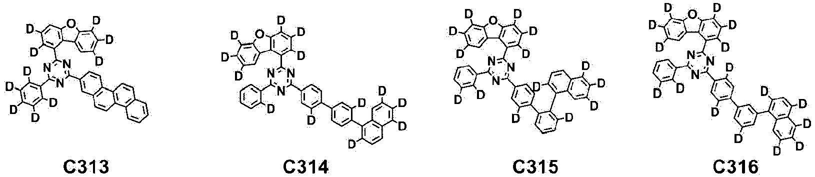 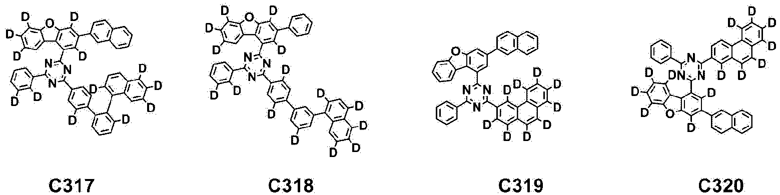 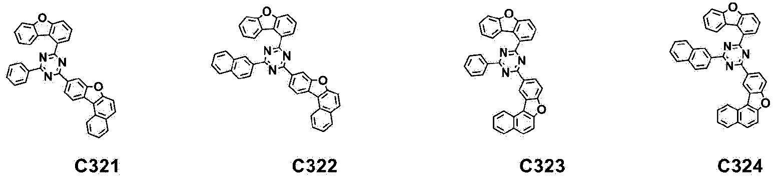 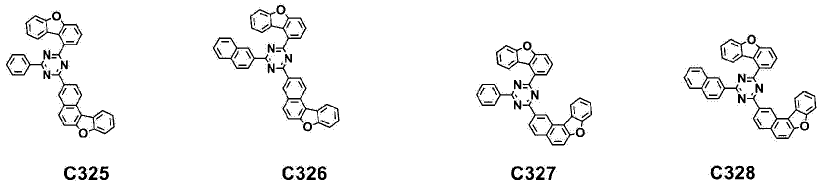 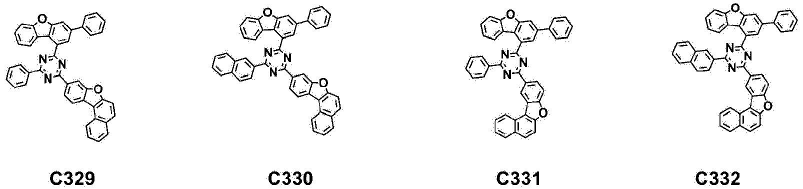 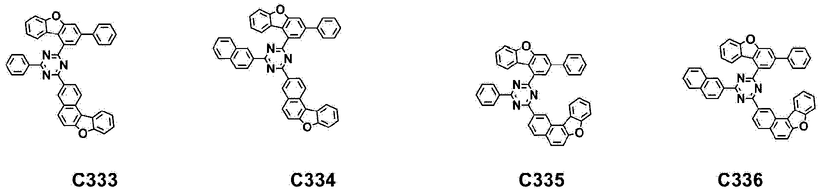 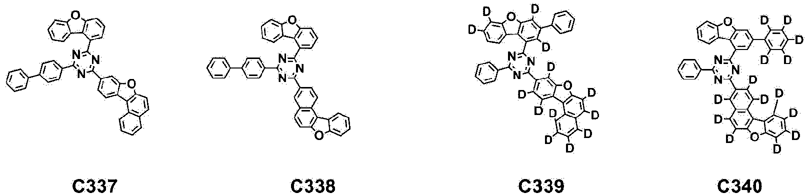 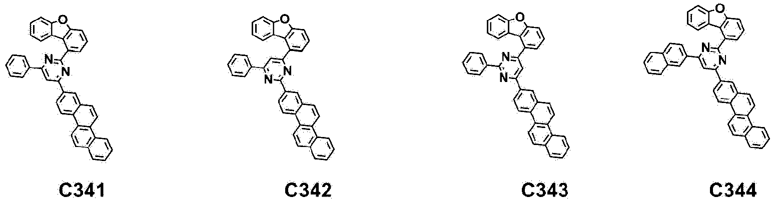 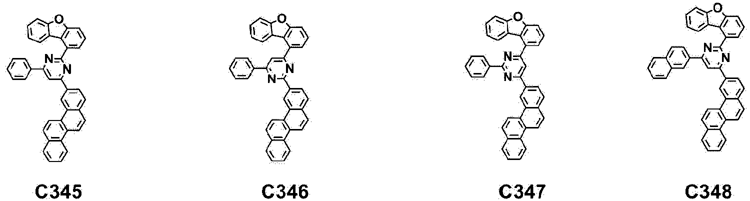 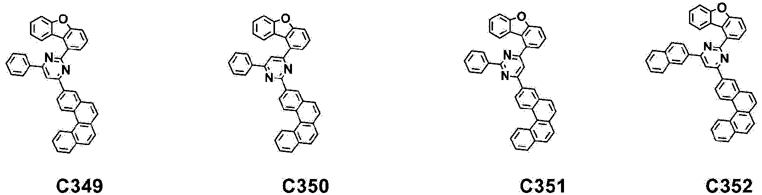 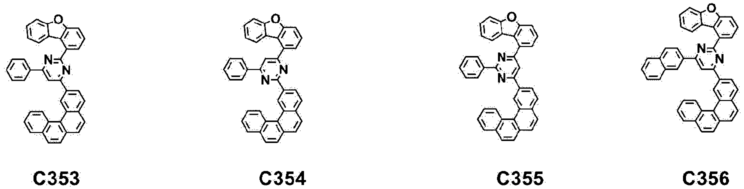 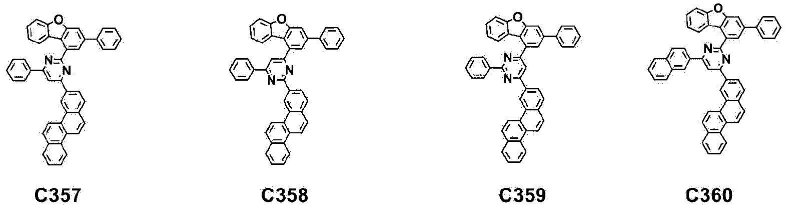 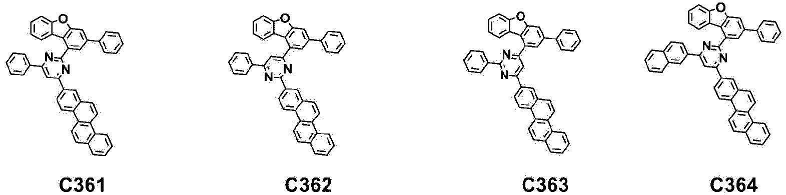 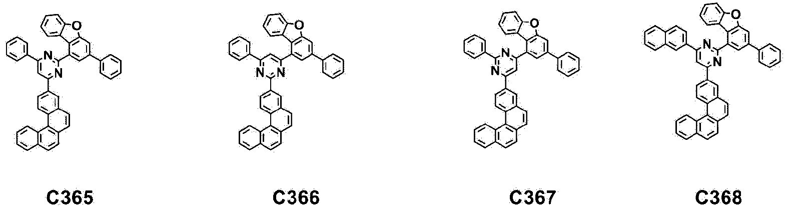 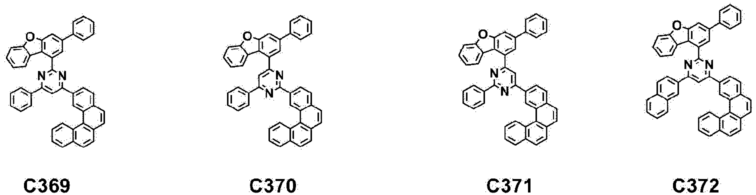 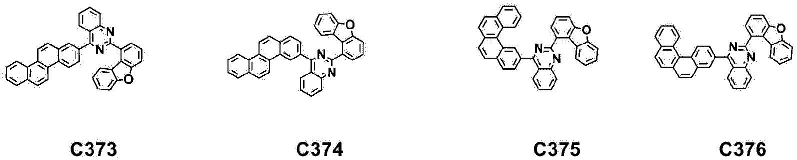 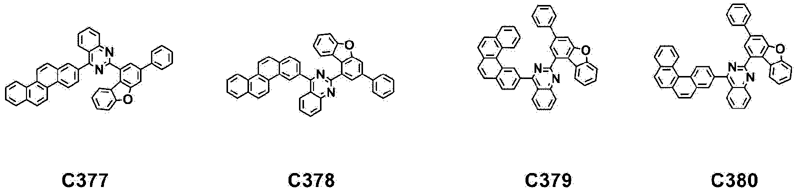 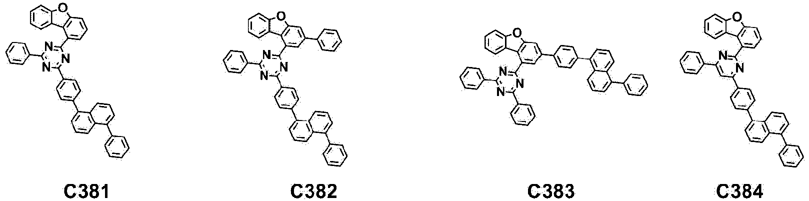 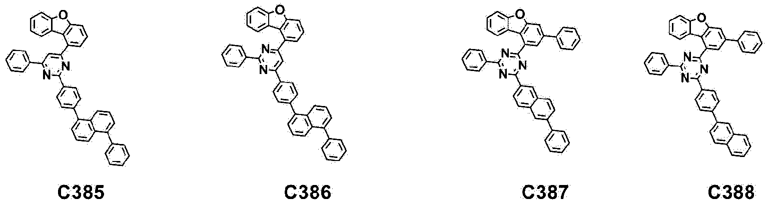 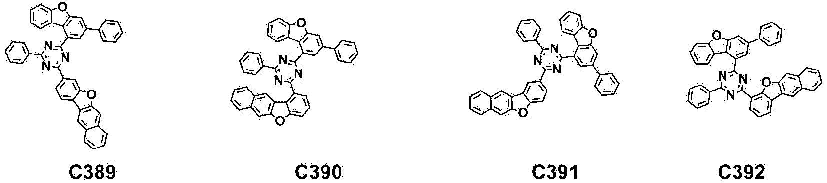 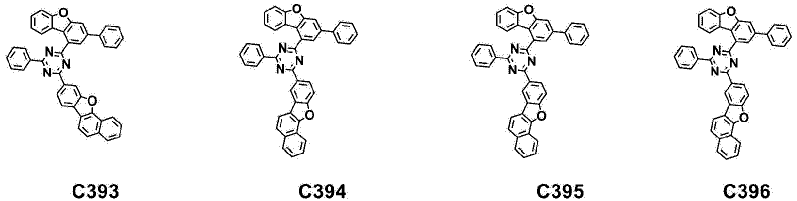 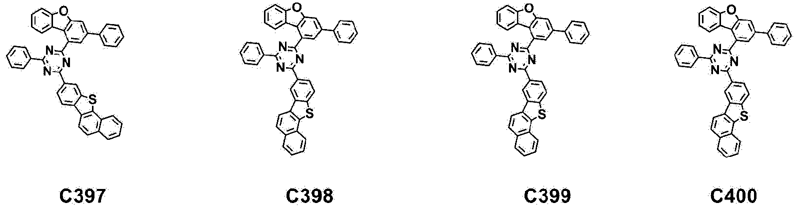 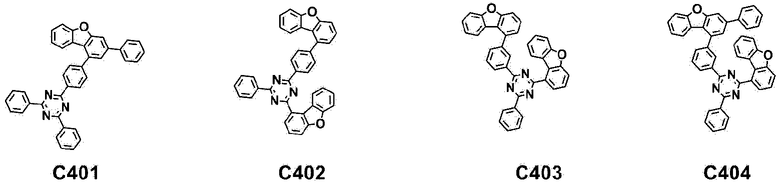 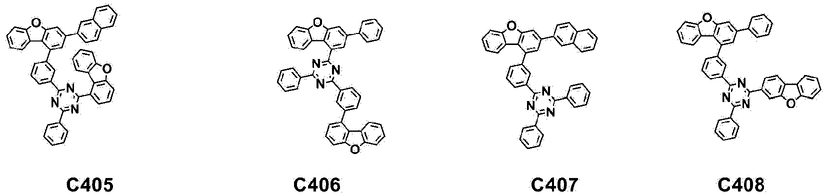 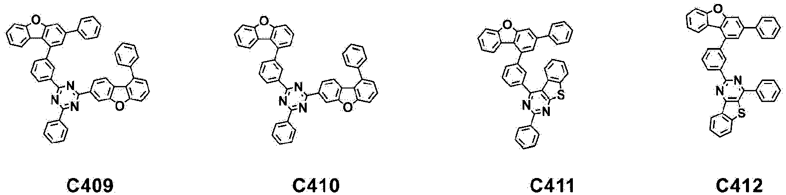 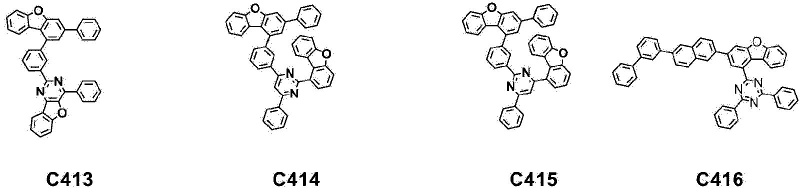 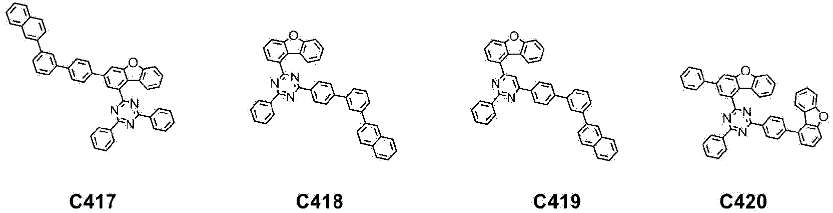 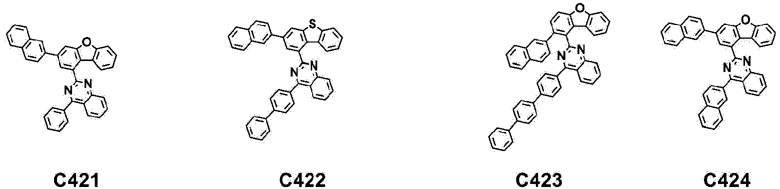 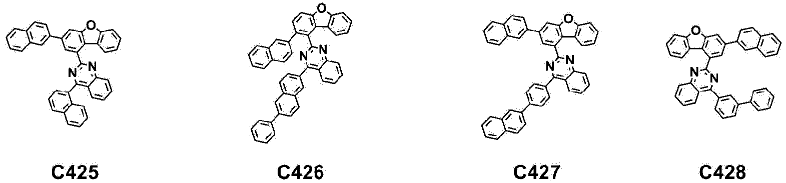 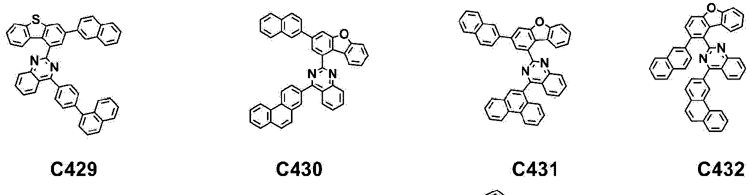 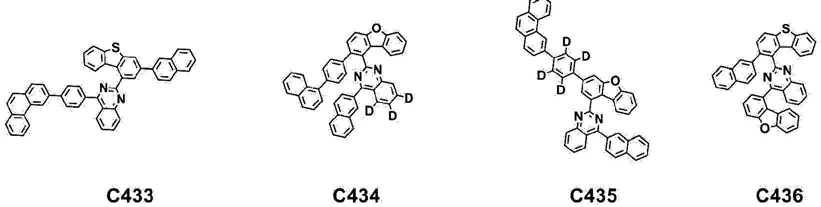 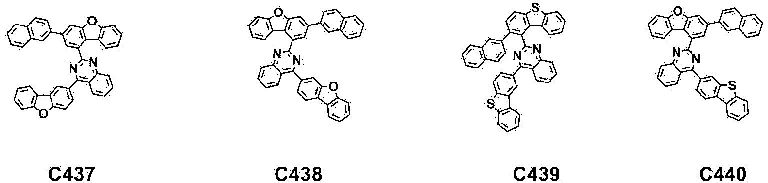 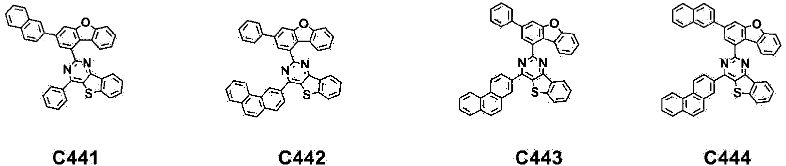 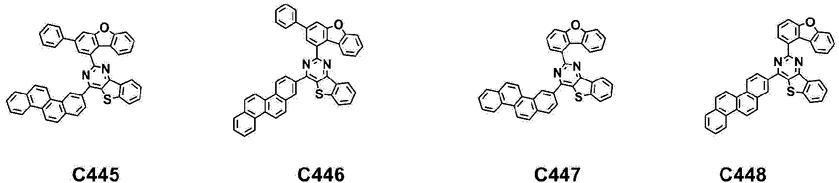 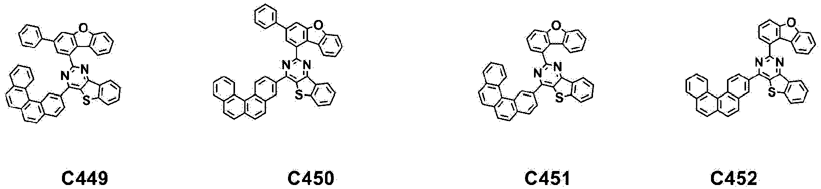 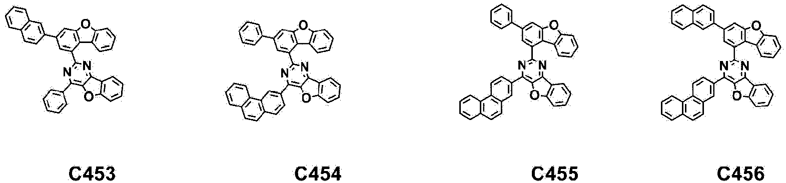 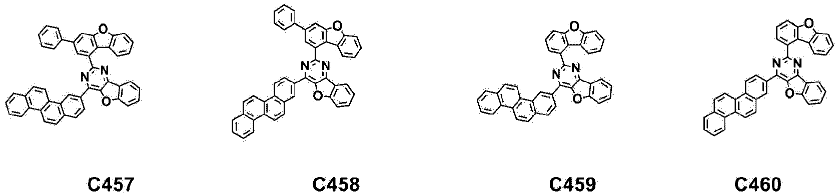 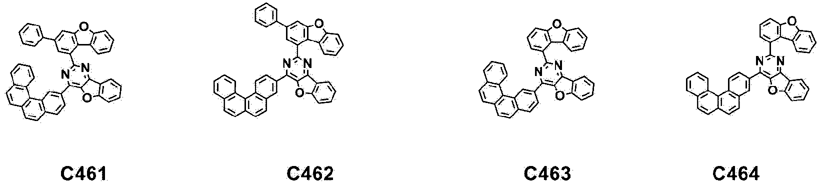 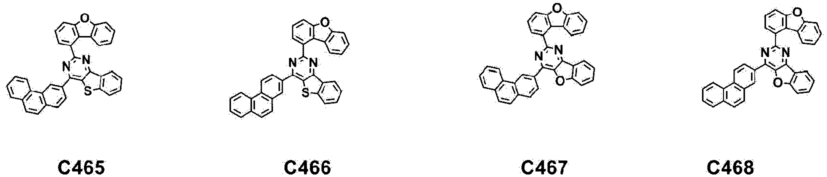 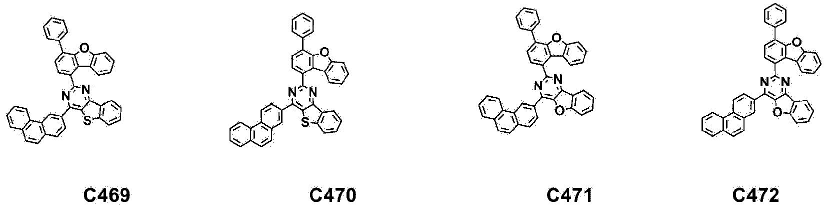 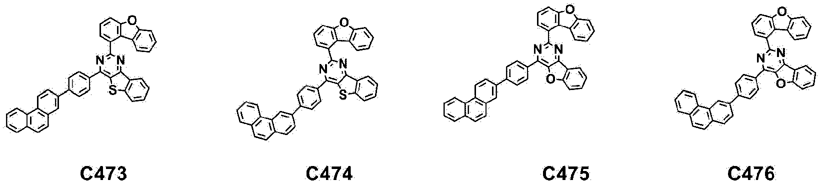 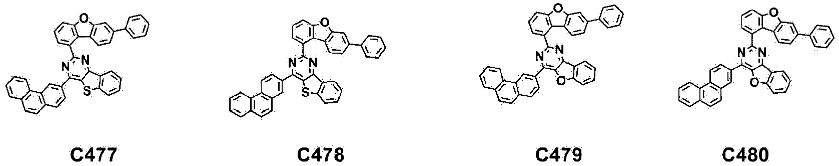 .

12. The organic light emitting device of claim 1, wherein the organic material layer comprises a light emitting layer, and
the light emitting layer comprises the first heterocyclic compound, the second heterocyclic compound, and the third heterocyclic compound.

13. A composition for an organic material layer of an organic light emitting device, comprising a first heterocyclic compound, a second heterocyclic compound, and a third heterocyclic compound,
wherein the first heterocyclic compound is represented by the following Chemical Formula A, and
the second heterocyclic compound and the third heterocyclic compound are different from each other, and are each represented by the following Chemical Formula C: 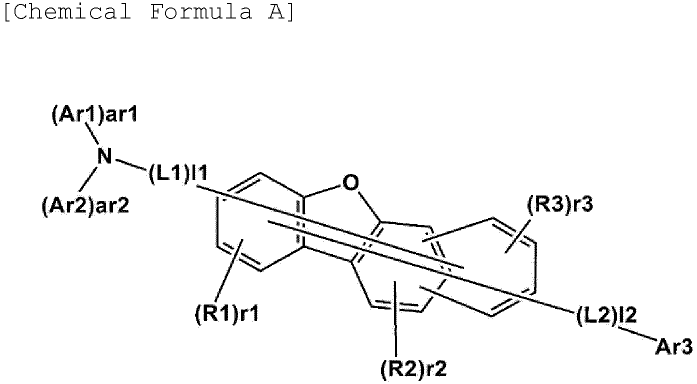 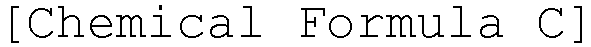 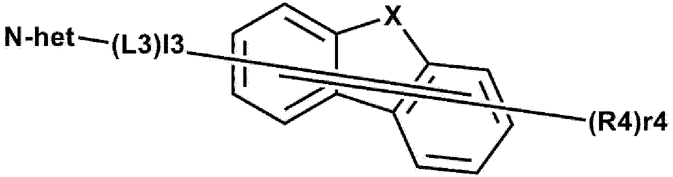
in Chemical Formulae A and C,
L1 to L3 are the same as or different from each other, and are each independently a direct bond; a substituted or unsubstituted C6 to C60 arylene group; or a substituted or unsubstituted C2 to C60 heteroarylene group,
Ar1 to Ar3 are the same as or different from each other, and are each independently a substituted or unsubstituted C6 to C60 aryl group; or a substituted or unsubstituted C2 to C60 heteroaryl group,
R1 to R3 are the same as or different from each other, and are each independently hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group,
R4 is hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; or -(L4)l4-Ar4,
Ar4 is a substituted or unsubstituted C6 to C60 aryl group; or a substituted or unsubstituted C2 to C60 heteroaryl group,
L4 is a direct bond; a substituted or unsubstituted C6 to C60 arylene group; or a substituted or unsubstituted C2 to C60 heteroarylene group,
11 to 14 are the same as or different from each other, and are each independently an integer from 1 to 3, and when each of 11 to 14 is 2 or higher, groups in the parenthesis are the same as or different from each other,
each of r1 and r3 is an integer from 0 to 4,
r2 is an integer from 0 to 2,
the sum of r1, r2 and r3 is 8,
when each of r1, r2 and r3 is 2 or an integer higher than 2, groups in the parenthesis are the same as or different from each other,
r4 is an integer from 0 to 7, and when r4 is an integer of 2 or higher, groups in the parenthesis are the same as or different from each other,
each of ar1 and ar2 is an integer from 1 to 4, and when each of ar1 and ar2 is an integer of 2 or higher, groups in the parenthesis are the same as or different from each other,
X is O; or S, and
N-het is a substituted or unsubstituted C2 to C60 heteroaryl group, and comprises one or more N's.

14. The composition of claim 13, wherein a weight ratio of the first heterocyclic compound : the second heterocyclic compound : the third heterocyclic compound in the composition is 0.1 to 3 : 0.1 to 2 : 0.1 to 2.

15. A method for manufacturing an organic light emitting device, the method comprising:
preparing a substrate;
forming a first electrode on the substrate;
forming an organic material layer having one or more layers on the first electrode; and
forming a second electrode on the organic material layer,
wherein the forming of the organic material layer comprises forming an organic material layer having one or more layers by using the composition of claim 13.
